# EUROPEAN PATENT SPECIFICATION

(11) **EP 4 207 994 B1**
(45) Date of publication and mention of the grant of the patent: **24.09.2025**
(21) Application number: 22215494.0
(22) Date of filing: 21.12.2022
(51) Int. Cl.: H10K 85/60, H10K 50/16, H10K 50/18, H10K 50/19, H10K 59/12, H10K 101/00

(54) **LIGHT EMITTING DEVICE AND LIGHT EMITTING DISPLAY INCLUDING THE SAME**
LICHTEMITTIERENDE VORRICHTUNG UND LICHTEMITTIERENDE ANZEIGE DAMIT
DISPOSITIF ÉLECTROLUMINESCENT ET AFFICHAGE ÉLECTROLUMINESCENT LE COMPRENANT

(30) Priority: 31.12.2021 KR 20210194800
(43) Date of publication of application: 05.07.2023
(73) Proprietor: LG Display Co., Ltd., SEOUL, 07336 (KR)
(72) Inventor: SONG, Wook, Paju-si (KR); HWANG, Min Hyeong, Paju-si (KR); CHO, Myeong Seon, Paju-si (KR); KIM, Chun Ki, Paju-si (KR); PARK, Sae Mi, Paju-si (KR); YU, Young Jun, Paju-si (KR); KIM, Jung Keun, Paju-si (KR); KIM, Byung Soo, Paju-si (KR); KIM, Sang Beom, Paju-si (KR)
(74) Representative: Ter Meer Steinmeister & Partner

(56) References cited:
- EP-A1- 3 483 146
- WO-A1-2017/122988
- WO-A1-2020/138876
- JIANGSHAN CHEN ET AL: "Hybrid white OLEDs with fluorophors and phosphors", MATERIALS TODAY, vol. 17, no. 4, 1 May 2014 (2014-05-01), AMSTERDAM, NL, pages 175 - 183, XP055619585, ISSN: 1369-7021, DOI: 10.1016/j.mattod.2014.04.002
- MIAO YANQIN ET AL: "High-efficiency/CRI/color stability warm white organic light-emitting diodes by incorporating ultrathin phosphorescence layers in a blue fluorescence layer", NANOPHOTONICS, vol. 7, no. 1, 22 July 2017 (2017-07-22), DE, pages 295 - 304, XP093048208, ISSN: 2192-8606, DOI: 10.1515/nanoph-2017-0021

## Description

### BACKGROUND OF THE INVENTION

### Field of the Invention

The present invention relates to a light emitting device, and more particularly to a light emitting device including a blue fluorescent stack and a phosphorescent stack, wherein the light emitting device is capable of improving the efficiency of a fluorescent blue light emitting layer without increasing a driving voltage, and a light emitting display including the same.

### Discussion of the Related Art

Recently, with the arrival of the information age, displays for visually rendering signals based on electrical information have been rapidly developed. In response thereto, a variety of displays having excellent characteristics such as thinness, low weight, and low power consumption have been developed and are rapidly replacing existing cathode ray tubes (CRTs) .

Among them, a light emitting display that does not require a separate light source and has a light emitting device in a display panel without a separate light source to make the display compact and realize clear color has been considered a competitive application.

Meanwhile, the light emitting device currently used in light emitting displays requires higher efficiency in order to realize a desired image quality, and is preferably implemented in the form of a plurality of stacks. However, the use of multiple stacks increases the driving voltage in proportion to the number of stacks, and there is a limitation on the extent to which efficiency can be increased using only a plurality of stacks due to the difference in the emission color and emission mechanism implemented between respective stacks. In addition, there is a problem in that the lifespan is shortened when changing materials to increase efficiency.

WO 2020/138876 A1 is directed to an organic light emitting diode that includes at least one emitting material layer including an anthracene-based host and a boron-based dopant, at least one electron blocking layer including an amine-based compound substituted with at least one fused aromatic or hetero aromatic ring, and optionally at least one hole blocking layer including an azine-based compound or a benzimidazole-based compound. EP 3 483 146 A1 provides a hetero-cyclic compound, and an organic light emitting device containing the hetero-cyclic compound in an organic compound layer. WO 2017/122988 A1 provides: a novel compound; an organic electric element using same; and an electronic device thereof. Jiangshan Chen et al, MATERIALS TODAY, vol. 17, no. 4, 1 May 2014, pages 175-183 is a review article of 2014 on hybrid white organic light-emitting diodes (WOLEDs) which are created by combining fluorophors and phosphors. Miao Yanqin et al: "High-efficiency/CRI/ color stability warm white organic light-emitting diodes by incorporating ultrathin phosphorescence layers in a blue fluorescence layer", Nanophotonics, vol. 7, no. 1, (2017-07-22), pages 295-304 is directed to white organic light-emitting diodes which incorporate ultrathin phosphorescence layers in a blue fluorescence layer.

### SUMMARY OF THE INVENTION

Accordingly, the present invention is directed to a light emitting device and a light emitting display including the same that substantially obviate one or more problems due to the limitations and disadvantages of the related art.

It is an object of the present invention to provide a light emitting device that is capable of improving both the driving voltage and lifespan to desired levels based on modification of a fluorescent light emitting layer having low internal quantum efficiency and structures adjacent thereto, and a light emitting display including the same.
Additional advantages, objects, and features of the invention will be set forth in part in the description which follows and in part will become apparent to those having ordinary skill in the art upon examination of the following, or may be learned from practice of the invention.

To achieve these objects and other advantages and in accordance with the purpose of the invention, as embodied and broadly described herein, a light emitting device includes an anode and a cathode facing each other, a first stack and a second stack disposed between the anode and the cathode, and a charge generation layer disposed between the first stack and the second stack, wherein the first stack includes a first electron-blocking layer, a first blue light emitting layer containing a boron-based compound emitting light having a wavelength of 430 nm to 480 nm, and a first electron transport layer and the second stack includes at least two phosphorescent light emitting layers emitting light having a longer wavelength than that emitted by the first blue light emitting layer.

The first electron transport layer comprises a first material of Formula 1 of claim 1 having high electron transport efficiency.

The first electron-blocking layer is formed of a second material containing a 9,9' -spirobifluorene, and at least one spirofluorene of the 9,9'-spirobifluorene is substituted with deuterium.

The electron-blocking layer may be in contact with one surface of the blue light emitting layer, the electron transport layer may be in contact with the other surface of the blue light emitting layer, and one surface and the other surface of the blue light emitting layer may face each other, with the thickness of the blue light emitting layer interposed therebetween.

In another aspect of the present invention, a light emitting display includes a substrate including a plurality of subpixels, a thin film transistor provided in each of the subpixels on the substrate, and the light emitting device connected to the thin film transistor.

It is to be understood that both the foregoing general description and the following detailed description of the present invention are exemplary and explanatory and are intended to provide further explanation of the invention as claimed.

### BRIEF DESCRIPTION OF THE DRAWINGS

The accompanying drawings, which are included to provide a further understanding of the invention and are incorporated in and constitute a part of this application, illustrate embodiment(s) of the invention and together with the description serve to explain the principle of the invention. In the drawings:
FIGS. 1A and 1B are cross-sectional views schematically illustrating an example of a light emitting device of the present invention;
FIG. 2 illustrates a first blue stack of FIGS. 1A and 1B;
FIG. 3 is a cross-sectional view illustrating the light emitting device used in experimental examples;
FIG. 4 is a graph showing emission spectrum properties of light emitting devices used in experimental examples;
FIG. 5 is a cross-sectional view schematically illustrating an example of a light emitting device of the present invention; and
FIG. 6 is a cross-sectional view illustrating a light emitting display using the light emitting device of the present invention.

### DETAILED DESCRIPTION OF THE INVENTION

Reference will now be made in detail to preferred embodiments of the present invention, examples of which are illustrated in the accompanying drawings. Wherever possible, the same reference numbers will be used throughout the drawings to refer to the same or like parts. In the following description of the present invention, detailed descriptions of known functions and configurations incorporated herein will be omitted when the same may obscure the subject matter of the present invention. In addition, the names of elements used in the following description are selected in consideration of clarity of description of the specification, and may differ from the names of elements of actual products.

The shape, size, ratio, angle, number, and the like shown in the drawings to illustrate various embodiments of the present invention are merely provided for illustration, and the invention is not limited to the content shown in the drawings. Wherever possible, the same reference numbers will be used throughout the drawings to refer to the same or like parts. In the following description, detailed descriptions of technologies or configurations related to the present invention may be omitted so as to avoid unnecessarily obscuring the subject matter of the present invention. When terms such as "including", "having", and "comprising" are used throughout the specification, an additional component may be present, unless "only" is used. A component described in a singular form encompasses a plurality thereof unless particularly stated otherwise.

The components included in the embodiments of the present invention should be interpreted to include an error range, even if there is no additional particular description thereof.

In describing the variety of embodiments of the present invention, when terms describing positional relationships such as "on", "above", "under" and "next to" are used, at least one intervening element may be present between the two elements, unless "immediately" or "directly" is used.

In describing the variety of embodiments of the present invention, when terms related to temporal relationships, such as "after", "subsequently", "next" and "before", are used, the non-continuous case may be included, unless "immediately" or "directly" is used.

In describing the variety of embodiments of the present invention, terms such as "first" and "second" may be used to describe a variety of components, but these terms only aim to distinguish the same or similar components from one another. Accordingly, throughout the specification, a "first" component may be the same as a "second" component within the technical concept of the present invention, unless specifically mentioned otherwise.

Features of various embodiments of the present disclosure may be partially or completely coupled to or combined with each other, and may be variously inter-operated with each other and driven technically. The embodiments of the present disclosure may be carried out independently from each other, or may be carried out together in an interrelated manner.

As used herein, the term "doped" means that, in a material that accounts for most of the weight of a layer, a material (for example, N-type and P-type materials, or organic and inorganic substances) having physical properties different from the material that occupies most of the weight ratio of the layer. Apart from the differences in properties, the material and the dopant material may also differ in terms of their amounts in the doped layer. For example, the material that accounts for most of the weight of a layer may be a host material that is a major component while the dopant material may be a minor component. The host material accounts for most of the weight of the doped layer. The dopant material is added in an amount less than 30% by weight based on a total weight of the host material in the doped layer. A "doped" layer may be a layer that is used to distinguish a host material from a dopant material of a certain layer, in consideration of the weight ratio. For example, if all of the materials constituting a layer is an organic material and not all materials constituting the layer are inorganic materials, the layer is included in the "undoped" layer. For example, when all materials constituting a certain layer are organic materials, at least one of the materials constituting the layer is n-type and the other is p-type, when the n-type material is present in an amount of less than 30 wt%, or when the p-type material is present in an amount of less than 30 wt%, the layer is considered to be a "doped" layer.

Also, the term "undoped" refers to layers that are not "doped". For example, a layer may be an "undoped" layer when the layer contains a single material or a mixture including materials having the same properties as each other. For example, if at least one of the materials constituting a certain layer is p-type and all materials constituting the layer are not n-type, the layer is considered to be an included in the "undoped" layer. For example, if at least one of materials constituting a layer is an organic material and all materials constituting the layer are not inorganic materials, the layer is considered to be an "undoped" layer.

Unless otherwise defined, all terms including technical and scientific terms used herein have the same meaning as commonly understood by one of ordinary skill in the art to which this inventive concept belongs. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

Hereinafter, example embodiments of the present disclosure will be described in detail with reference to the accompanying drawings. In adding reference numerals to elements of each of the drawings, although the same elements are illustrated in other drawings, like reference numerals may refer to like elements. Also, for convenience of description, a scale in which each of elements is illustrated in the accompanying drawings may differ from an actual scale. Thus, the illustrated elements are not limited to the specific scale in which they are illustrated in the drawings.

Hereinafter, a light emitting device of the present invention and a light emitting display including the same will be described with reference to the drawings.

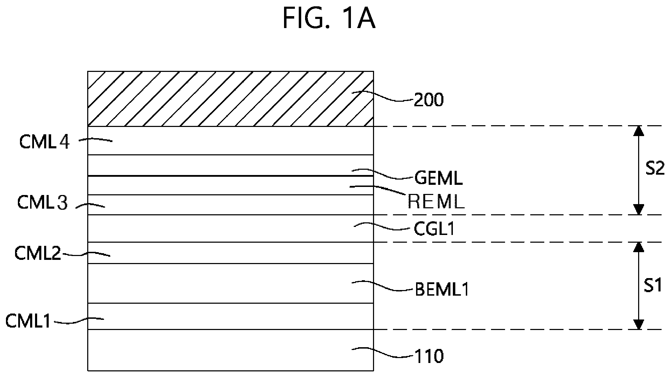

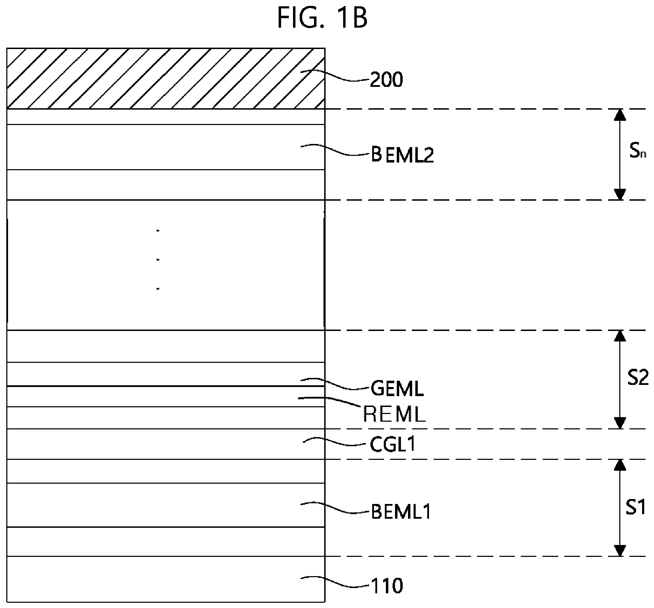

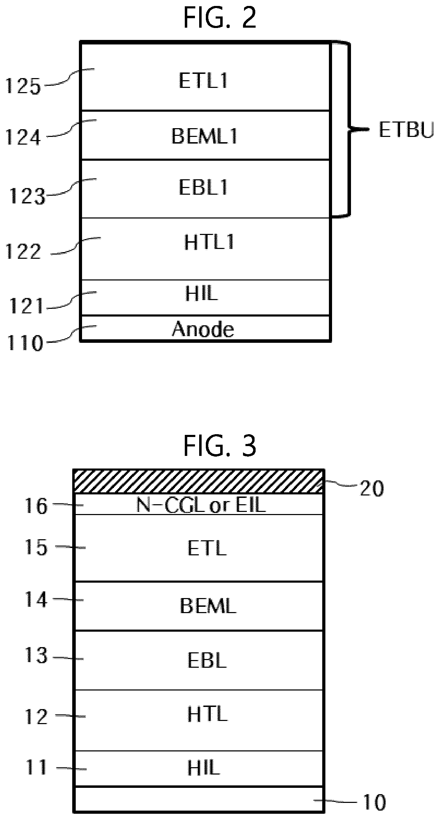

FIGS. 1A and 1B are cross-sectional views schematically illustrating an example of a light emitting device of the present invention, and FIG. 2 illustrates a first blue stack of FIGS. 1A and 1B.

As shown in FIGS. 1A and 1B, the light emitting device of the present invention includes an anode 110 and a cathode 200 facing each other, a first stack S1 and a second stack S2 disposed between the anode 110 and the cathode 200, and a first charge generation layer CGL1 disposed between the first stack S1 and the second stack S2, wherein the first stack S1 includes a first blue light emitting layer BEML1 and the second stack S2 includes at least two phosphorescent light emitting layers REML and GEML, each emitting light having a longer wavelength than that of the light emitted by the first blue light emitting layer BEML1.

FIG. 1A shows a configuration having two stacks according to an embodiment of a light emitting device of the present invention, and FIG. 1B shows a configuration having three or more stacks (in which n is a natural number of 3 or more) according to another embodiment, and this configuration is characterized in that the light emitting device further includes a stack including a second blue light emitting layer BEML2 that emits blue light, in addition to the first stack S1 and the second stack S2 including the phosphorescent light emitting layer.

As shown in FIG. 1A, a first common layer CML1 relating to hole transport and injection is disposed between the first blue light emitting layer BEML1 of the first stack S1 and the anode 110, and a second common layer CML2 relating to electron transport is disposed between the first blue light emitting layer BEML1 and the first charge generation layer CGL1. Similarly, a third common layer CML3 relating to hole transport is disposed between the red light emitting layer REML of the second stack S2 and the first charge generation layer CGL1 and a fourth common layer CML4 relating to electron transport is disposed between the green light emitting layer GEML and the cathode 200.

Specifically, as shown in FIG. 2, the first stack S1 emitting blue light includes a hole injection layer 121, a first hole transport layer 122, a first electron-blocking layer 123, a blue light emitting layer 124 and a first electron transport layer 125 on the anode 110.

Here, the hole injection layer 121 is a layer that is initially formed before holes are injected from the anode 110. The hole injection layer 121 may function to lower an energy barrier to inject holes from an electrode component into an organic material. The hole transport material including an aryl group or an arylene group may include a p-type dopant. The p-type dopant may be an organic material having a very low HOMO level, such as HATCN, or an inorganic compound containing a metal and fluoride, such as MgF₂.

The first hole transport layer 122 may be selected from organic materials having excellent hole transport properties so that holes injected through the hole injection layer are transferred to the first blue light emitting layer 124. The first hole transport layer 122 may confine holes to the first blue light emitting layer 124. The first hole transport layer 122 may be formed of an organic material or a mixture of a plurality of organic materials to perform a hole transport function.

The first blue light emitting layer 124 may include a first host and includes a boron-based dopant having an emission peak of 430 nm to 480 nm. The first host may be a material capable of easily transferring energy to the boron-based dopant and smoothly inducing excitation in the boron-based dopant. The first host may be selected from a material that may have electron transport capability, for example, an organic material having an anthracene as a core.

In addition, the first electron transport layer 125 may be formed of or contain at least one material that may have high electron transport efficiency. In the claimed invention, the first electron transport layer comprises a first material represented by the following Formula 1, to confine electrons to the first blue light emitting layer 124.

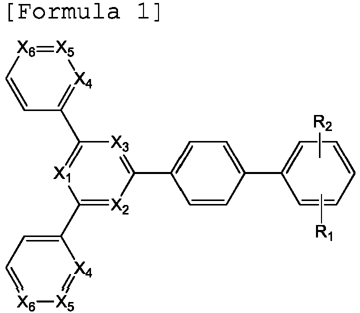

Here, R₁ and R₂ are each independently selected from a cycloalkyl group, an aryl group, and a heteroaryl group. The heteroaryl group may include an unsubstituted or aryl-substituted carbazole group.

In some embodiments, at least one of R₁ and R₂ may be a carbazole group.

In some embodiments, the carbazole group includes a phenyl group as a substituent.

In some embodiments, at least one of R₁ and R₂ is a phenyl group.

In some embodiments, at least one of R₁ and R₂ is biphenyl group.

X₁, X₂, and X₃ are each independently N or CH. At least one of X₄, X₅, and X₆ is N, and the remaining ones are CH. The two phenyl rings containing X₄, X₅, and X₆ may be symmetric relative to the phenyl ring containing X₁, X₂, and X₃.

The first material of Formula 1 constituting the first electron transport layer 125 is bonded to two symmetrical benzene rings. The first material may be capable of transferring electrons to the first blue light emitting layer 124 with high efficiency due to the strong electron donor activity of the nitrogen (N) at the end of the symmetrical benzene rings.

In addition, examples of the first material of Formula 1 constituting the first electron transport layer 125 may include at least one of ETM-01 to ETM-60 shown below.

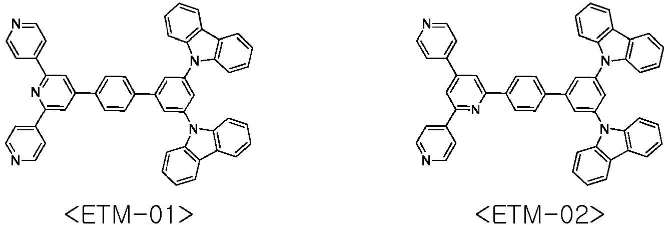

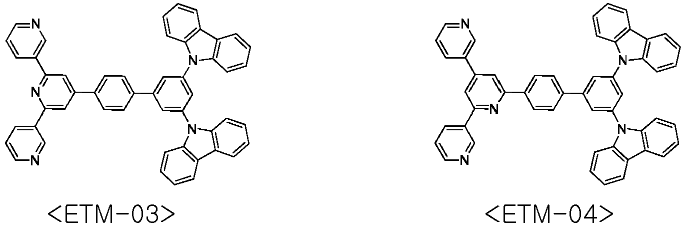

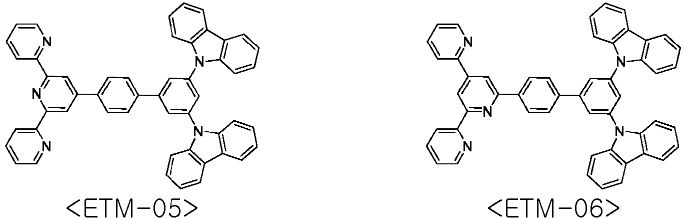

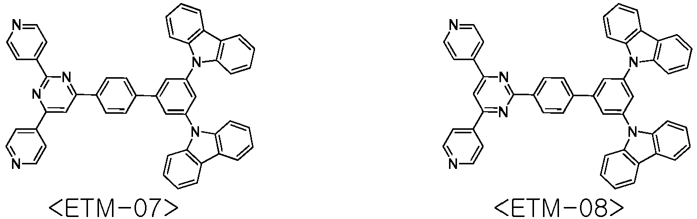

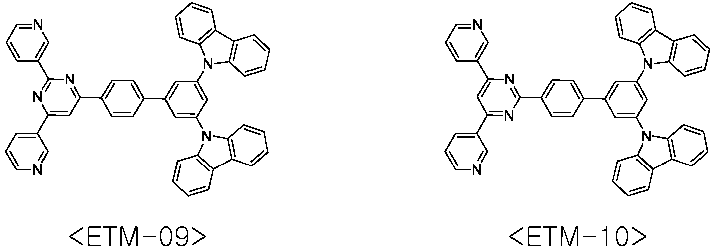

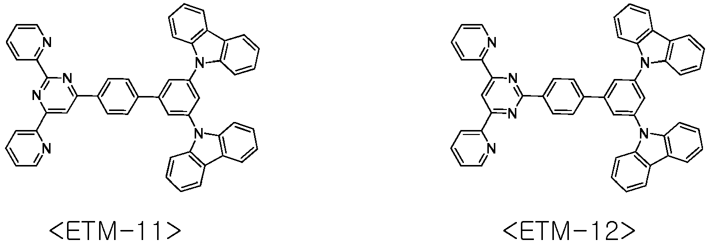

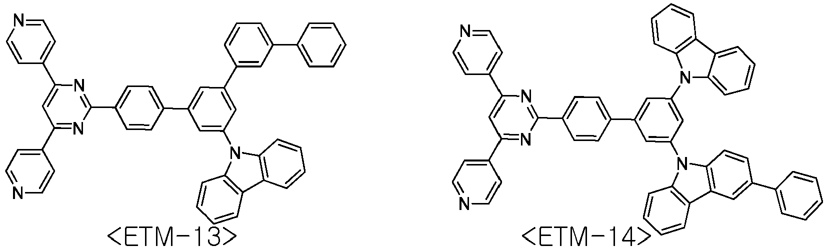

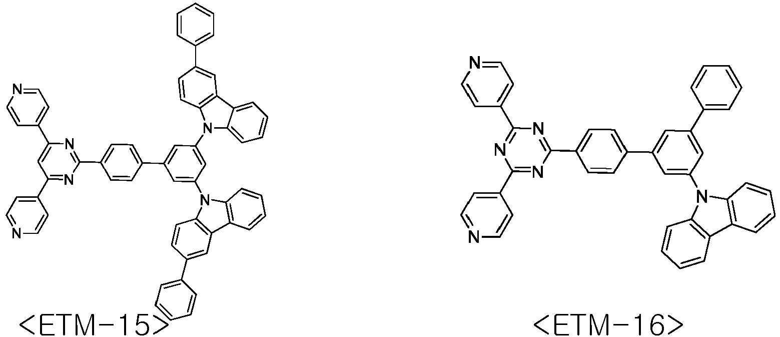

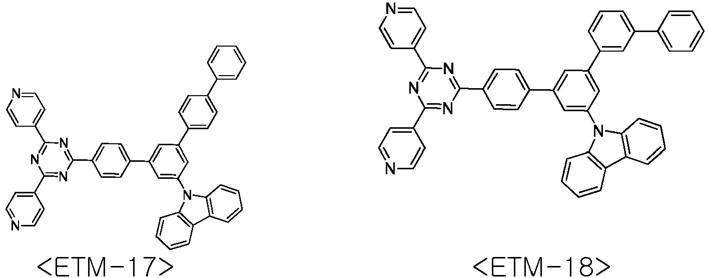

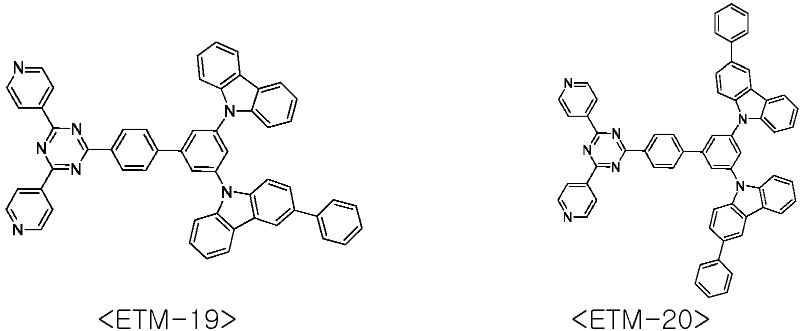

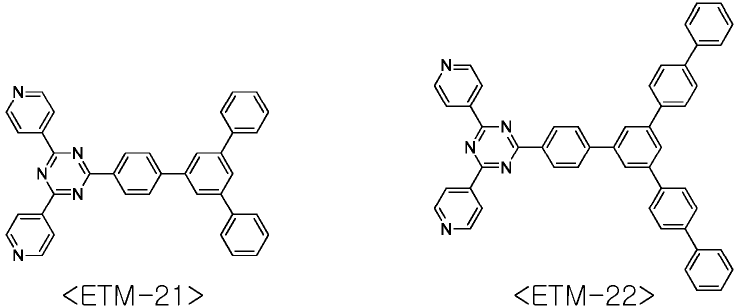

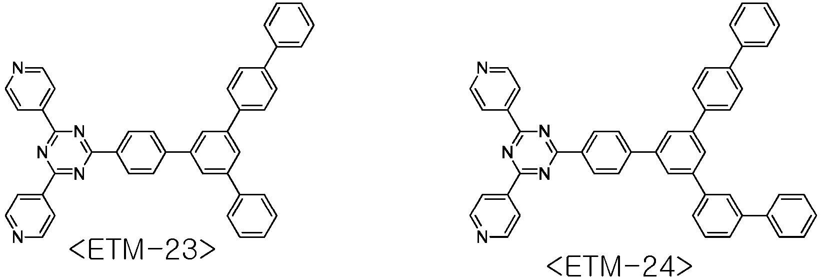

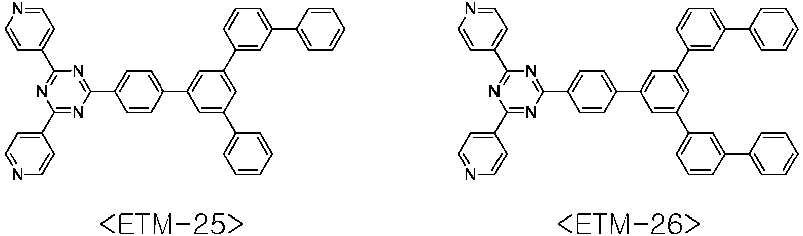

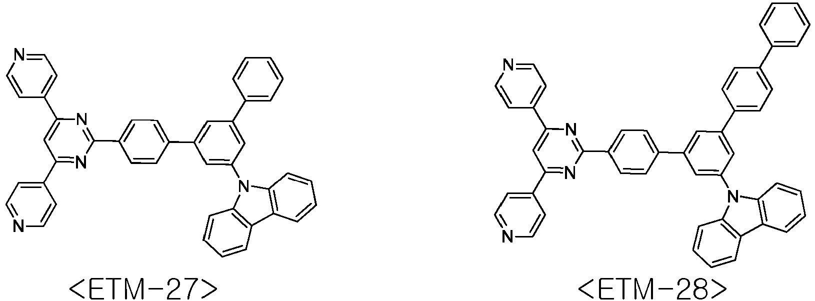

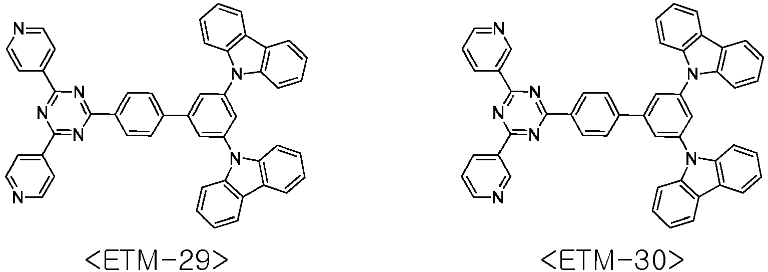

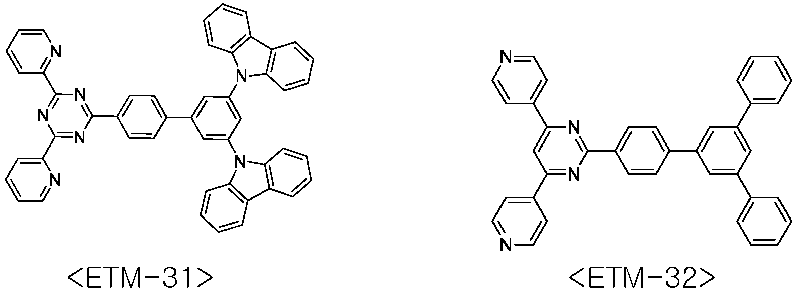

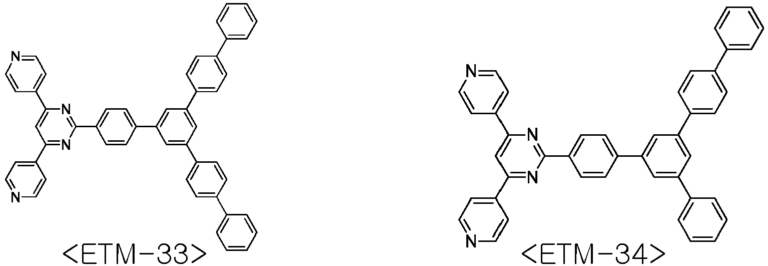

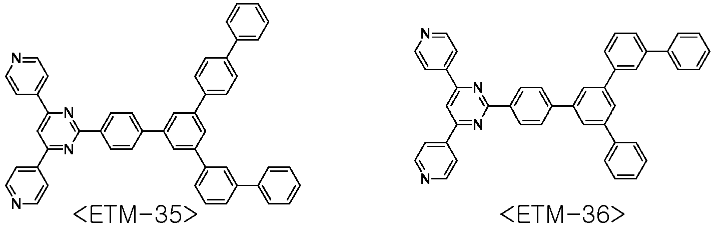

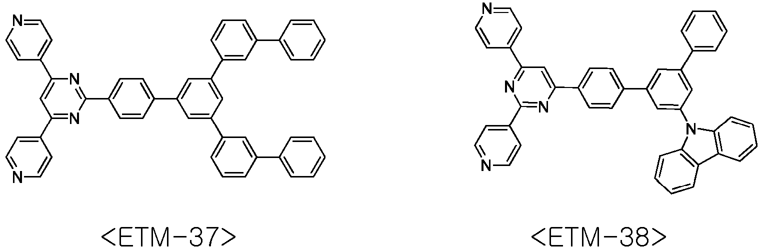

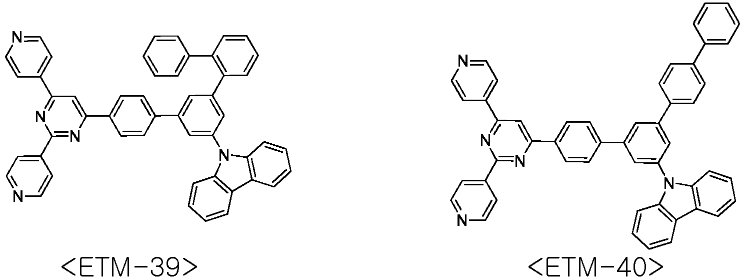

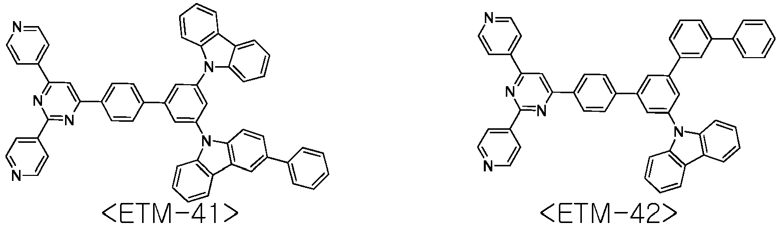

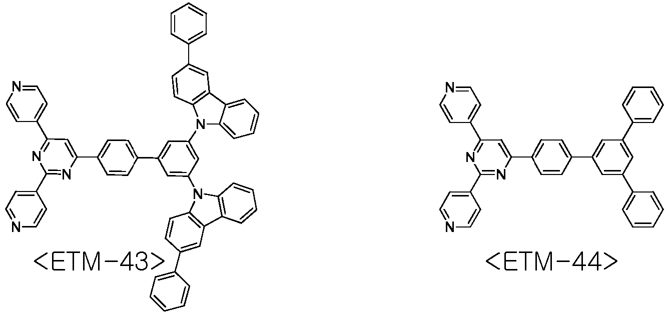

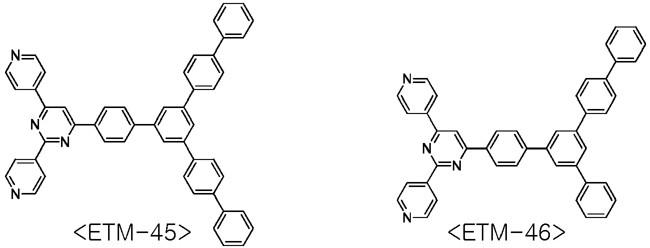

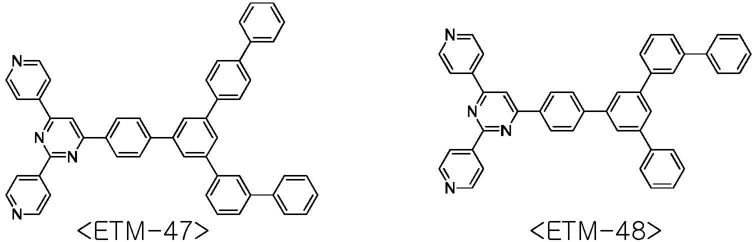

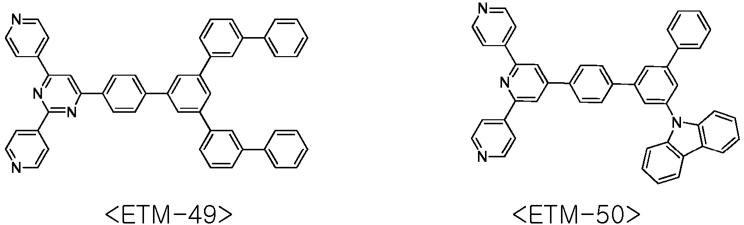

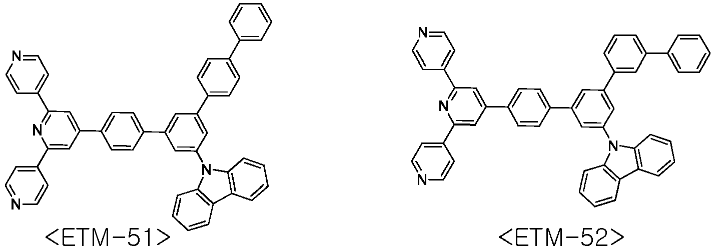

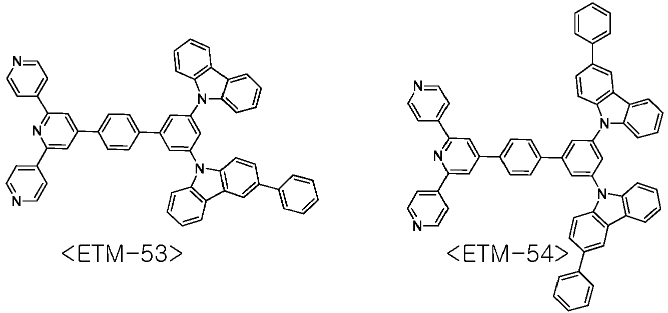

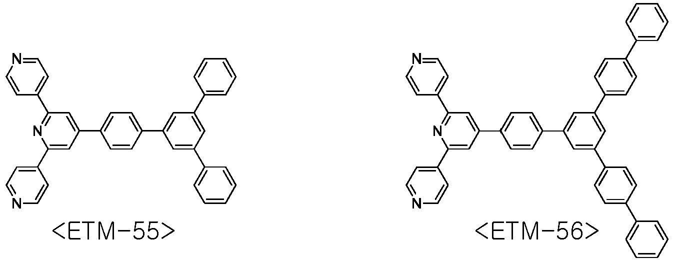

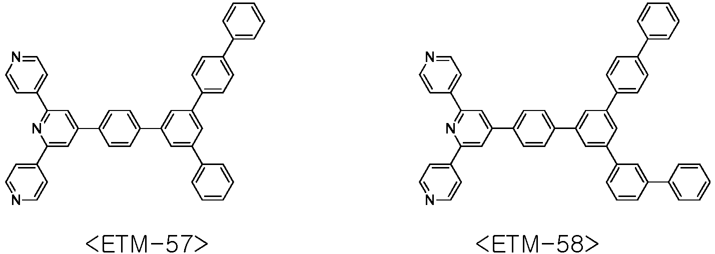

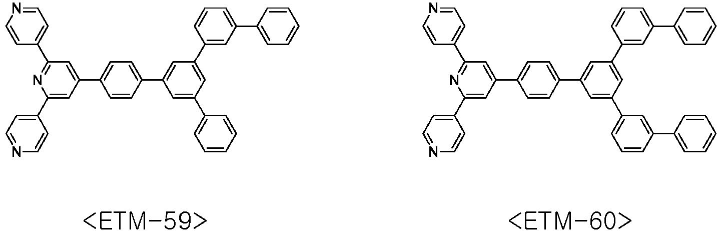

In addition, as a representative material of Formula 1, ETM-01 was obtained through the following preparation method.

### (1) Synthesis of first compound:

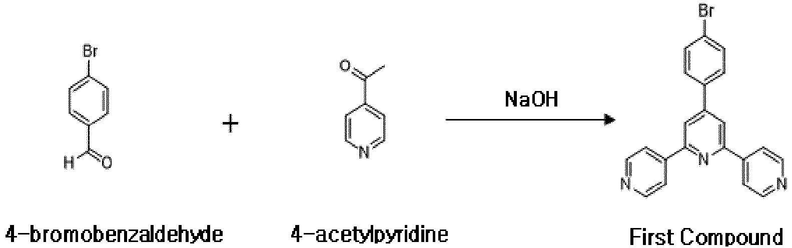

6.0 g (49.5 mmol) of 4-acetylpyridine and 9.0 g (48.6 mmol) of 4-bromobenzaldehyde were prepared and placed in a flask along with 200 ml of a 2% NaOH aqueous solution, followed by stirring at room temperature for 10 hours and observation of the color change of the reaction solution. Then, 6.0 g (49.5 mmol) of 4-acetylpyridine was added thereto, and an NaOH concentration was set to 20%, followed by stirring at 80°C for 8 hours. The product was dehydrated without purification and stirred under reflux conditions in a solution containing more than 36.0 g of ammonium acetate in 500 mL of ethanol for 5 hours. Then, the product was recrystallized from the resulting reaction solution using ethanol to obtain the first compound (11g, 60%).

### (2) Synthesis of second compound:

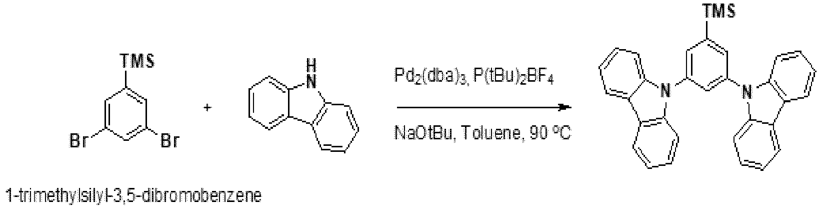

8.1 g (48.75 mmol) of Carbazole, 6.0 g (19.5 mmol) of 1-trimethylsilyl-3,5-dibromobenzene, 0.89 g (1.0 mmol) of tris(dibenzylideneacetone)dipalladium(O) (Pd₂(dba)₃), 0.59 g (2.0 mmol) of tri-tert-butylphosphine tetrafluoroborate, and 4.7 g (48.8 mmol) of NaOtBu were added to dry toluene (200 mL), followed by stirring at 90°C for 10 hours. Upon completion of the reaction, the NaOtBu residue was filtered and then the product was extracted with ethyl acetate. The resulting product was dehydrated with MgSO₄ and purified through column chromatography (hexane:EA = 20:1) to obtain a second compound (6.1 g, 65%).

### (3) Synthesis of third compound:

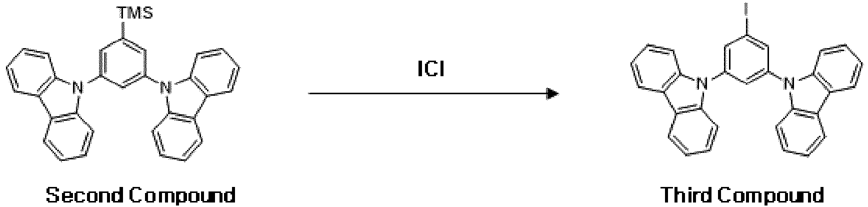

The second compound (4.0 g, 8.3 mmol) was dissolved in CCl₄ (70 mL), and an iodine monochloride solution (1.0 M in methylene chloride, 8.3 mL, 8.3 mmol) was added dropwise thereto at 0°C, followed by stirring for 1 hour. Then, the reaction solution was added to a 5 wt% aqueous solution of sodium thiosulfate (Na₂S₂O₃), followed by vigorous stirring until the reaction solution became transparent. The reaction solution was extracted with ethyl acetate, dehydrated with MsSO₄, and purified through column chromatography (hexane:EA = 20:1) to obtain a third compound (3.6 g, 80%).

### (4) Synthesis of fourth compound:

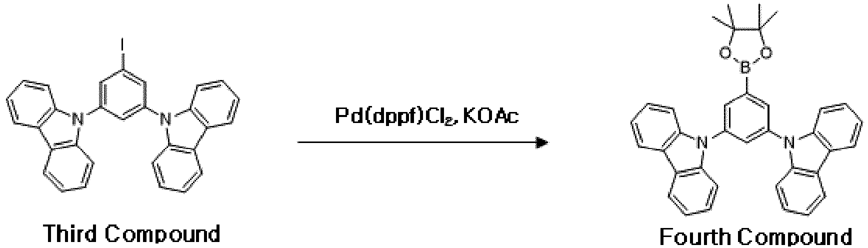

The third compound (3 g, 5.6 mmol), 4,4,4',4',5,5,5',5'-octamethyl-2,2'-bi(1,3,2,-dioxaborolane) (2.1 g, 8.4 mmol), [1,1'-bis(diphenylphosphino)ferrocene]dichloropalladium (II) (Pd(dppf)Cl₂) (0.21 g, 0.28 mmol), and potassium acetate (KOAc) (1.65 g, 16.8 mmol) were mixed under an inert atmosphere formed by injection of nitrogen, and then 1,4-dioxane (30 mL) was added thereto, followed by stirring at 130°C for 12 hours. After completion of the reaction, the mixture was extracted with ethyl acetate, dehydrated with MgSO₄, and purified through column chromatography (hexane:EA = 7:1 (v/v)) to obtain a fourth compound (2.3 g, 75%).

### (5) Synthesis of ETM-01:

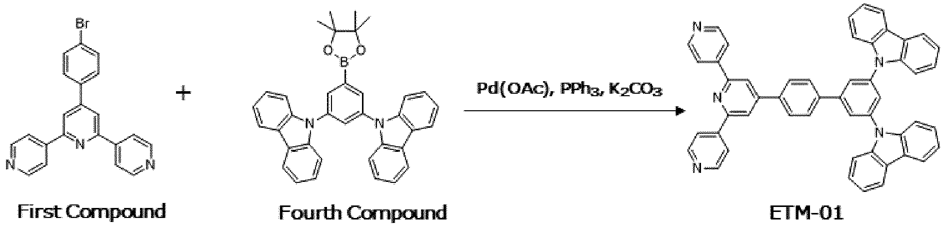

The first compound (1.8 g, 4.6 mmol), the fourth compound (2.3 g, 4.3 mmol), palladium(II) acetate (Pd(OAc)₂) (0.048 g, 0.2 mmol), triphenylphosphine (PPh₃) (0.28 g, 1.0 mmol), and potassium carbonate (K₂CO₃) (3.0 g, 21.5 mmol) were charged in a round-bottom flask in which an inert atmosphere was formed, and degassed THF/H₂O (35 mL/5 mL) was added thereto, followed by stirring at 70°C for 10 hours. After completion of the reaction, the reaction solution was extracted with dichloromethane, dehydrated with MgSO₄, and purified through column chromatography (hexane:EA = 7:1 (v/v)) to obtain ETM-01 (2.6 g, 85% yield).

The above synthesis method may be used to synthesize the representative material ETM-01 of Formula 1. ETM-02 to ETM-60 may be obtained by changing the number of nitrogen atoms in the nitrogen-containing precursor in the synthesis of the first compound in (1) or by changing the number of synthesized carbazoles and/or phenyl groups in the synthesis of the second compound in (2). For example, for ETM-21, bromobenzene was used instead of carbazole in the synthesis of the second compound in (2).

The light emitting device of the present invention includes a first electron-blocking layer 123 which is formed of or includes a 9,9'-spirobifluorene, and at least one spirofluorene of the 9,9'-spirobifluorene is substituted with deuterium in order to prevent electrons from being rapidly transported from the first electron transport layer 125 to the first blue light emitting layer 124 due to the fast electron transport capacity through the change in the material of the first electron transport layer 125 and then accumulating at the interface between the first blue light emitting layer 124 and the first electron-blocking layer.

The first electron-blocking layer 123 is formed of a second material containing 9,9'-spirobifluorene, wherein at least one spirofluorene of the 9,9'-spirobifluorene is substituted with deuterium. The first electron-blocking layer 123 may be formed of or include a compound represented by Formula 2 below. The compound represented by Formula 2 has a structure in which spirofluorene moieties opposite each other are bonded and the end group of the spirofluorene on at least one side is substituted with deuterium (D). The compound represented by Formula 2 has a structure in which spirofluorene moieties opposite each other are bonded and the end group (hydrogen atoms) of the spirofluorene on one side is substituted with deuterium (D). The compound of formula 2 is a 9,9'-spirobifluorene, and at least one spirofluorene of the 9,9'-spirobifluorene is substituted with deuterium (D).

In the first electron-blocking layer 123, the second material repels electrons accumulated at the interface between the first electron-blocking layer 123 and the first blue light emitting layer 124 due to the stability of deuterium to move the first blue light emitting layer 124 inwards and thereby to prevent reduction in the lifespan of the first electron-blocking layer 123 due to accumulated electrons.

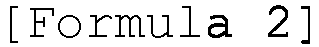

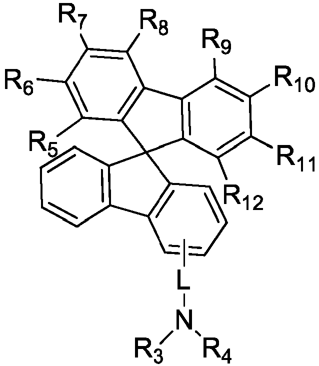

R₅ to R₁₂ each represent deuterium.

Here, L is a single bond, or is selected from a deuterium-substituted or unsubstituted phenylene group and a deuterium-substituted or unsubstituted naphthylene group.

R₃ and R₄ are each independently selected from an unsubstituted or a deuterium-substituted phenyl group, a deuterium-substituted or unsubstituted biphenyl group, and a deuterium-substituted or unsubstituted heteroaryl group.

In some embodiments, at least one of R₃ and R₄ may be a deuterium-substituted or unsubstituted biphenyl group.

In some embodiments, at least one of R₃ and R₄ may be a perdeuterated biphenyl group.

In some embodiments, at least one of R₃ and R₄ may be a deuterium-substituted or unsubstituted dimethylfluorene group.

In some embodiments, at least one of R₃ and R₄ may be a perdeuterated dimethylfluorene group.

In some embodiments, at least one of R₃ and R₄ may be a deuterium-substituted or unsubstituted carbazole group.

In some embodiments, at least one of R₃ and R₄ may be a perdeuterated carbazole group.

In some embodiments, the carbazole group may include a deuterium-substituted or unsubstituted phenyl group as a substituent.

In some embodiments, at least one of R₃ and R₄ may be a deuterium-substituted or unsubstituted dibenzofuran group.

In an embodiment, R₃ and R₄ are partially deuterium-substituted. In another embodiment, R₃ and R₄ are fully deuterium-substituted. Each of R₅ to R₁₂ may be a deuterium.

Examples of the material constituting the electron-blocking layer represented by Formula 2 may include EBM-09 to EBM-24 as follows.

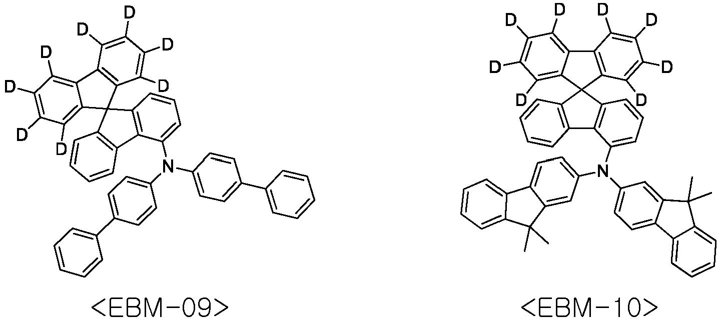

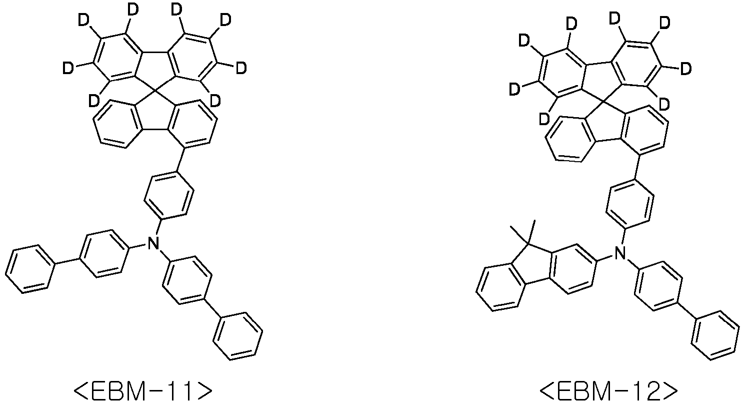

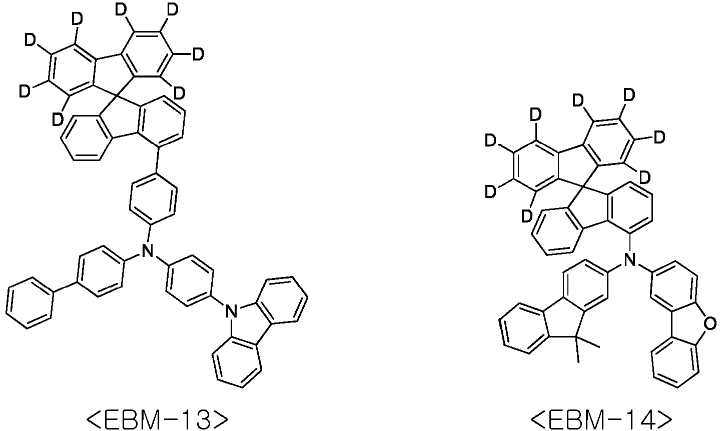

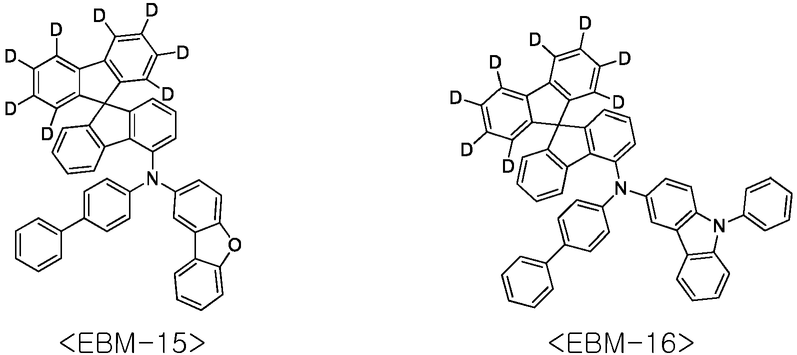

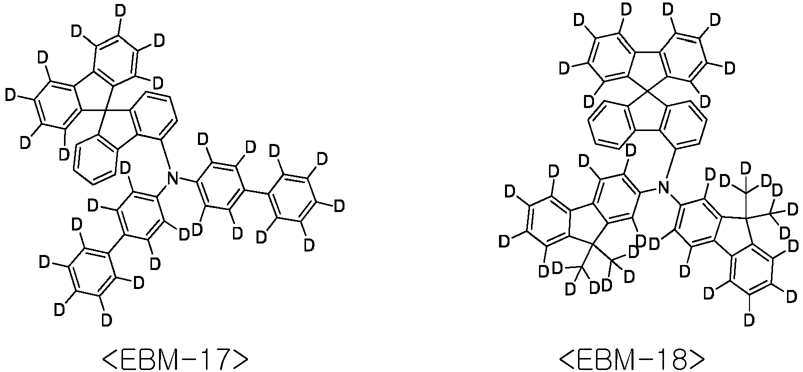

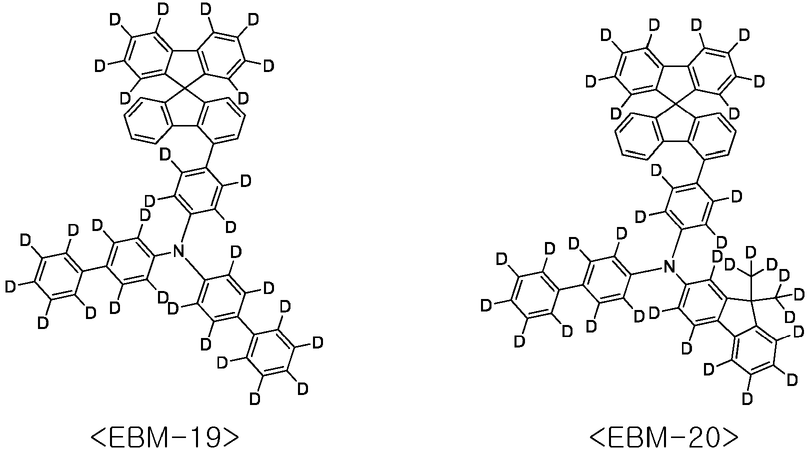

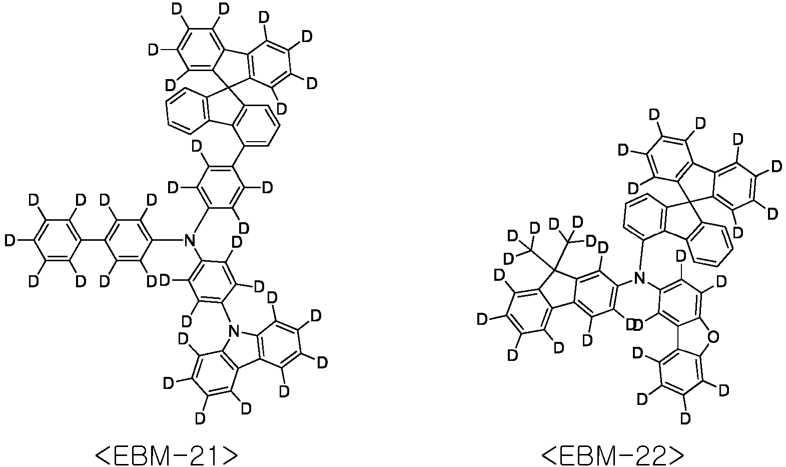

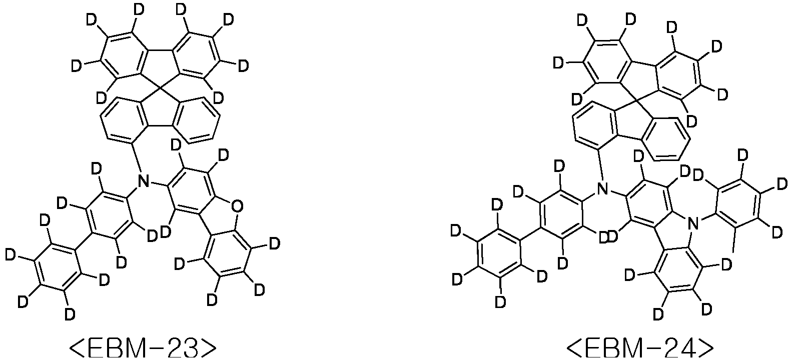

Here, the first electron-blocking layer 123, the first blue light emitting layer 124, and the first electron transport layer 125, which are layers relating to the confinement of electrons to the first blue light emitting layer, are referred to as an "electron transport and blocking unit (ETBU)".

Meanwhile, the light emitting device includes a first charge generation layer CGL1 to supply electrons and holes to the first stack S1 and the second stack S2 between the first stack S1 and the next second stack S2, far from the cathode 200 and the anode 110, respectively. The first charge generation layer CGL1 may include an n-type charge generation layer, which generates electrons and supplies the generated electrons to the first electron transport layer 125 of the first stack S1, and a p-type charge generation layer, which generates holes and supplies the holes to the hole transport layer of the second stack S2.

As shown in FIG. 1A, when the light emitting device has a two-stack structure, in consideration of the viewing angle characteristics, the first stack S1 close to the anode 110 is formed as a blue fluorescent stack including a first blue light emitting layer 124 having the ability to emit fluorescent light and the second stack S2 is formed as a phosphorescent light emitting stack including at least a phosphorescent red light emitting layer and a phosphorescent green light emitting layer.

The phosphorescent light emitting layer used in the second stack S2 is, for example, a red light emitting layer or a green light emitting layer, and the long-wavelength phosphorescent materials therefor are known to be improved with regard to both lifetime and efficiency.

Theoretically, the phosphorescent light emitting layer has an internal quantum efficiency of 100%, whereas the fluorescent light emitting layer has an internal quantum efficiency of 25%. Therefore, the reason for including a phosphorescent stack as the second stack S2 is that the fluorescent light emitting stack has an internal quantum efficiency as low as 25%, so white light can be realized using the minimum number of stacks causing an increase in the driving voltage. If all of the light emitting stacks are fluorescent light emitting stacks, efficiency is very low when using a fixed number of stacks.

In the light emitting device of the present invention, the efficiency of blue fluorescence light emission from the first blue light emitting layers (EML1, 124) is improved by changing the material of the first electron transport layer 125 in the electron transport and blocking unit ETBU in the first stack S1. In this case, when the efficiency of the light emitting layer is improved in the first blue light emitting layer 124, the contribution of triplet-triplet annihilation (TTA), which is the main mechanism for improving efficiency, is greatly increased. In order to prevent a phenomenon in which triplet excitons or electrons inhibit the action of other light emitting materials in the first blue light emitting layer 124 or move toward the interface of the first electron-blocking layer 123, resulting in a shortened lifespan, the first electron-blocking layer 123 is substituted with deuterium.

That is, the light emitting device of the present invention overcomes the trade-off relationship between blue efficiency and lifespan in a blue light emitting stack, and the electron transport layer uses a material having greatly improved electron transport capability, and the electron-blocking layer, which is mainly degraded by TTA, is substituted with deuterium, so efficiency can be improved, and at the same time, deterioration in the lifespan can be prevented, and thus the excellent lifespan of the blue fluorescent material can be maintained.

As shown in FIG. 1B, when the light emitting device further includes a stack emitting blue light, in addition to the second stack S2, it may further include an electron transport and blocking unit, in addition to an additional blue light emitting stack BS, including, as a layer relating to confinement of the electrons to the blue light emitting layer, a second electron-blocking layer formed of a second material represented by Formula 2, a blue light emitting layer (BEML2) containing a boron-based dopant having an emission peak of 430 nm to 480 nm, and a second electron transport layer formed of a first material.

The light emitting device of the present invention emits white light through combination of blue light of the first stack S1, emitted from the internal stack OS, with long-wavelength light emitted from the phosphorescent light emitting layer of the second stack S2 by forming at least one of the anode 110 and the cathode 200 using a transparent metal or a reflective metal to emit white light by combining the long-wavelength light emitted from the phosphorescent light emitting layer.

The reason for using the fluorescent blue light emitting layer in the blue light emitting stack in the light emitting device of the present invention is that the fluorescent blue light emitting layer has higher stability than the phosphorescent material in terms of lifespan.

When the charge generation layer of the second stack as the phosphorescent stack and the first stack as the fluorescent stack supplies holes and electrons to the second stack and the first stack at the same level, the blue light-emitting efficiency from the first blue light emitting layer is increased to a level similar to that of the second stack as the phosphorescent stack, and thus the number of stacks can be reduced. That is, in the light emitting device of the present invention, the first electron-blocking layer 123 of the second material of Formula 2 is in contact with one surface of the first blue light emitting layer 124, and the first electron transport layer 125 is in contact with another surface of the first blue light emitting layer 124, so fast electron transport can be realized through the material of the first electron transport layer 125 and the electrons and excitons can be confined to the first blue light emitting layer 124, and thus the driving voltage, efficiency, and luminance can be improved without reducing the lifespan. In addition, the efficiency of the blue fluorescent stack and the phosphorescent light emitting stack are adjusted to similar levels, so the light emitting device of the present invention can realize white color using only the two-stack structure shown in FIG. 1A. In this case, it is possible to reduce the driving voltage to realize the same white color by reducing the use of the stack.

The light emitting device of the present invention may further include a blue light emitting stack, as shown in FIG. 1B, when high-efficiency blue light emission is required in order to realize a high color temperature. Accordingly, the light emitting device of the present invention may include two or more fluorescent blue stacks and a phosphorescent stack emitting light having a wavelength different from that of the light emitted by the fluorescent blue stack.

If the efficiency of the blue light emitting stack is sufficiently improved, as shown in FIG. 1A, a white light emitting device can realize blue using only one blue light emitting stack. That is, even if the white light emitting device includes only one blue light emitting stack and one phosphorescent emitting stack, efficiency can be improved, and in this case, a reduction in the driving voltage can be decreased.

Hereinafter, in an experiment, changes in efficiency and lifespan depending on the constituents of an electron-blocking layer and an electron transport layer in a blue light emitting device emitting blue light will be evaluated. In the experimental example, a single blue fluorescent stack is provided between the anode and the cathode.

Meanwhile, there are EBM-01 to EBM-08 as the following electron-blocking materials containing 9,9'-spirobifluorene that is not substituted with deuterium, and which are not according to the claimed invention, compared to the electron-blocking material having the structure of Formula 2 above. The material for the electron-blocking layer used in the experimental example group (Ex1-1 to Ex1-72) which is not according to the claimed invention, was 9,9'-spirobifluorene that was not substituted with deuterium.

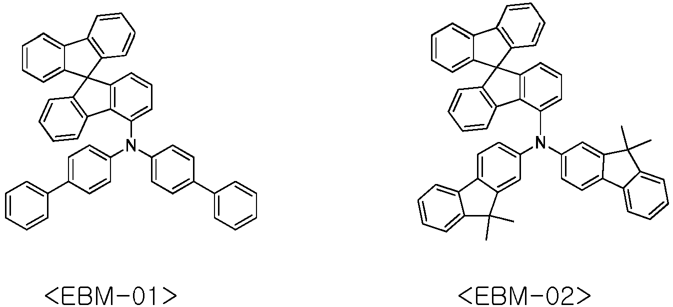

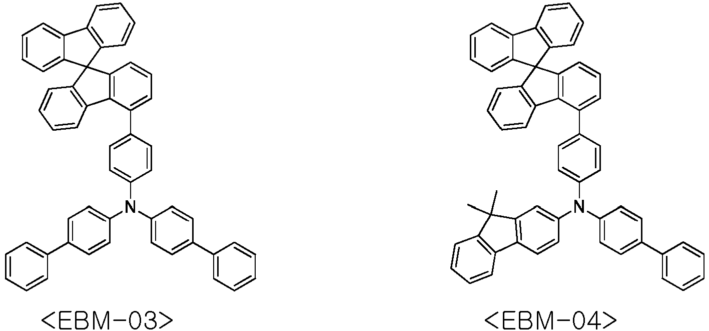

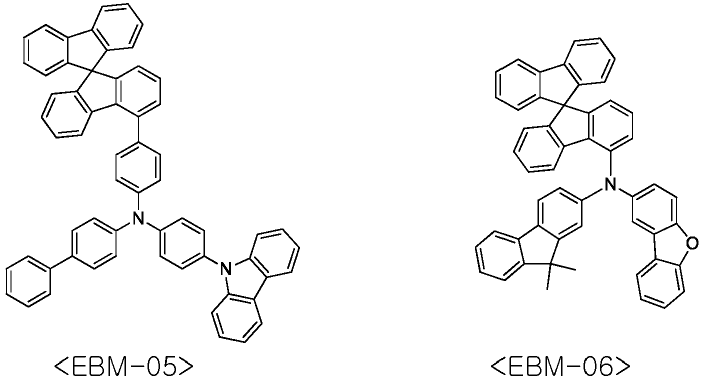

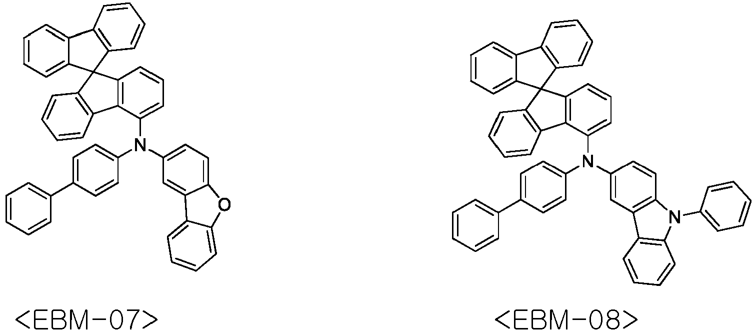

FIG. 3 is a cross-sectional view illustrating the light emitting device used in experimental examples.

As shown in FIG. 3, the light emitting devices used for the first experimental example group (Ex1-1 to Ex1-72) which is not according to the claimed invention, sequentially have the following configurations on the anode 10 formed of ITO.

That is, DNTPD of Formula 3 and MgF₂ were mixed 1:1 on the anode 10, and the resulting mixture was deposited to a thickness of 7.5 nm to form a hole injection layer HIL 11.

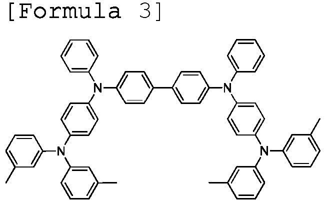

Then, α-NPD was deposited to a thickness of 80 nm on the hole injection layer 11 to form a hole transport layer (HTL, 12) .

Then, an electron-blocking layer 13 was formed to a thickness of 20 nm on the hole transport layer 12 using any one of the materials of EBM-01 to EBM-08 which are not according to the claimed invention, as a material not substituted with deuterium in the first experimental group (Ex1-1 to Ex1-72) which is not according to the claimed invention.

Then, MADN of Formula 4 was doped with a boron-based dopant of DABNA-1 of Formula 5 on the electron-blocking layer 13 to form a blue light emitting layer 14 having a thickness of 30 nm. In the blue light emitting layer 14, the boron-based dopant was doped at 3wt% with respect to total weight of the MADN.

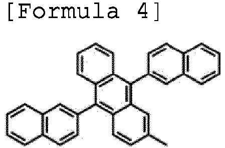

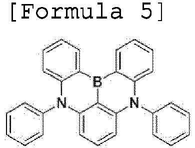

Then, an electron transport layer 15 was formed using any one of ETM-08, ETM-12, ETM-14, ETM-19, ETM-22, ETM-31, ETM-32, ETM-45 and ETM-54, among the electron transport materials of Formula 1.

Then, an electron injection layer or an n-type charge generation layer 16 containing Bphen of Formula 6 doped with 2 wt% Li was formed on the electron transport layer 15.

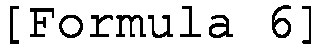

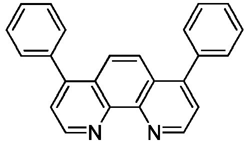

Then, a cathode 20 made of an aluminum (Al) component was formed on the electron injection layer or the n-type charge generation layer 16.

First, in the first experimental example group (Ex1-1 to Ex1-9) which is not according to the claimed invention, listed in Table 1-1, the material of the electron-blocking layer 13 was EBM-01, which is not according to the claimed invention, and the material of the electron transport layer 15 was changed to ETM-08, ETM-12, ETM-14, ETM-19, ETM-22, ETM-31, ETM-32, ETM-45, or ETM-54. The driving voltage, luminance, and external quantum efficiency were evaluated at a current density of 10 mA/cm², and the lifespan was comparatively evaluated at a high current density of 55 mA/cm² to determine the lifespan under accelerated conditions. The fifth experimental example (Ex1-5) of the first experimental example group among the experimental examples in Table 1-1 had the highest external quantum efficiency (EQE) and lifespan, so the lifespan of each of the remaining experimental examples was evaluated compared to the fifth experimental example.

**[Table 1-1]**

| Ite m | Structur e | | Voltage[V ], 10mA/cm² | luminance[Cd/A ], 10mA/cm² | EQE (%) , 10mA/c m² | Lifespan(% ), 55mA/cm² |
|---|---|---|---|---|---|---|
| | EBL | ETL | | | | |
| Ex1 -1 | EBM -01 | ETM -08 | 3.64 | 5.2 | 8.4 | 94 |
| Ex1 -2 | EBM -01 | ETM -12 | 3.70 | 5.2 | 8.3 | 98 |
| Ex1 -3 | EBM -01 | ETM -14 | 3.65 | 5.1 | 8.1 | 92 |
| Ex1 -4 | EBM -01 | ETM -19 | 3.78 | 5.6 | 9.1 | 79 |
| Ex1 -5 | EBM -01 | ETM -22 | 3.60 | 5.6 | 9.0 | 100 |
| Ex1 -6 | EBM -01 | ETM -31 | 3.79 | 5.0 | 8.0 | 98 |
| Ex1 -7 | EBM -01 | ETM -32 | 3.60 | 5.3 | 8.5 | 95 |
| Ex1 -8 | EBM -01 | ETM -45 | 3.76 | 5.4 | 8.7 | 94 |
| Ex1 -9 | EBM -01 | ETM -54 | 3.68 | 5.0 | 8.0 | 75 |

In the first experimental example group (Ex1-10 to Ex1-18) which is not according to the claimed invention, listed in Table 1-2, the material of the electron-blocking layer 13 was EBM-02, which is not according to the claimed invention, and the material of the electron transport layer 15 was changed to ETM-08, ETM-12, ETM-14, ETM-19, ETM-22, ETM-31, ETM-32, ETM-45 or ETM-54. The driving voltage, luminance, and external quantum efficiency were evaluated at a current density of 10 mA/cm², and the lifespan was comparatively evaluated at a high current density of 55 mA/cm² to determine the lifespan under accelerated conditions.

**[Table 1-2]**

| Ite m | Structur e | | Voltage[V ], 10mA/cm² | Luminance[Cd/A ], 10mA/cm² | EQE (%) , 10mA/c m² | Lifespan(% ), 55mA/cm² |
|---|---|---|---|---|---|---|
| | EBL | ETL | | | | |
| Ex1 -10 | EBM -02 | ETM -08 | 3.66 | 5.3 | 8.6 | 93 |
| Ex1 -11 | EBM -02 | ETM -12 | 3.67 | 5.2 | 8.4 | 92 |
| Ex1 -12 | EBM -02 | ETM -14 | 3.65 | 5.3 | 8.5 | 98 |
| Ex1 -13 | EBM -02 | ETM -19 | 3.65 | 5.4 | 8.7 | 93 |
| Ex1 -14 | EBM -02 | ETM -22 | 3.62 | 5.4 | 8.7 | 97 |
| Ex1 -15 | EBM -02 | ETM -31 | 3.71 | 5.7 | 9.1 | 75 |
| Ex1 -16 | EBM -02 | ETM -32 | 3.61 | 5.6 | 8.9 | 85 |
| Ex1 -17 | EBM -02 | ETM -45 | 3.79 | 5.6 | 9.0 | 95 |
| Ex1 -18 | EBM -02 | ETM -54 | 3.63 | 4.9 | 7.9 | 103 |

In the first experimental example group (Ex1-19 to Ex1-27) which is not according to the claimed invention, listed in Table 1-3, the material of the electron-blocking layer 13 was EBM-03, which is not according to the claimed invention, and the material of the electron transport layer 15 was changed to ETM-08, ETM-12, ETM-14, ETM-19, ETM-22, ETM-31, ETM-32, ETM-45, or ETM-54. The driving voltage, luminance, and external quantum efficiency were evaluated at a current density of 10 mA/cm², and the lifespan was comparatively evaluated at a high current density of 55 mA/cm² to determine the lifespan under accelerated conditions.

**[Table 1-3]**

| Ite m | Structur e | | Voltage[V ], 10mA/cm² | Luminance[Cd/A ], 10mA/cm² | EQE (%) , 10mA/c m² | Lifespan(% ), 55mA/cm² |
|---|---|---|---|---|---|---|
| | EBL | ETL | | | | |
| Ex1 -19 | EBM -03 | ETM -08 | 3.75 | 5.4 | 8.6 | 99 |
| Ex1 -20 | EBM -03 | ETM -12 | 3.68 | 5.3 | 8.5 | 101 |
| Ex1 -21 | EBM -03 | ETM -14 | 3.62 | 5.0 | 8.0 | 90 |
| Ex1 -22 | EBM -03 | ETM -19 | 3.72 | 5.5 | 8.9 | 96 |
| Ex1 -23 | EBM -03 | ETM -22 | 3.72 | 5.2 | 8.4 | 92 |
| Ex1 -24 | EBM -03 | ETM -31 | 3.76 | 5.1 | 8.1 | 90 |
| Ex1 -25 | EBM -03 | ETM -32 | 3.75 | 5.1 | 8.3 | 103 |
| Ex1 -26 | EBM -03 | ETM -45 | 3.73 | 5.6 | 9.0 | 96 |
| Ex1 -27 | EBM -03 | ETM -54 | 3.61 | 5.5 | 8.9 | 94 |

In the first experimental example group (Ex1-28 to Ex1-36) which is not according to the claimed invention, listed in Table 1-4, the material of the electron-blocking layer 13 was EBM-04, which is not according to the claimed invention, and the material of the electron transport layer 15 was changed to ETM-08, ETM-12, ETM-14, ETM-19, ETM-22, ETM-31, ETM-32, ETM-45, or ETM-54. The driving voltage, luminance, and external quantum efficiency were evaluated at a current density of 10 mA/cm², and the lifespan was comparatively evaluated at a high current density of 55 mA/cm² to determine the lifespan under accelerated conditions.

**[Table 1-4]**

| Ite m | Structur e | | Voltage[V ], 10mA/cm² | Luminance[Cd/A ], 10mA/cm² | EQE (%) , 10mA/c m² | Lifespan(% ), 55mA/cm² |
|---|---|---|---|---|---|---|
| | EBL | ETL | | | | |
| Ex1 -28 | EBM -04 | ETM -08 | 3.75 | 5.4 | 8.7 | 95 |
| Ex1 -29 | EBM -04 | ETM -12 | 3.64 | 5.1 | 8.2 | 85 |
| Ex1 -30 | EBM -04 | ETM -14 | 3.71 | 5.7 | 9.1 | 83 |
| Ex1 -31 | EBM -04 | ETM -19 | 3.67 | 5.3 | 8.6 | 77 |
| Ex1 -32 | EBM -04 | ETM -22 | 3.75 | 5.6 | 9.0 | 84 |
| Ex1 -33 | EBM -04 | ETM -31 | 3.70 | 5.6 | 9.1 | 88 |
| Ex1 -34 | EBM -04 | ETM -32 | 3.62 | 5.0 | 8.0 | 79 |
| Ex1 -35 | EBM -04 | ETM -45 | 3.78 | 5.0 | 8.0 | 85 |
| Ex1 -36 | EBM -04 | ETM -54 | 3.73 | 5.2 | 8.3 | 94 |

In the first experimental example group (Ex1-37 to Ex1-45) which is not according to the claimed invention, listed in Table 1-5, the material of the electron-blocking layer 13 was EBM-05 which is not according to the claimed invention, and the material of the electron transport layer 15 was changed to ETM-08, ETM-12, ETM-14, ETM-19, ETM-22, ETM-31, ETM-32, ETM-45, or ETM-54. The driving voltage, luminance, and external quantum efficiency were evaluated at a current density of 10 mA/cm², and the lifespan was comparatively evaluated at a high current density of 55 mA/cm² to determine the lifespan under accelerated conditions.

**[Table 1-5]**

| Ite m | Structur e | | Voltage[V ], 10mA/cm² | Luminance[Cd/A ], 10mA/cm² | EQE (%) , 10mA/c m² | Lifespan(% ), 55mA/cm² |
|---|---|---|---|---|---|---|
| | EBL | ETL | | | | |
| Ex1 -37 | EBM -05 | ETM -08 | 3.64 | 4.9 | 7.96 | 76 |
| Ex1 -38 | EBM -05 | ETM -12 | 3.60 | 5.3 | 8.5 | 95 |
| Ex1 -39 | EBM -05 | ETM -14 | 3.72 | 5.2 | 8.4 | 99 |
| Ex1 -40 | EBM -05 | ETM -19 | 3.73 | 5.1 | 8.2 | 82 |
| Ex1 -41 | EBM -05 | ETM -22 | 3.64 | 5.0 | 8.1 | 92 |
| Ex1 -42 | EBM -05 | ETM -31 | 3.71 | 5.5 | 8.8 | 93 |
| Ex1 -43 | EBM -05 | ETM -32 | 3.75 | 5.0 | 8.1 | 83 |
| Ex1 -44 | EBM -05 | ETM -45 | 3.62 | 5.0 | 8.0 | 94 |
| Ex1 -45 | EBM -05 | ETM -54 | 3.77 | 4.9 | 7.9 | 98 |

In the first experimental example group (Ex1-46 to Ex1-54) which is not according to the claimed invention, listed in Table 1-6, the material of the electron-blocking layer 13 was EBM-06 which is not according to the claimed invention, and the material of the electron transport layer 15 was changed to ETM-08, ETM-12, ETM-14, ETM-19, ETM-22, ETM-31, ETM-32, ETM-45, or ETM-54. The driving voltage, luminance, and external quantum efficiency were evaluated at a current density of 10 mA/cm², and the lifespan was comparatively evaluated at a high current density of 55 mA/cm² to determine the lifespan under accelerated conditions.

**[Table 1-6]**

| Ite m | Structur e | | Voltage[V ], 10mA/cm² | Luminance[Cd/A ], 10mA/cm² | EQE (%) , 10mA/c m² | Lifespan(% ), 55mA/cm² |
|---|---|---|---|---|---|---|
| | EBL | ETL | | | | |
| Ex1 -46 | EBM -06 | ETM -08 | 3.68 | 5.6 | 9.0 | 94 |
| Ex1 -47 | EBM -06 | ETM -12 | 3.77 | 5.1 | 8.2 | 76 |
| Ex1 -48 | EBM -06 | ETM -14 | 3.72 | 5.4 | 8.7 | 92 |
| Ex1 -49 | EBM -06 | ETM -19 | 3.74 | 5.0 | 8.0 | 77 |
| Ex1 -50 | EBM -06 | ETM -22 | 3.66 | 4.9 | 7.9 | 101 |
| Ex1 -51 | EBM -06 | ETM -31 | 3.65 | 5.6 | 8.9 | 83 |
| Ex1 -52 | EBM -06 | ETM -32 | 3.77 | 5.6 | 9.0 | 92 |
| Ex1 -53 | EBM -06 | ETM -45 | 3.68 | 5.5 | 8.9 | 96 |
| Ex1 -54 | EBM -06 | ETM -54 | 3.67 | 5.3 | 8.5 | 93 |

In the first experimental example group (Ex1-55 to Ex1-63) which is not according to the claimed invention, listed in Table 1-7, the material of the electron-blocking layer 13 was EBM-07, which is not according to the claimed invention, and the material of the electron transport layer 15 was changed to ETM-08, ETM-12, ETM-14, ETM-19, ETM-22, ETM-31, ETM-32, ETM-45, or ETM-54. The driving voltage, luminance, and external quantum efficiency were evaluated at a current density of 10 mA/cm², and the lifespan was comparatively evaluated at a high current density of 55 mA/cm² to determine the lifespan under accelerated conditions.

**[Table 1-7]**

| Ite m | Structur e | | Voltage[V ], 10mA/cm² | Luminance[Cd/A ], 10mA/cm² | EQE (%) , 10mA/c m² | Lifespan(% ), 55mA/cm² |
|---|---|---|---|---|---|---|
| | EBL | ETL | | | | |
| Ex1 -55 | EBM -07 | ETM -08 | 3.64 | 4.9 | 7.8 | 75 |
| Ex1 -56 | EBM -07 | ETM -12 | 3.73 | 5.4 | 8.6 | 89 |
| Ex1 -57 | EBM -07 | ETM -14 | 3.76 | 5.1 | 8.2 | 84 |
| Ex1 -58 | EBM -07 | ETM -19 | 3.67 | 5.3 | 8.6 | 92 |
| Ex1 -59 | EBM -07 | ETM -22 | 3.77 | 5.0 | 8.0 | 81 |
| Ex1 -60 | EBM -07 | ETM -31 | 3.71 | 5.0 | 8.1 | 80 |
| Ex1 -61 | EBM -07 | ETM -32 | 3.65 | 5.2 | 8.4 | 79 |
| Ex1 -62 | EBM -07 | ETM -45 | 3.69 | 5.2 | 8.3 | 78 |
| Ex1 -63 | EBM -07 | ETM -54 | 3.73 | 5.0 | 8.1 | 88 |

In the first experimental example group (Ex1-64 to Ex1-72) which is not according to the claimed invention, listed in Table 1-8, the material of the electron-blocking layer 13 was EBM-08 which is not according to the claimed invention, and the material of the electron transport layer 15 was changed to ETM-08, ETM-12, ETM-14, ETM-19, ETM-22, ETM-31, ETM-32, ETM-45, or ETM-54. The driving voltage, luminance, and external quantum efficiency were evaluated at a current density of 10 mA/cm², and the lifespan was comparatively evaluated at a high current density of 55 mA/cm² to determine the lifespan under accelerated conditions.

**[Table 1-8]**

| Item | Structure | | Voltage[V ], 10mA/cm² | Luminance[Cd/A ], 10mA/cm² | EQE(%) , 10mA/c m² | Lifespan(% ), 55mA/cm² |
|---|---|---|---|---|---|---|
| | EBL | ETL | | | | |
| Ex1 -64 | EBM -08 | ETM -08 | 3.76 | 5.3 | 8.5 | 77 |
| Ex1 -65 | EBM -08 | ETM -12 | 3.79 | 5.4 | 8.7 | 96 |
| Ex1 -66 | EBM -08 | ETM -14 | 3.64 | 5.4 | 8.6 | 91 |
| Ex1 -67 | EBM -08 | ETM -19 | 3.61 | 5.2 | 8.3 | 93 |
| Ex1 -68 | EBM -08 | ETM -22 | 3.68 | 5.3 | 8.5 | 91 |
| Ex1 -69 | EBM -08 | ETM -31 | 3.78 | 5.3 | 8.4 | 99 |
| Ex1 -70 | EBM -08 | ETM -32 | 3.62 | 5.3 | 8.4 | 76 |
| Ex1 -71 | EBM -08 | ETM -45 | 3.64 | 5.6 | 9.0 | 81 |
| Ex1 -72 | EBM -08 | ETM -54 | 3.60 | 5.4 | 8.7 | 96 |

It can be seen that in the above-described first experimental example group (Ex1-1 to Ex1-72), which is not according to the claimed invention, the driving voltage at a current density of 10 mA/cm² was 3.60V to 3.79V, the luminance was 4.9 Cd/A to 5.7 Cd/A, and the external quantum efficiency was 7.8% to 9.0%.

In a comparative example having a structure as illustrated in the example embodiment of FIG. 3, TAPC of Formula 7 was used as the material for the electron-blocking layer 13, and the material of Formula 8, which has a benzimidazole group, was used as the material for the electron transport layer 15.

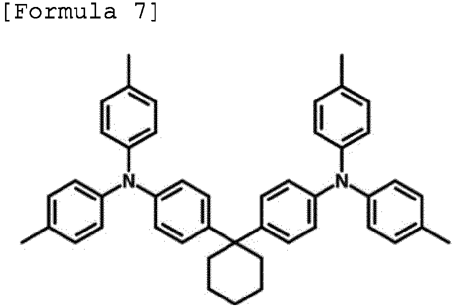

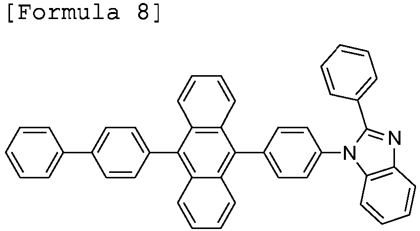

In the comparative example, the driving voltage at the same current density of 10 mA/cm² was 3.95 V, the luminance was 3.9 Cd/A, and the external quantum efficiency was 3.9%.

Compared to the comparative example, the first experimental example group (Ex1-1 to Ex1-72) which is not according to the claimed invention, exhibited an at least two-fold increase in external quantum efficiency, reduced driving voltage, and increased luminance. This improvement may be due to the change in the material of the electron transport layer.

Hereinafter, the effectiveness of the electron-blocking layer as a function of the degree of substitution with deuterium will be described in relation to the second experimental example group and the third experimental example group.

In the second experimental example group (Ex2-1 to Ex2-32), according to the claimed invention, the structure as illustrated in the example embodiment FIG. 3 was used, the material of the electron-blocking layer 13 was changed to one of EBM-09 to EBM-16, according to the claimed invention, and the material of the electron transport layer 15 was changed to ETM-08, ETM-19, ETM-31, or ETM-45 according to the claimed invention. The driving voltage, luminance, and external quantum efficiency at a current density of 10 mA/cm² were evaluated, and the lifespan at a high current density of 55 mA/cm² was comparatively evaluated to determine the lifespan under accelerated conditions.

**[Table 2]**

| Item | Structure | | Voltage [V] at 10 mA/cm² | Luminance [Cd/A] at 10 mA/cm² | EQE (%) at 10 mA/ cm² | Lifespan (%) at 55 mA/cm² |
|---|---|---|---|---|---|---|
| | EBL | ETL | | | | |
| Ex2-1 | EBM-09 | ETM-08 | 3.74 | 5.5 | 8.9 | 95 |
| Ex2-2 | EBM-09 | ETM-19 | 3.77 | 5.4 | 8.8 | 101 |
| Ex2-3 | EBM-09 | ETM-31 | 3.69 | 5.7 | 9.1 | 93 |
| Ex2-4 | EBM-09 | ETM-45 | 3.72 | 5.6 | 9.0 | 110 |
| Ex2-5 | EBM-10 | ETM-08 | 3.62 | 5.6 | 9.0 | 104 |
| Ex2-6 | EBM-10 | ETM-19 | 3.79 | 5.5 | 8.8 | 106 |
| Ex2-7 | EBM-10 | ETM-31 | 3.75 | 5.5 | 8.8 | 113 |
| Ex2-8 | EBM-10 | ETM-45 | 3.62 | 5.5 | 8.9 | 110 |
| Ex2-9 | EBM-11 | ETM-08 | 3.64 | 5.7 | 9.1 | 99 |
| Ex2-10 | EBM-11 | ETM-19 | 3.66 | 5.6 | 8.9 | 115 |
| Ex2-11 | EBM-11 | ETM-31 | 3.68 | 5.7 | 9.1 | 112 |
| Ex2-12 | EBM-11 | ETM-45 | 3.78 | 5.5 | 8.8 | 90 |
| Ex2-13 | EBM-12 | ETM-08 | 3.62 | 5.5 | 8.8 | 116 |
| Ex2-14 | EBM-12 | ETM-19 | 3.61 | 5.6 | 8.9 | 96 |
| Ex2-15 | EBM-12 | ETM-31 | 3.64 | 5.5 | 8.8 | 92 |
| Ex2-16 | EBM-12 | ETM-45 | 3.67 | 5.6 | 9.1 | 95 |
| Ex2-17 | EBM-13 | ETM-08 | 3.62 | 5.5 | 8.8 | 105 |
| Ex2-18 | EBM-13 | ETM-19 | 3.73 | 5.4 | 8.7 | 119 |
| Ex2-19 | EBM-13 | ETM-31 | 3.66 | 5.6 | 9.0 | 105 |
| Ex2-20 | EBM-13 | ETM-45 | 3.78 | 5.6 | 9.1 | 91 |
| Ex2-21 | EBM-14 | ETM-08 | 3.73 | 5.6 | 9.0 | 101 |
| Ex2-22 | EBM-14 | ETM-19 | 3.68 | 5.7 | 9.1 | 94 |
| Ex2-23 | EBM-14 | ETM-31 | 3.62 | 5.7 | 8.8 | 109 |
| Ex2-24 | EBM-14 | ETM-45 | 3.60 | 5.7 | 8.9 | 113 |
| Ex2-25 | EBM-15 | ETM-08 | 3.69 | 5.6 | 9.0 | 100 |
| Ex2-26 | EBM-15 | ETM-19 | 3.77 | 5.6 | 9.0 | 112 |
| Ex2-27 | EBM-15 | ETM-31 | 3.65 | 5.5 | 8.8 | 106 |
| Ex2-28 | EBM-15 | ETM-45 | 3.64 | 5.7 | 9.0 | 95 |
| Ex2-29 | EBM-16 | ETM-08 | 3.77 | 5.5 | 8.8 | 116 |
| Ex2-30 | EBM-16 | ETM-19 | 3.79 | 5.5 | 8.8 | 97 |
| Ex2-31 | EBM-16 | ETM-31 | 3.66 | 5.4 | 8.7 | 109 |
| Ex2-32 | EBM-16 | ETM-45 | 3.76 | 5.6 | 9.0 | 107 |

Electron-blocking materials (EBM-09 to EBM-16) according to the claimed invention, containing a 9,9'-spirobifluorene system only substituted with deuterium were used in the second experimental group (Ex2-1 to Ex2-32) according to the claimed invention. In the second experimental example group (Ex2-1 to Ex2-32), according to the claimed invention, the electron transport materials were the same as the first experimental example group (Ex1-1 to Ex1-72) which is not according to the claimed invention, but the deuterium, substitution state of the material in the electron-blocking layer was different. Comparing the second experimental example group (Ex2-1 to Ex2-32) according to the claimed invention, and the first experimental example group (Ex1-1 to Ex1-72), which is not according to the claimed invention, the second experimental example group (Ex2-1 to Ex2-32) showed a slight change in efficiency, but the lifespan was improved by about 10%.

In the third experimental example group (Ex3-1 to Ex3-32), according to the claimed invention, the structure as illustrated in the example embodiment of FIG. 3 was used, the material of the electron-blocking layer 13 was changed to one of EBM-17 to EBM-27, according to the claimed invention, and the material of the electron transport layer 15 was changed to ETM-08, ETM-19, ETM-31 or ETM-45 according to the claimed invention. The driving voltage, luminance, and external quantum efficiency at a current density of 10 mA/cm² were evaluated, and the lifespan at a high current density of 55 mA/cm² was comparatively evaluated to determine the lifespan under accelerated conditions.

**[Table 3]**

| Item | Structure | | Voltage [V] at 10mA/ cm² | Luminance [Cd/A] at 10 mA/cm² | EQE (%) at 10 mA/cm² | Lifespan (%) at 55 mA/cm² |
|---|---|---|---|---|---|---|
| | EBL | ETL | | | | |
| Ex3-1 | EBM-17 | ETM-08 | 3.64 | 5.5 | 8.8 | 124 |
| Ex3-2 | EBM-17 | ETM-19 | 3.72 | 5.6 | 9.1 | 128 |
| Ex3-3 | EBM-17 | ETM-31 | 3.63 | 5.5 | 8.8 | 107 |
| Ex3-4 | EBM-17 | ETM-45 | 3.68 | 5.6 | 9.0 | 110 |
| Ex3-5 | EBM-18 | ETM-08 | 3.68 | 5.4 | 8.7 | 131 |
| Ex3-6 | EBM-18 | ETM-19 | 3.68 | 5.7 | 9.1 | 106 |
| Ex3-7 | EBM-18 | ETM-31 | 3.66 | 5.4 | 8.7 | 114 |
| Ex3-8 | EBM-18 | ETM-45 | 3.72 | 5.5 | 8.9 | 133 |
| Ex3-9 | EBM-19 | ETM-08 | 3.65 | 5.6 | 8.9 | 128 |
| Ex3-10 | EBM-19 | ETM-19 | 3.80 | 5.6 | 9.0 | 117 |
| Ex3-11 | EBM-19 | ETM-31 | 3.62 | 5.4 | 8.8 | 109 |
| Ex3-12 | EBM-19 | ETM-45 | 3.79 | 5.5 | 8.8 | 120 |
| Ex3-13 | EBM-20 | ETM-08 | 3.73 | 5.6 | 9.0 | 127 |
| Ex3-14 | EBM-20 | ETM-19 | 3.69 | 5.5 | 8.8 | 115 |
| Ex3-15 | EBM-20 | ETM-31 | 3.63 | 5.5 | 8.9 | 130 |
| Ex3-16 | EBM-20 | ETM-45 | 3.60 | 5.7 | 9.1 | 113 |
| Ex3-17 | EBM-21 | ETM-08 | 3.73 | 5.5 | 8.9 | 107 |
| Ex3-18 | EBM-21 | ETM-19 | 3.65 | 5.5 | 8.8 | 115 |
| Ex3-19 | EBM-21 | ETM-31 | 3.75 | 5.5 | 8.8 | 109 |
| Ex3-20 | EBM-21 | ETM-45 | 3.73 | 5.5 | 8.8 | 113 |
| Ex3-21 | EBM-22 | ETM-08 | 3.80 | 5.5 | 8.8 | 127 |
| Ex3-22 | EBM-22 | ETM-19 | 3.69 | 5.4 | 8.7 | 114 |
| Ex3-23 | EBM-22 | ETM-31 | 3.80 | 5.7 | 9.1 | 108 |
| Ex3-24 | EBM-22 | ETM-45 | 3.66 | 5.7 | 9.1 | 129 |
| Ex3-25 | EBM-23 | ETM-08 | 3.66 | 5.5 | 8.9 | 117 |
| Ex3-26 | EBM-23 | ETM-19 | 3.75 | 5.5 | 8.9 | 118 |
| Ex3-27 | EBM-23 | ETM-31 | 3.79 | 5.6 | 9.1 | 109 |
| Ex3-28 | EBM-23 | ETM-45 | 3.74 | 5.5 | 8.8 | 113 |
| Ex3-29 | EBM-24 | ETM-08 | 3.63 | 5.5 | 8.8 | 113 |
| Ex3-30 | EBM-24 | ETM-19 | 3.72 | 5.5 | 8.9 | 129 |
| Ex3-31 | EBM-24 | ETM-31 | 3.79 | 5.7 | 9.1 | 112 |
| Ex3-32 | EBM-24 | ETM-45 | 3.78 | 5.6 | 8.9 | 134 |

Electron-blocking materials (EBM-17 to EBM-24) according to the claimed invention, in which phenyl as well as spirofluorene were substituted with deuterium were used in the third experimental example group (Ex3-1 to Ex3-32) according to the claimed invention. In the third experimental example group (Ex3-1 to Ex3-32), according to the claimed invention, the electron transport materials were the same as the first experimental example group (Ex1-1 to Ex1-72) which is not according to the claimed invention, but the deuterium substitution state of the material in the electron-blocking layer was different. Comparing the third experimental example group (Ex3-1 to Ex3-32) according to the claimed invention, and the first experimental example group (Ex1-1 to Ex1-72), which is not according to the claimed invention, the third experimental example group (Ex3-1 to Ex3-32) showed a slight change in efficiency, but the lifespan was improved by about 20% or more.

It can be seen that when the electron transport material having excellent or high efficiency was used for the electron transport layer in the experiments of the second and third experimental example groups (Ex2-1 to Ex2-32, Ex3-1 to Ex3-32), according to the claimed invention, lifespan characteristics were maintained or improved by substituting the material of the electron-blocking layer with deuterium.

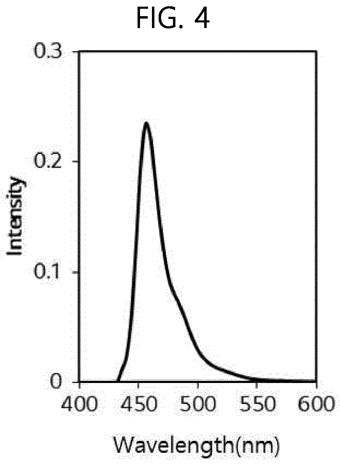

FIG. 4 is a graph showing the emission spectrum of the light emitting device used in experimental examples.

All of the first experimental example group (Ex1-1 to which is not according to the claimed invention, the second experimental example group (Ex2-1 to Ex2-32), according to the claimed invention, and the third experimental example group (Ex3-1 to Ex-3-32) according to the claimed invention, used boron-based dopants having an emission peak of approximately 450 nm to 455 nm and emit light in a blue wavelength range, as illustrated in FIG. 4.

In the experiment described above, the material of Formula 5 was used as the boron-based dopant. Any one of the materials of Formulas 9 to 16 may also be used as the boron-based dopant of the fluorescent blue light emitting layer in the light emitting device according to an example embodiment of the present disclosure. Any one of the materials of Formulas 9 to 16 may enable emission of blue light having an emission peak of 430 nm to 480 nm.

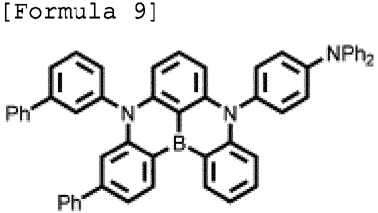

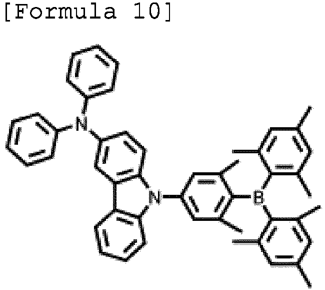

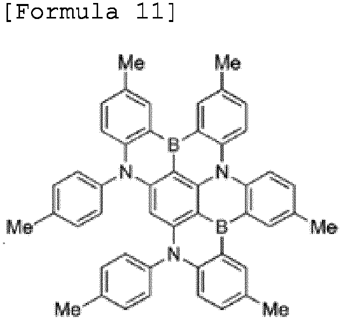

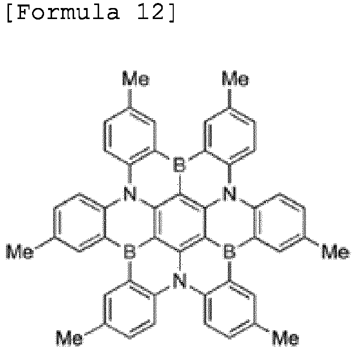

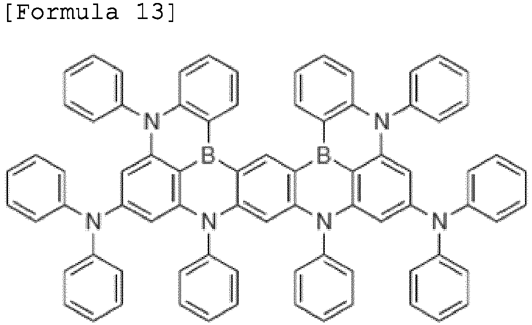

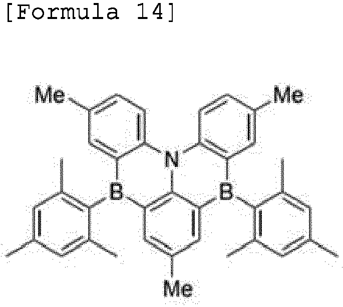

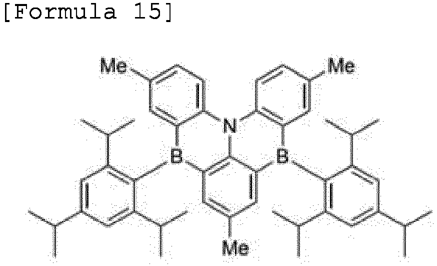

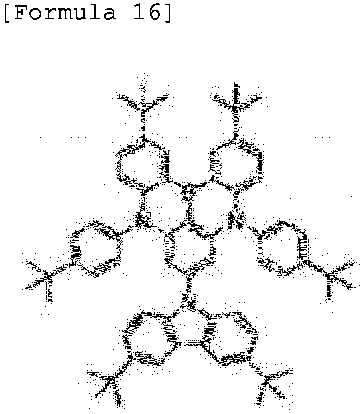

Hereinafter, a specific example of a light emitting device of the present invention and a light emitting display using the same will be described in detail.

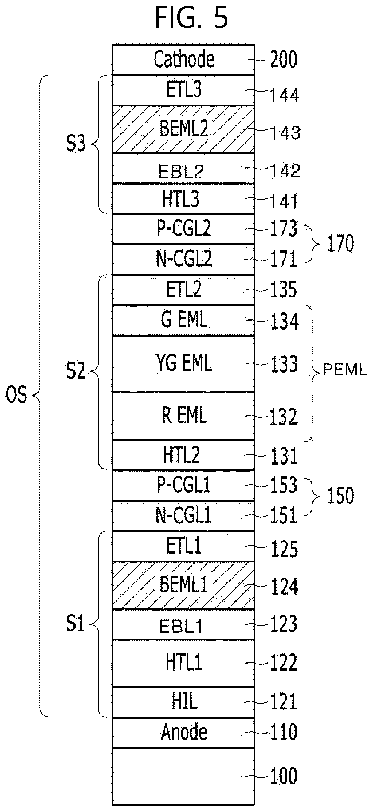

FIG. 5 is a cross-sectional view schematically illustrating an example of a light emitting device of the present invention.

As shown in FIG. 5, the light emitting device according to an embodiment of the present invention is an example having three stacks S1, S2, and S3 between the anode 110 and the cathode 200. Here, the first to third stacks S1, S2, and S3 are divided by the first and second charge generation layers 150 and 170. The first stack S1 includes a hole injection layer 121, a first hole transport layer 122, a first electron-blocking layer 123 of or including the second material including the compound of Formula 2, a first blue light emitting layer 124 containing a boron-based fluorescent dopant, and a first electron transport layer 125 formed of or including the first material of Formula 1, sequentially stacked between the anode 110 and the first charge generation layer 150.

The second stack S2 is disposed between the first and second charge generation layers 150 and 170. The second stack S2 includes a phosphorescent light emitting layer (PEML) including a red light emitting layer 132, a yellowish green light emitting layer 133, and a green light emitting layer 134 stacked in the order, a second hole transport layer 131 under the red light emitting layer 132, and a second electron transport layer 135 on the green light emitting layer 134.

The third stack S3 is disposed between the second charge generation layer 170 and the cathode 200. The third stack S3 includes a third hole transport layer 141, a second electron-blocking layer 142, a second blue light emitting layer 143, and a third electron transport layer 144, which are sequentially stacked.

In addition, the cathode 200 may be formed on the second electron transport layer 144. In some embodiments, an electron injection layer may be further formed between the third electron transport layer 144 and the cathode 200.

The first and second charge generation layers 150 and 170 between the stacks include n-type charge generation layers 151 and 171, each functioning to produce electrons and transfer the electrons to an adjacent stack. The first and second charge generation layers 150 and 170 also include p-type charge generation layers 153 and 173, each functioning to produce holes and transfer the holes to an adjacent stack. In some embodiment, the first and second charge generation layers 150 and 170 may be also formed as a single layer by doping one or more hosts with both an n-type dopant and a p-type dopant.

As described above, the first electron-blocking layer 123, the first blue light emitting layer 124, and the first electron transport layer 125 of the first stack S1 may function as the electron-transport-and-blocking unit described in the example embodiment of FIG. 2. Blue light emission efficiency can be improved by changing the material. A decrease in lifespan can be more effectively prevented or reduced by avoiding accumulation of excitons and electrons at the interface between the first electron-blocking layer 123 and the first blue light emitting layer 124. Similarly, the second electron-blocking layer 142, the second blue light emitting layer 143, and the third electron transport layer 144 of the third stack S3 can function as the electron transport blocking unit described in the example embodiment of FIG. 2. Blue light emission efficiency can be improved by changing the material. A decrease in lifespan can be more effectively prevented or reduced by avoiding accumulation of excitons and electrons at the interface between the second electron-blocking layer 142 and the second blue light emitting layer 143.

In addition, when the electron injection layer is formed adjacent to the cathode 200, metal doping may be performed to increase electron injection efficiency. In some embodiments, the third electron transport layer 144 may be formed using a mixture including benzimidazole of Formula 8 and the first material of Formula 1 described above.

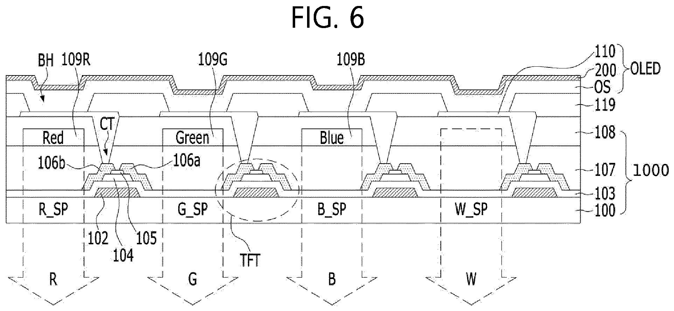

FIG. 6 illustrates a cross-sectional view of a light emitting display using the light emitting device according to an example embodiment of the present invention.

The light emitting device may be commonly applied to a plurality of subpixels to emit white light to a light emitting electrode.

As illustrated in the example embodiment of FIG. 6, the light emitting display according to an example embodiment of the present invention includes a substrate 100 having a plurality of subpixels R_SP, G_SP, B_SP, and W_SP, a light emitting device (also referred to as "OLED, organic light emitting diode") commonly provided on the substrate 100, a thin film transistor (TFT) provided in each of the subpixels and connected to the anode 110 of the light emitting device (OLED), and color filters 109R, 109G, or 109B provided below the anode 110 of at least one of the subpixels.

The illustrated example embodiment relates to a configuration including the white subpixel W_SP, but the present invention is not limited thereto. A configuration in which the white subpixel W_SP is omitted and only the red, green, and blue subpixels R_SP, G_SP, and B_SP are provided is also possible. In some embodiment, a combination of a cyan subpixel, a magenta subpixel, and a yellow subpixel capable of creating white by replacing the red, green, and blue subpixels is possible.

The thin film transistor TFT includes, for example, a gate electrode 102, a semiconductor layer 104, and a source electrode 106a and a drain electrode 106b connected to each side of the semiconductor layer 104. In addition, a channel protection layer 105 may be further provided on the portion where the channel of the semiconductor layer 104 is located to prevent or reduce direct connection between the source/drain electrodes 106a and 106b and the semiconductor layer 104.

A gate insulating layer 103 is provided between the gate electrode 102 and the semiconductor layer 104.

The semiconductor layer 104 may be formed of, for example, an oxide semiconductor, amorphous silicon, polycrystalline silicon, or a combination thereof. For example, when the semiconductor layer 104 is an oxide semiconductor, the heating temperature required for forming the thin film transistor can be lowered, and thus the substrate 100 can be selected from among a greater variety of available types thereof, so the semiconductor layer 104 can be advantageously applied to a flexible display device.

In addition, the drain electrode 106b of the thin film transistor TFT may be connected to the anode 110 in a contact hole CT formed in the first and second passivation layers 107 and 108.

The first passivation layer 107 is provided to primarily protect the thin film transistor TFT. Color filters 109R, 109G, and 109B may be provided thereon.

When the plurality of subpixels includes a red subpixel, a green subpixel, a blue subpixel, and a white subpixel, the color filter may include first to third color filters 109R, 109G, and 109B in each of the subpixels excluding the white subpixel W_SP. The color filters 109R, 109G, and 109B allow the emitted white light to pass through the anode 110 for each wavelength. A second passivation layer 108 is formed under the anode 110 to cover the first to third color filters 109R, 109G, and 109B. The anode 110 is formed on the surface of the second passivation layer 108 excluding the contact hole CT.

Here, a configuration from the substrate 100 to the thin film transistor TFT, color filters 109R, 109G, and 109B, and the first and second passivation layers 107 and 108 is referred to as a "thin film transistor array substrate" 1000.

The light emitting device OLED is formed on the thin film transistor array substrate 100 including the bank 119, which is adjacent to a light emitting part BH. The light emitting device OLED includes, for example, a transparent anode 110, a cathode 200 that faces the anode 110 and is formed of a reflective electrode, and an electron transport and blocking unit ETBU disposed in the blue light emitting stacks S1 and S3, among the stacks divided into the first and second charge generation layers CGL1 and CGL2, between the anode 110 and the cathode 200, as illustrated in the example embodiments of FIGS. 1A to 2 and 5. The electron transport and blocking unit ETBU includes an electron-blocking layer 123 formed of the electron-blocking material of Formula 2, a blue light emitting layer 124 containing a boron-based blue dopant, and an electron transport layer 125 containing the electron transport material of Formula 1.

The anode 110 is divided for each subpixel. The remaining layers of the white-light emitting device OLED are integrally provided in the entire display area, rather than being divided for each subpixel.

When the blue light emitting stack having the electron transport and blocking unit (ETBU) is provided, the material of the electron transport layer in contact with the fluorescent blue light emitting layer, which may have limited internal quantum efficiency, includes the first material represented by Formula 1. The efficiency of the fluorescent light emitting layer can be improved by enhancing the electron transport efficiency.

In addition, when the electron transport layer is formed using a material that may be capable of rapidly transporting electrons, the material of the electron-blocking layer in contact with the fluorescent blue light emitting layer is substituted with deuterium, thereby preventing accumulation of electrons or excitons at the interface between the fluorescent blue light emitting layer and the electron-blocking layer. Improving efficiency, luminance, and quantum efficiency may be achieved without reducing the lifespan.

In addition, improving the efficiency of the blue fluorescent stack including the fluorescent blue light emitting layer can reduce the number of blue stacks required in a light emitting device realizing white light. Thus, the number of stacks to realize the same efficiency of white may be reduced. The yield based on reduced driving voltage may be improved and simplified processing may be achieved.

The light emitting device according to an embodiment of the present invention includes an anode and a cathode facing each other, a first stack and a second stack disposed between the anode and the cathode, and a charge generation layer disposed between the first stack and the second stack, wherein the first stack includes a first electron-blocking layer, a first blue light emitting layer containing a boron-based compound emitting light having a wavelength of 430 nm to 480 nm, and a first electron transport layer, and the second stack includes at least two phosphorescent light emitting layers emitting light having a longer wavelength than that of the light emitted by the first blue light emitting layer, wherein the first electron transport layer includes the first material of Formula 1, the second material of the first electron-blocking layer includes a 9,9 - spirobifluorene, and at least one spirofluorene of the 9,9'-spirobifluorene is substituted with deuterium.

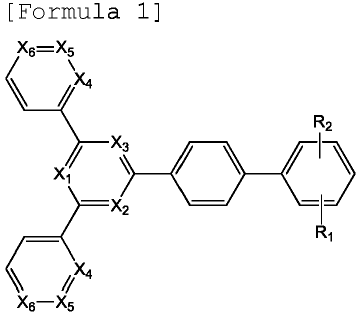

R₁ and R₂ are each independently selected from a cycloalkyl group, an aryl group and a heteroaryl group. X₁, X₂ and X₃ are each independently N or CH. At least one among X₄, X₅ and X₆ is N, and the remaining of X₄, X₅, and X₆ are a CH.

In some embodiments, the second material may include a compound represented by Formula 2 below.

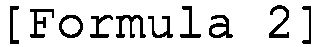

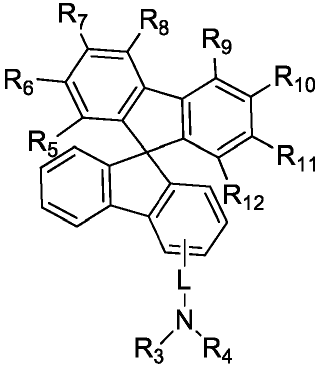

L is a single bond, or is selected from a deuterium-substituted or unsubstituted phenylene group and a deuterium-substituted or unsubstituted naphthylene group. R₃ and R₄ are each independently selected from an unsubstituted or a deuterium-substituted phenyl group, a deuterium-substituted or unsubstituted biphenyl group, and a deuterium-substituted or unsubstituted heteroaryl group. Each of R₅ to R₁₂ may be substituted with deuterium.. In an embodiment, R₃ and R₄ are partially deuterium-substituted. In another embodiment, R₃ and R₄ are fully deuterium-substituted. R₅ to R₁₂ each represent deuterium.

In some embodiments, the first electron-blocking layer may be in contact with one surface of the first blue light emitting layer, the first electron transport layer may be in contact with the other surface of the first blue light emitting layer, and one surface and the other surface of the first blue light emitting layer may face each other, with a gap therebetween **corresponding** to a thickness of the first blue light emitting layer.

In some embodiments, the at least two phosphorescent light emitting layers may include a red light emitting layer adjacent to the first stack and a green light emitting layer adjacent to the cathode.

In some embodiments, a yellowish green light emitting layer may be further included between the red light emitting layer and the green light emitting layer.

In some embodiments, the light emitting device may further include at least one stack between the second stack and the cathode, wherein the at least one stack between the second stack and the cathode includes a second electron-blocking layer including the second material, the second blue light emitting layer emitting the same color as the first blue light emitting layer, and a second electron transport layer including the first material.

In some embodiments, the light emitting device may further include an electron injection layer between the second electron transport layer and the cathode, and the second electron transport layer may further include a third material.

In some embodiments, at least one of R₁ and R₂ may be a carbazole group.

In some embodiments, the carbazole group includes a phenyl group as a substituent.

In some embodiments, at least one of R₁ and R₂ is a phenyl group.

In some embodiments, at least one of R₁ and R₂ is biphenyl group.

In some embodiments, at least one of R₃ and R₄ is a deuterium-substituted or unsubstituted biphenyl group.

In some embodiments, at least one of R₃ and R₄ is a perdeuterated biphenyl group.

In some embodiments, at least one of R₃ and R₄ is a deuterium-substituted or unsubstituted dimethylfluorene group.

In some embodiments, at least one of R₃ and R₄ is a perdeuterated dimethylfluorene group.

In some embodiments, at least one of R₃ and R₄ is a deuterium-substituted or unsubstituted carbazole group.

In some embodiments, at least one of R₃ and R₄ is a perdeuterated carbazole group.

In some embodiments, the carbazole group includes a deuterium-substituted or unsubstituted phenyl group as a substituent.

In some embodiments, at least one of R₃ and R₄ is a deuterium-substituted or unsubstituted dibenzofuran group.

In other example embodiments of the present disclosure, a light emitting display according to another embodiment of the present invention may include a substrate including a plurality of subpixels, each of the subpixels includes a thin film transistor disposed therein, and a light emitting device connected to the thin film transistor. The light emitting device including an anode and a cathode facing each other, a first stack and a second stack disposed between the anode and the cathode, the first stack including a first electron transport layer includes a first material represented by Formula 1, a first electron-blocking layer including a second material including a 9,9'-spirobifluorene group, and at least one spirofluorene group of the 9,9' -spirobifluorene is substituted by deuterium, and a first blue light emitting layer containing a boron-based compound emitting light having a wavelength of 430 nm to 480 nm, and the second stack including at least two phosphorescent light emitting layers emitting light having a longer wavelength than a wavelength of light emitted by the first blue light emitting layer; and a charge generation layer disposed between the first stack and the second stack, wherein the Formula 1 is:

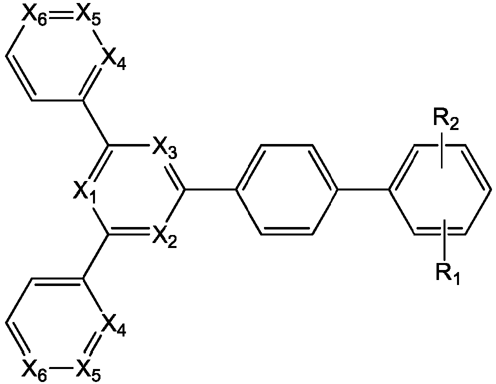

R₁ and R₂ are each independently selected from a cycloalkyl group, an aryl group, and a heteroaryl group, X₁, X₂, and X₃ are each independently N or CH, and X₄, X₅ or X₆ is N, and remaining of X₄, X₅, and X₆ are CH.

The light emitting device of the present invention and a light emitting display including the same have the following effects.

First, the material of the electron transport layer in contact with the fluorescent blue light emitting layer, which has limited internal quantum efficiency, is changed in the fluorescent light emitting stack connected to a phosphorescent light emitting stack and a charge generation layer, so the electron transport efficiency can be enhanced and thus the efficiency of the fluorescent light emitting layer can be improved.

Second, when the electron transport layer is formed using a material capable of rapidly transporting electrons, the material of the electron-blocking layer in contact with the fluorescent blue light emitting layer is substituted with deuterium, thereby preventing accumulation of electrons or excitons at the interface between the fluorescent blue light emitting layer and the electron-blocking layer and obtaining the effect of improving efficiency, luminance, and quantum efficiency without reducing the lifespan.

Third, improving the efficiency of the blue fluorescent stack including the fluorescent blue light emitting layer can reduce the number of blue stacks required in a light emitting device realizing white light, and can thus reduce the number of stacks required to realize white with the same efficiency, thereby improving yield based on reduced driving voltage and simplified processing.

It will be apparent to those skilled in the art that various modifications and variations can be made in the present invention without departing from the scope of the invention. Thus, it is intended that the present invention covers such modifications and variations thereto, provided they fall within the scope of the appended claims.

## Claims

1. A light emitting device comprising:
an anode (110) and a cathode (200) facing each other;
a first stack (S1) and a second stack (S2) disposed between the anode and the cathode,
the first stack comprising:
a first electron-blocking layer (EBL1);
a first blue light emitting layer (BEML1) containing a boron-based compound emitting light having a wavelength of 430 nm to 480 nm; and
a first electron transport layer (ETL1), and
the second stack comprising at least two phosphorescent light emitting layers (R EML, YG EML, G EML) emitting light having a longer wavelength than a wavelength of light emitted by the first blue light emitting layer; and
a charge generation layer (CGL1) disposed between the first stack and the second stack,
wherein the first electron transport layer comprises a first material of Formula 1, a second material of the first electron-blocking layer comprises a 9,9'-spirobifluorene, and at least one spirofluorene of the 9,9'-spirobifluorene is substituted with deuterium, 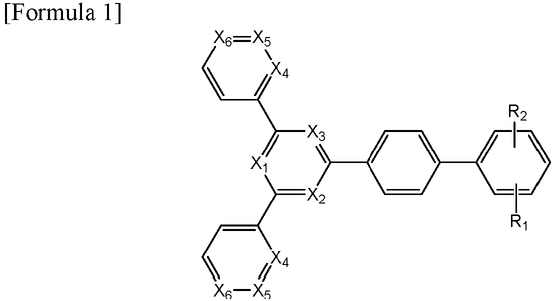
wherein R₁ and R₂ are each independently selected from a cycloalkyl group, an aryl group and a heteroaryl group;
X₁, X₂, and X₃ are each independently N or CH; and
at least one among X₄, X₅, and X₆ is N, and remaining ones are CH.

2. The light emitting device according to claim 1, wherein the second material comprises a compound represented by Formula 2 below: 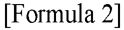 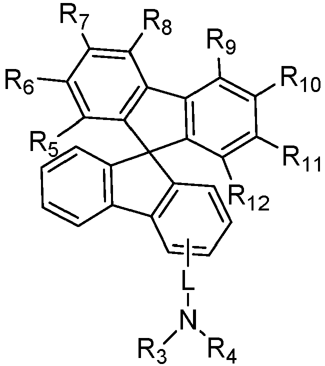
wherein L is a single bond, or is selected from a deuterium-substituted or unsubstituted phenylene group and a deuterium-substituted or unsubstituted naphthylene group;
R₃ and R₄ are each independently selected from an unsubstituted or a deuterium-substituted phenyl group, a deuterium-substituted or unsubstituted biphenyl group, a deuterium-substituted or unsubstituted dimethylfluorene group, and a deuterium-substituted heteroaryl group; and
R₅ to R₁₂ each represent deuterium.

3. The light emitting device according to claim 1, wherein at least one of R₁ and R₂ is a carbazole group and the carbazole group includes a phenyl group as a substituent.

4. The light emitting device according to claim 1, wherein at least one of R₁ and R₂ is a phenyl group or a biphenyl group.

5. The light emitting device according to claim 2, wherein at least one of R₃ and R₄ includes at least one of a biphenyl group, a dimethylfluorene group, a carbazole group, a dibenzofuran group, a deuterium-substituted biphenyl group, a deuterium-substituted dimethylfluorene group, a deuterium-substituted carbazole group, a deuterium-substituted dibenzofuran group, a perdeuterated biphenyl group, a perdeuterated dimethylfluorene group or a perdeuterated carbazole group.

6. The light emitting device according to claim 5, wherein the carbazole group includes a phenyl group as a substituent.

7. The light emitting device according to claim 2, wherein R₃ and R₄ are fully deuterium-substituted.

8. The light emitting device according to claim 1, wherein the compound of Formula 1 is one of the following compounds:

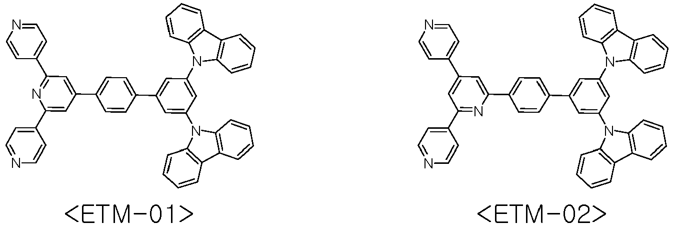

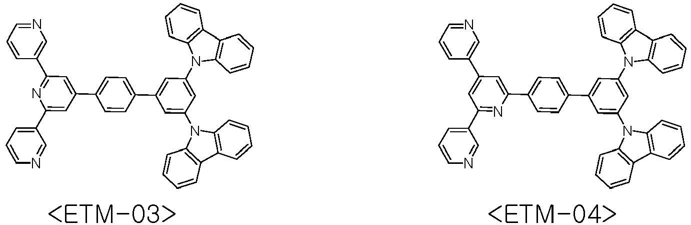

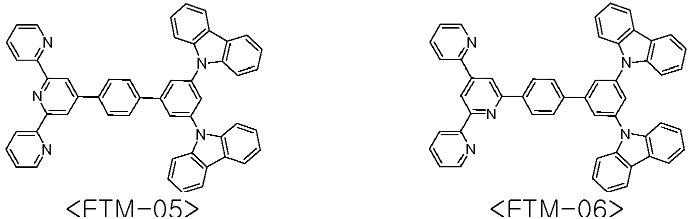

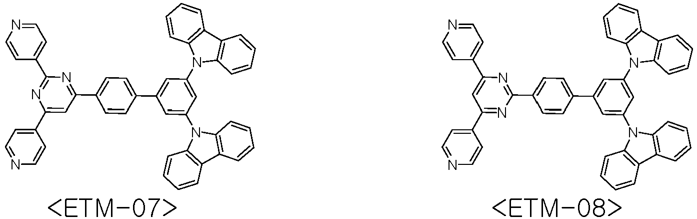

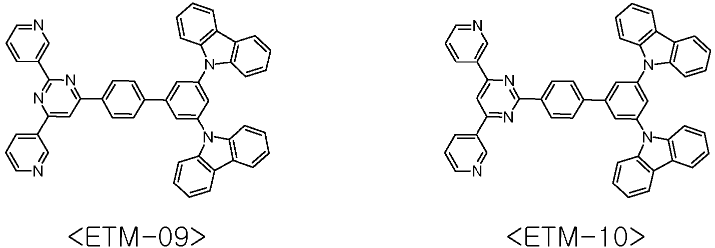

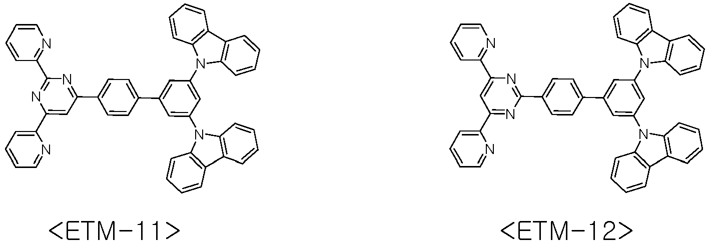

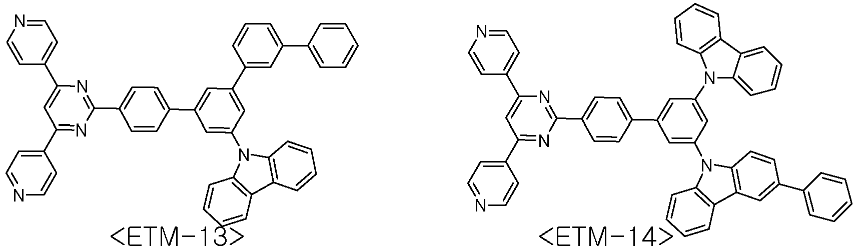

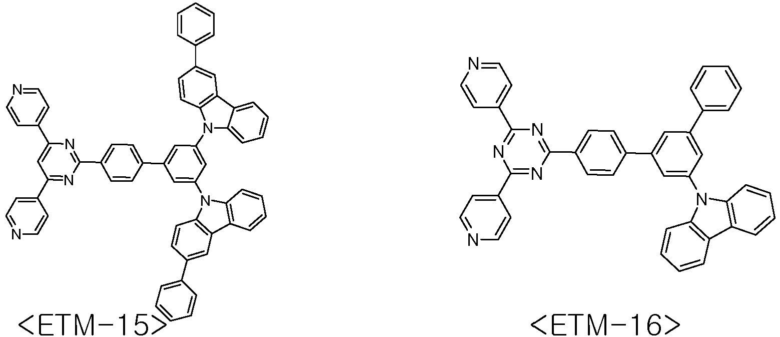

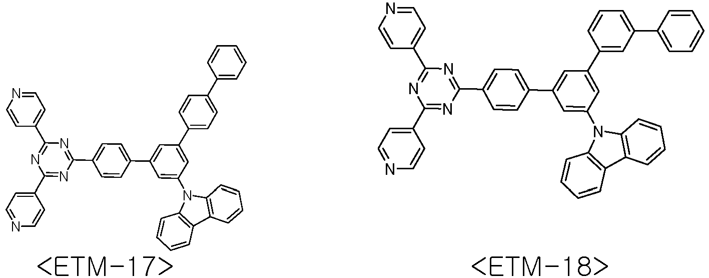

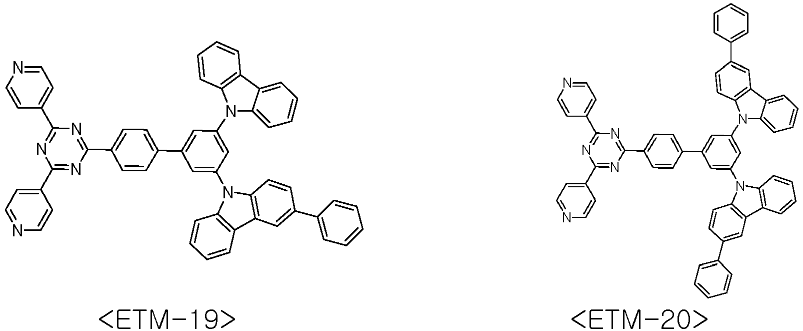

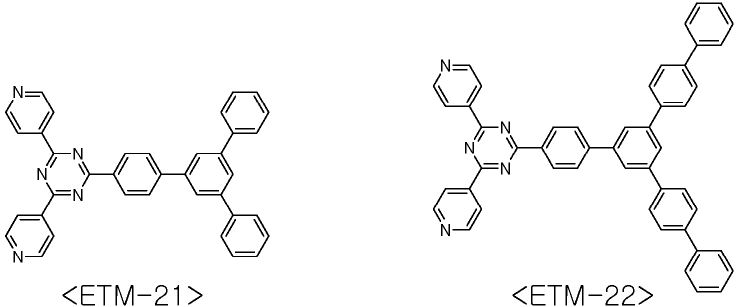

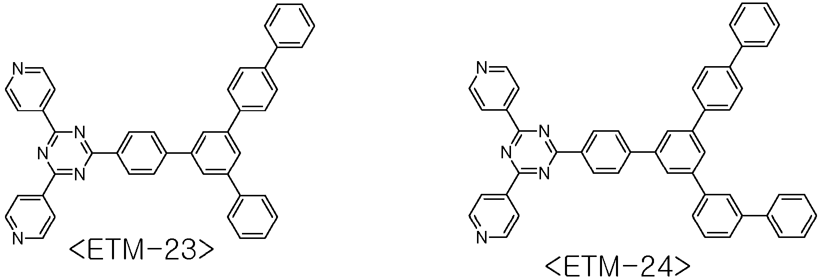

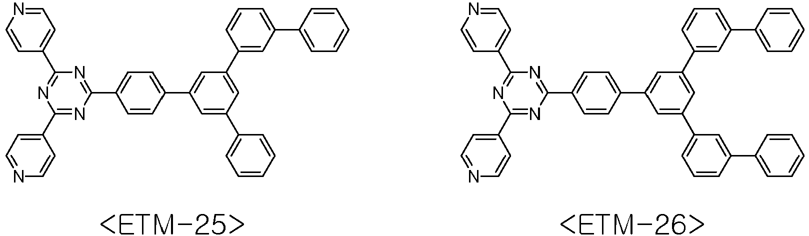

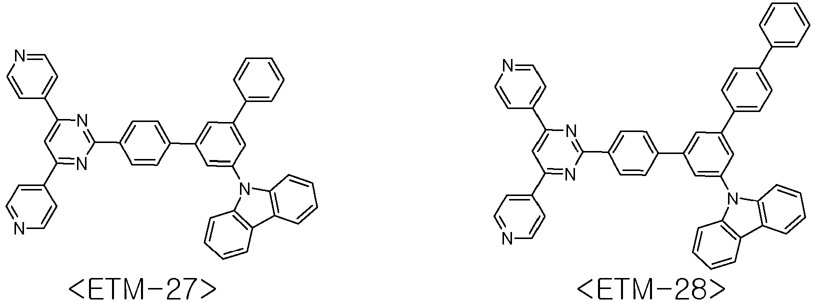

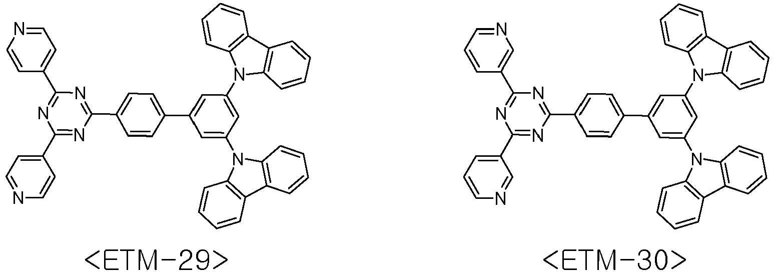

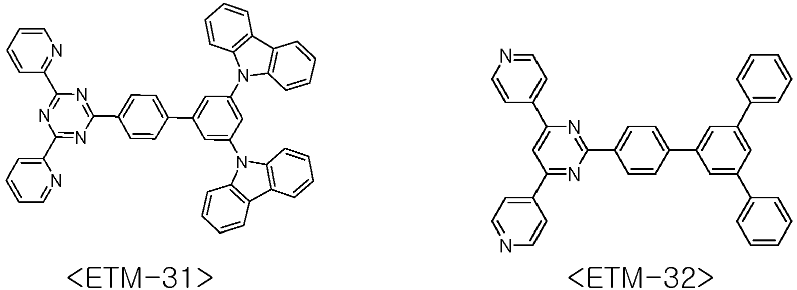

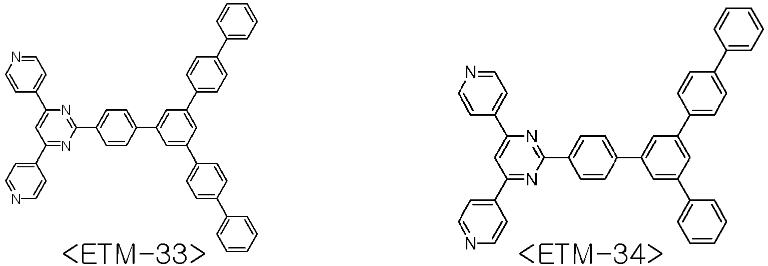

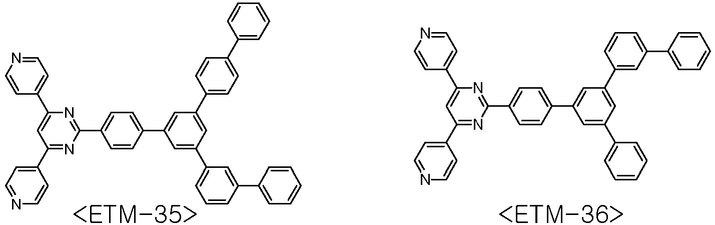

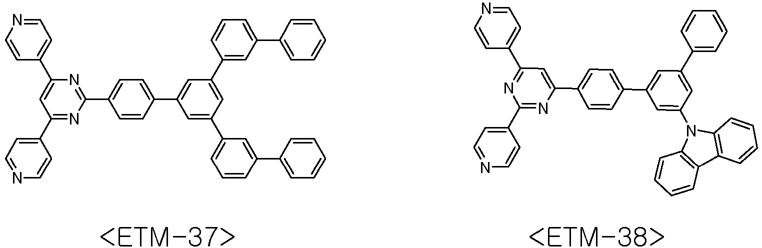

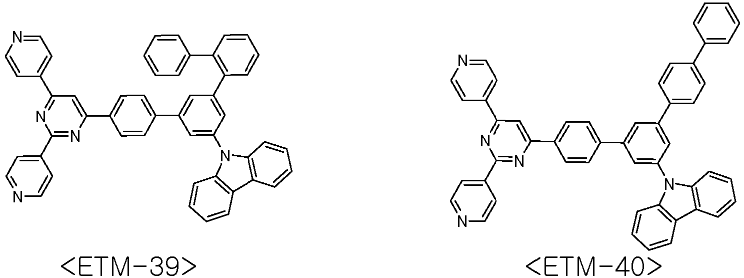

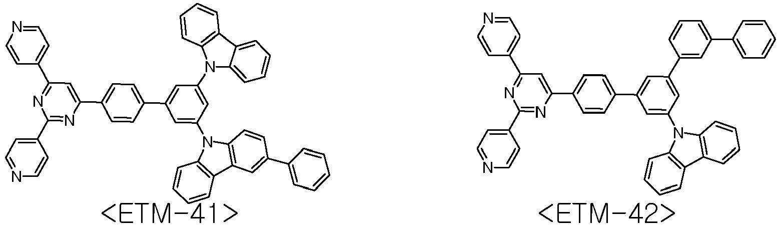

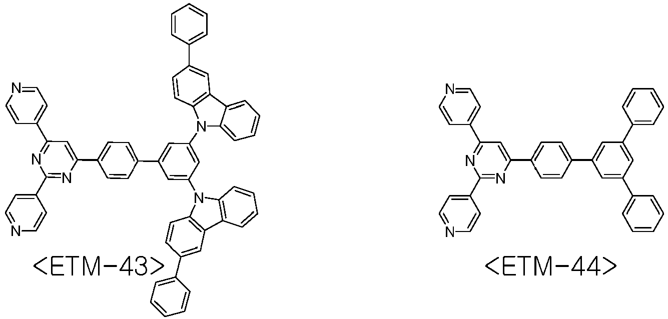

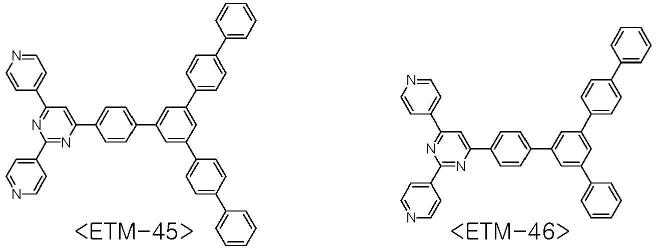

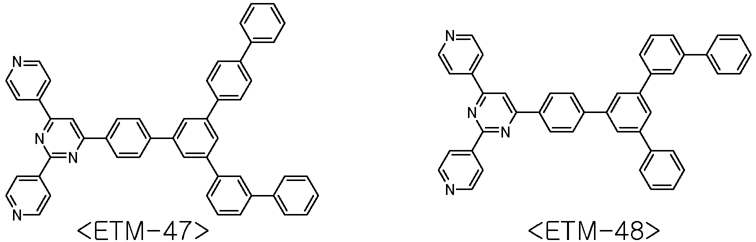

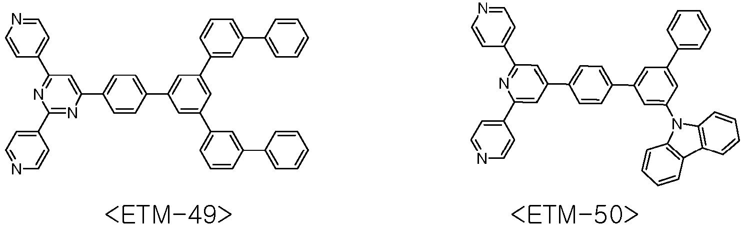

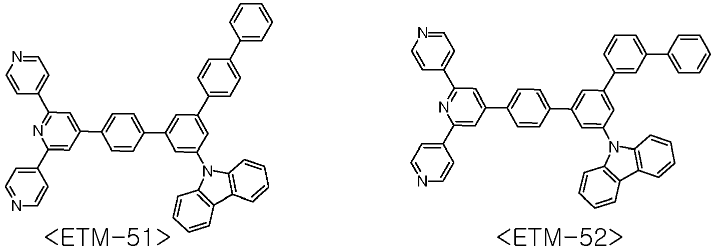

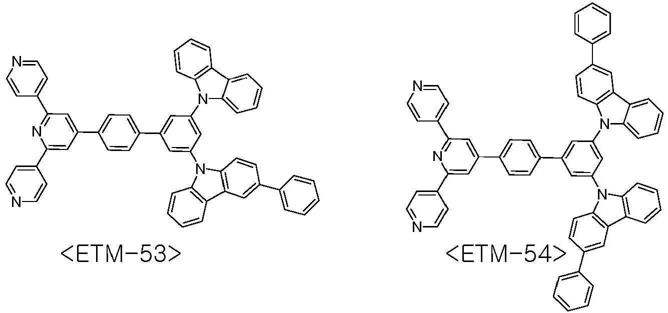

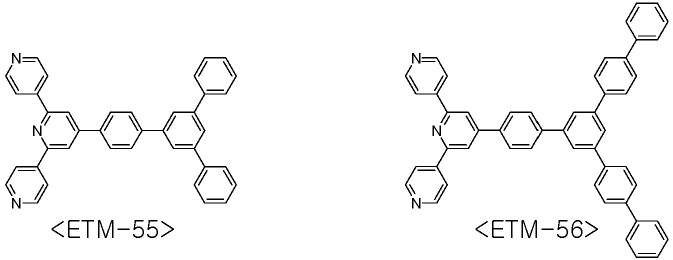

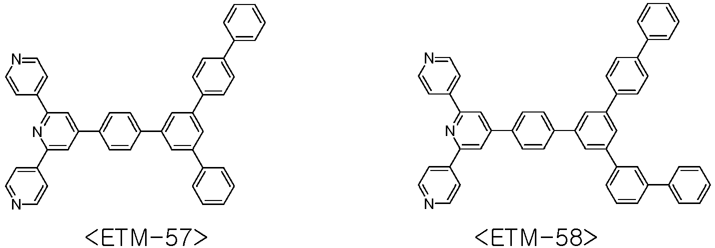

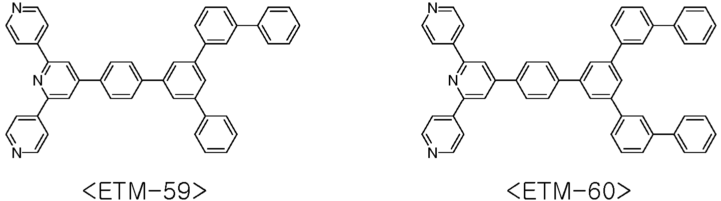

9. The light emitting device according to anyone of claims 2 to 8, wherein the compound of Formula is one the following compounds:

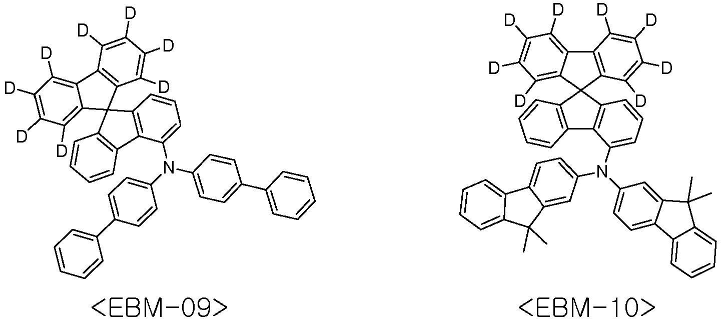

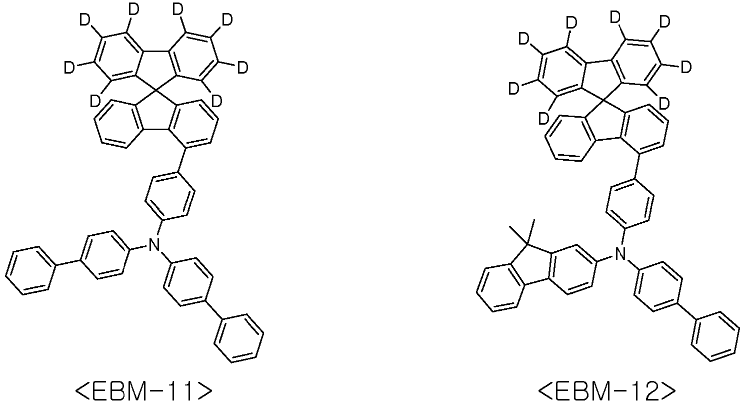

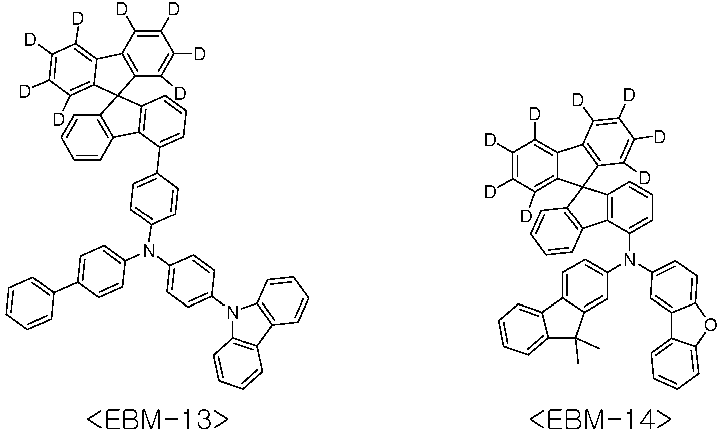

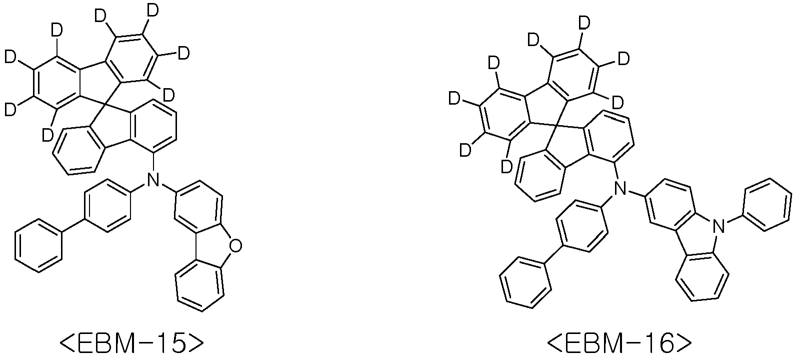

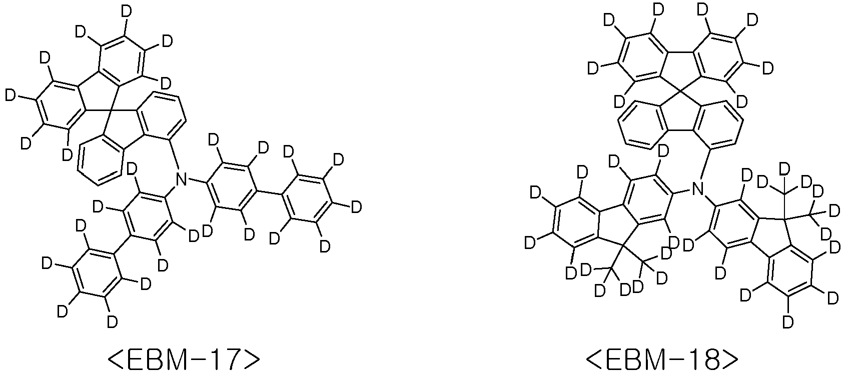

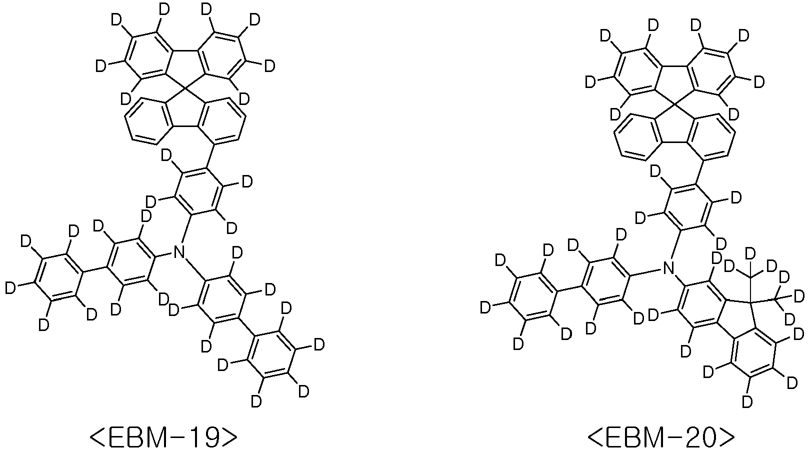

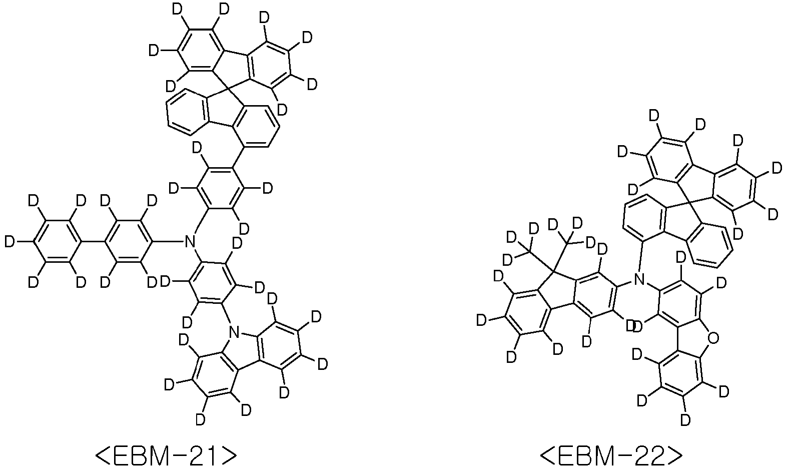

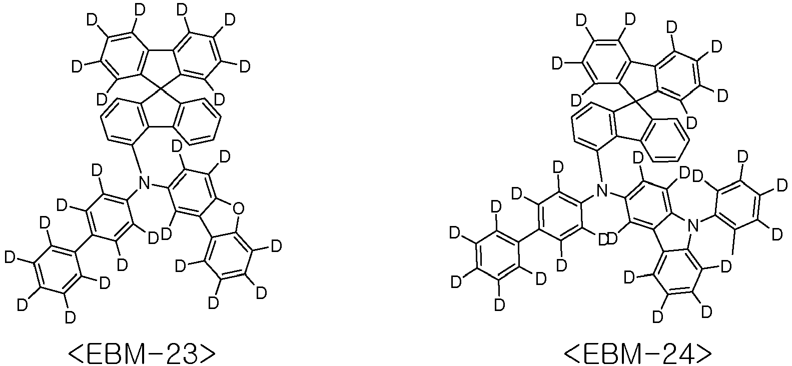

10. The light emitting device according to anyone of claims 1 to 9, wherein the first electron-blocking layer is in contact with one surface of the first blue light emitting layer, the first electron transport layer is in contact with the other surface of the first blue light emitting layer, and one surface and the other surface of the first blue light emitting layer face each other, with a gap therebetween corresponding to a thickness of the first blue light emitting layer.

11. The light emitting device according to anyone of claims 1 to 10, wherein the at least two phosphorescent light emitting layer of the second stack comprises:
a red light emitting layer adjacent to the first stack; and
a green light emitting layer adjacent to the cathode.

12. The light emitting device according to claim 11, wherein the at least two phosphorescent light emitting layers further comprise a yellowish green light emitting layer between the red light emitting layer and the green light emitting layer.

13. The light emitting device according to anyone of claims 1 to 12, further comprising at least one stack between the second stack and the cathode,
wherein the at least one stack between the second stack and the cathode comprises:
a second electron-blocking layer including the second material;
a second blue light emitting layer emitting the same color as the first blue light emitting layer; and
a second electron transport layer including the first material.

14. The light emitting device according to claim 13, further comprising an electron injection layer between the second electron transport layer and the cathode,
wherein the second electron transport layer further comprises a third material.

15. A light emitting display comprising:
a substrate including a plurality of subpixels;
a thin film transistor provided in each of the subpixels on the substrate; and
a light emitting device connected to the thin film transistor,
wherein the light emitting device is according to anyone of claims 1 to 14.

## Patentansprüche

1. Lichtemittierende Vorrichtung, umfassend:
eine Anode (110) und eine Kathode (200), die einander gegenüberliegen;
einen ersten Stapel (S1) und einen zweiten Stapel (S2), die zwischen der Anode und der Kathode angeordnet sind,
wobei der erste Stapel umfasst:
eine erste Elektronenblockierschicht (EBL1);
eine erste blaues Licht emittierende Schicht (BEML1), die eine Bor-basierte Verbindung enthält, die Licht mit einer Wellenlänge von 430 nm bis 480 nm emittiert; und
eine erste Elektronentransportschicht (ETL1), und
wobei der zweite Stapel mindestens zwei phosphoreszierende Licht emittierende Schichten (R EML, YG EML, G EML), die Licht mit einer längeren Wellenlänge emittieren als die Wellenlänge des von der ersten blaues Licht emittierenden Schicht emittierten Lichts; und
eine Ladungserzeugungsschicht (CGL1), die zwischen dem ersten Stapel und dem zweiten Stapel angeordnet ist, umfasst
wobei die erste Elektronentransportschicht ein erstes Material der Formel 1 umfasst, ein zweites Material der ersten Elektronenblockierschicht ein 9,9'-Spirobifluoren umfasst und mindestens ein Spirofluoren des 9,9'-Spirobifluorens durch Deuterium substituiert ist, 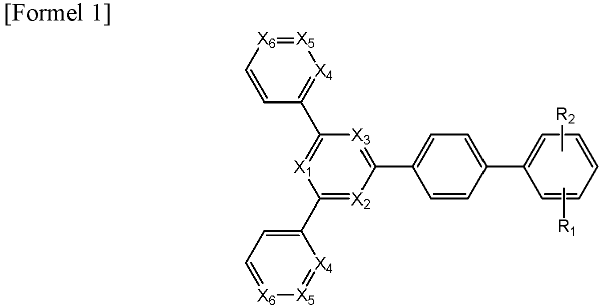
worin R₁ und R₂ jeweils unabhängig voneinander ausgewählt sind aus einer Cycloalkylgruppe, einer Arylgruppe und einer Heteroarylgruppe;
X₁, X₂ und X₃ jeweils unabhängig voneinander N oder CH sind; und
mindestens einer von X₄, X₅ und X₆ N ist und die übrigen CH sind.

2. Lichtemittierende Vorrichtung nach Anspruch 1, wobei das zweite Material eine Verbindung, dargestellt durch die folgende Formel 2, umfasst: 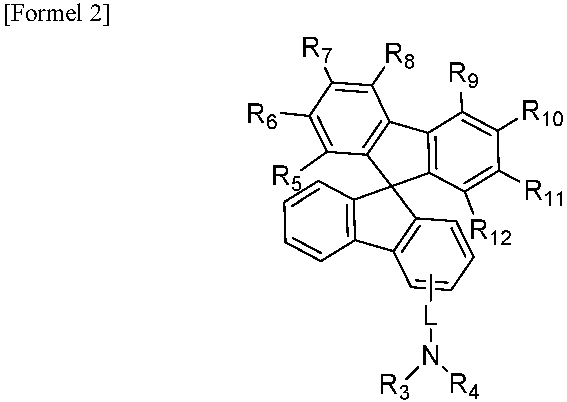
worin L eine Einfachbindung ist oder ausgewählt ist aus einer Deuterium-substituierten oder unsubstituierten Phenylengruppe und einer Deuterium-substituierten oder unsubstituierten Naphthylengruppe;
R₃ und R₄ jeweils unabhängig voneinander ausgewählt sind aus einer unsubstituierten oder Deuterium-substituierten Phenylgruppe, einer Deuterium-substituierten oder unsubstituierten Biphenylgruppe, einer Deuterium-substituierten oder unsubstituierten Dimethylfluorengruppe und einer Deuterium-substituierten Heteroarylgruppe; und
R₅ bis R₁₂ jeweils für Deuterium stehen.

3. Lichtemittierende Vorrichtung nach Anspruch 1, wobei mindestens einer von R₁ und R₂ eine Carbazolgruppe ist und die Carbazolgruppe eine Phenylgruppe als Substituenten enthält.

4. Lichtemittierende Vorrichtung nach Anspruch 1, wobei mindestens einer von R₁ und R₂ eine Phenylgruppe oder eine Biphenylgruppe ist.

5. Lichtemittierende Vorrichtung nach Anspruch 2, wobei mindestens einer von R₃ und R₄ mindestens eine aus einer Biphenylgruppe, einer Dimethylfluorengruppe, einer Carbazolgruppe, einer Dibenzofurangruppe, einer Deuterium-substituierten Biphenylgruppe, einer Deuterium-substituierten Dimethylfluorengruppe, einer Deuterium-substituierten Carbazolgruppe, einer Deuterium-substituierten Dibenzofurangruppe, einer perdeuterierten Biphenylgruppe, einer perdeuterierten Dimethylfluorengruppe oder einer perdeuterierten Carbazolgruppe enthält.

6. Lichtemittierende Vorrichtung nach Anspruch 5, wobei die Carbazolgruppe eine Phenylgruppe als Substituenten enthält.

7. Lichtemittierende Vorrichtung nach Anspruch 2, wobei R₃ und R₄ vollständig Deuterium-substituiert sind.

8. Lichtemittierende Vorrichtung nach Anspruch 1, wobei die Verbindung der Formel 1 eine der folgenden Verbindungen ist:

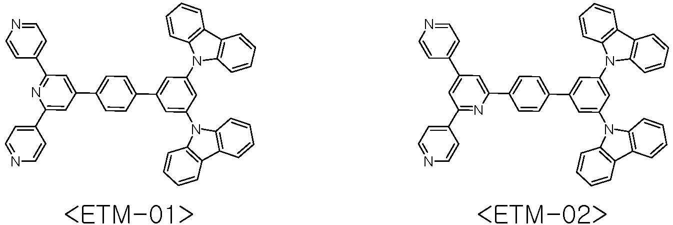

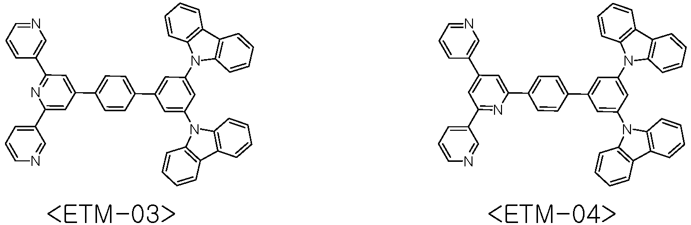

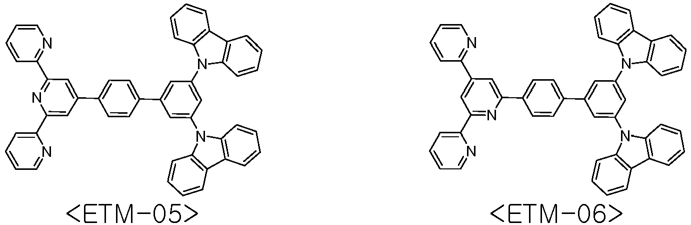

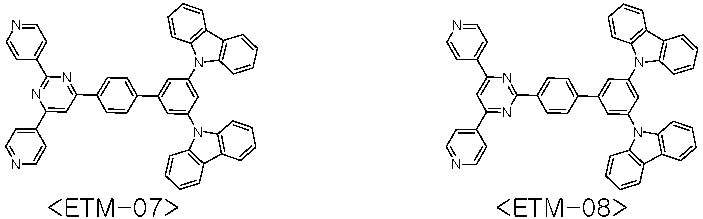

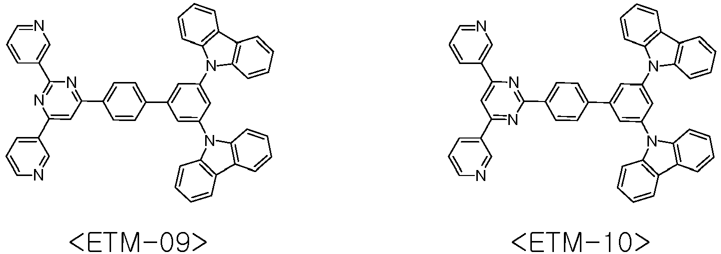

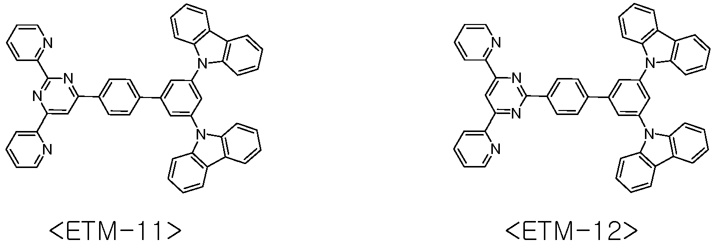

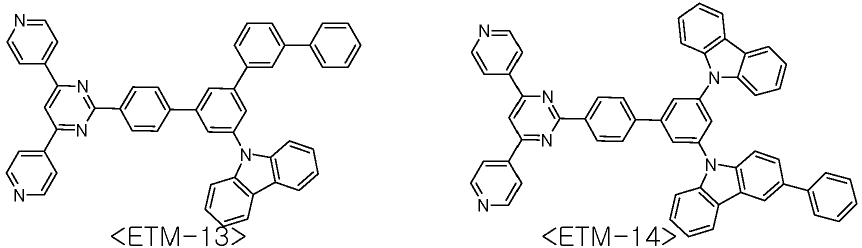

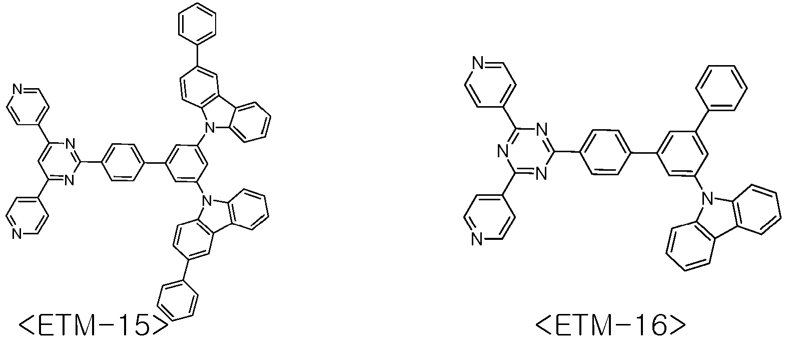

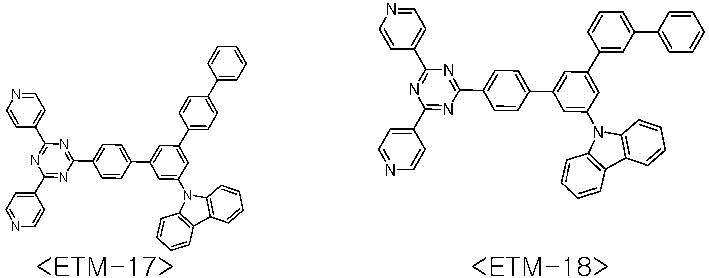

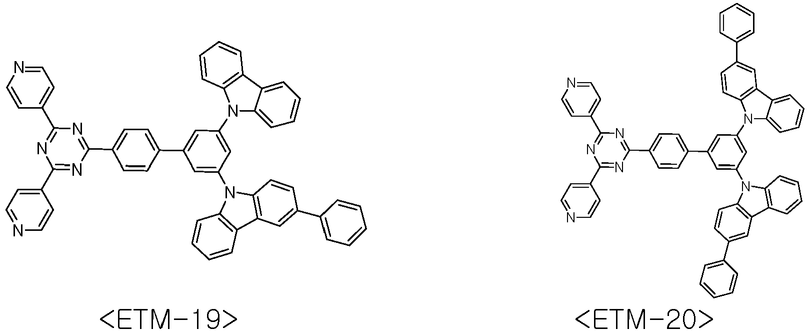

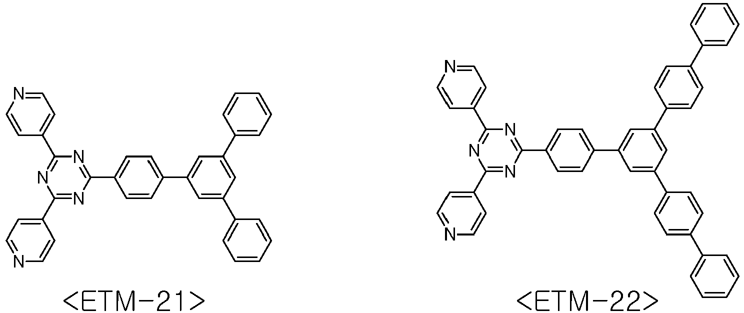

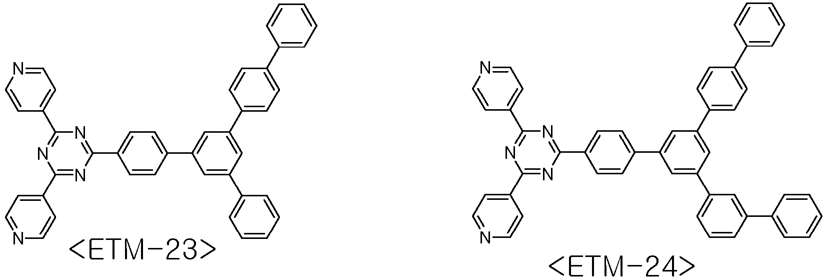

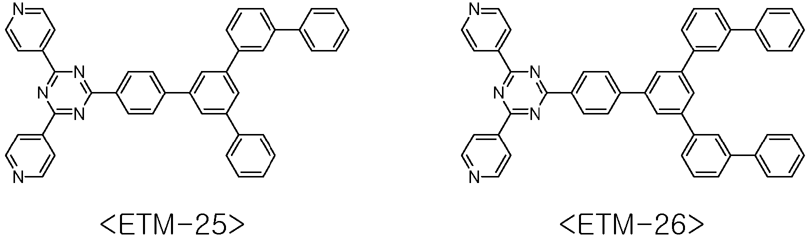

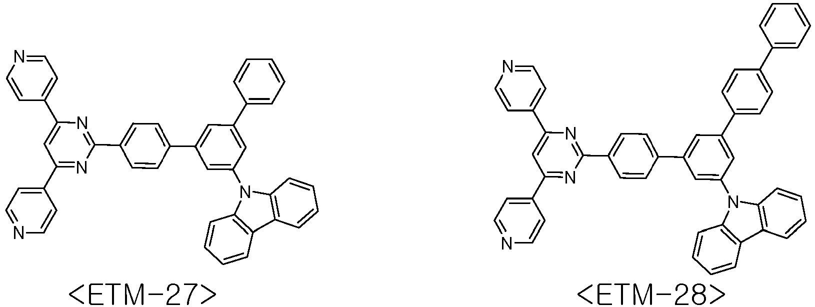

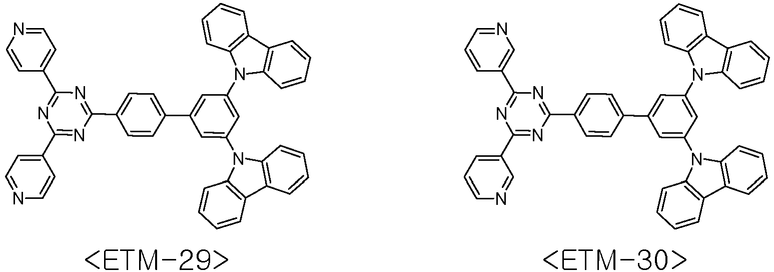

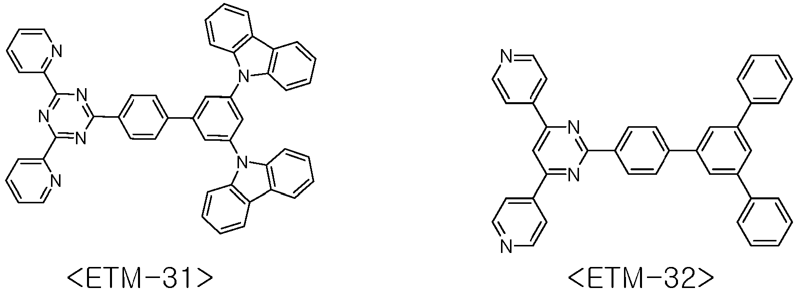

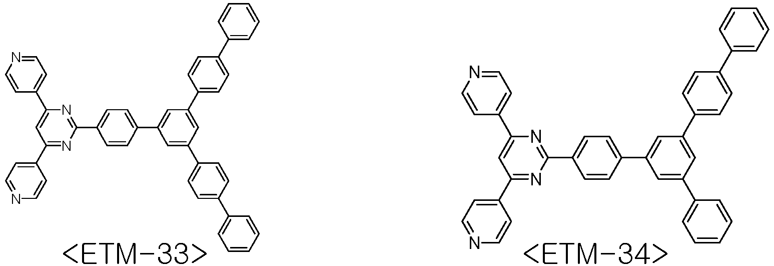

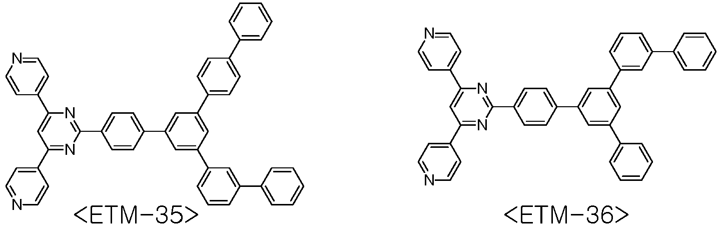

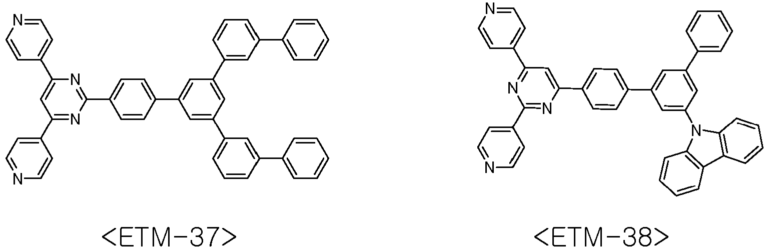

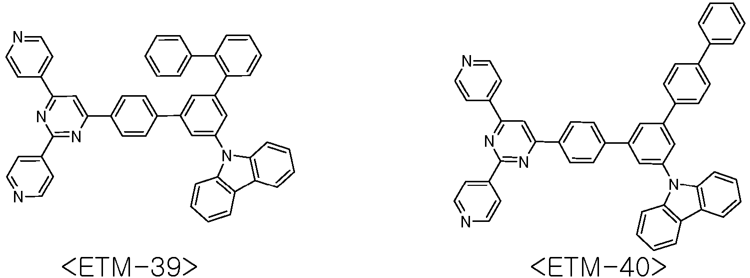

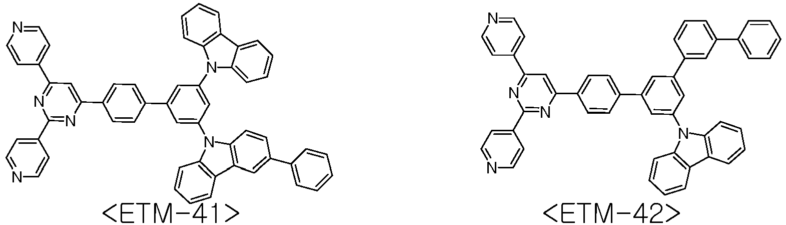

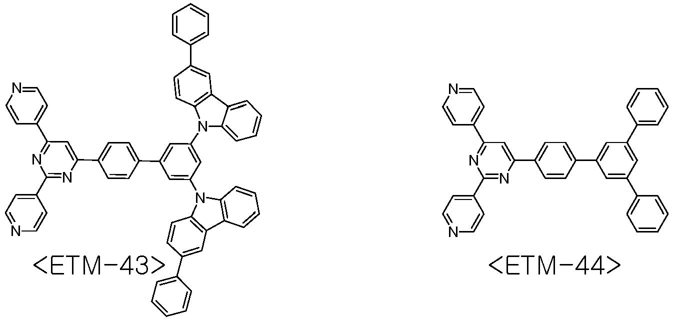

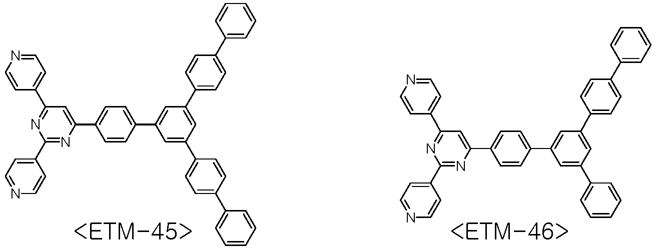

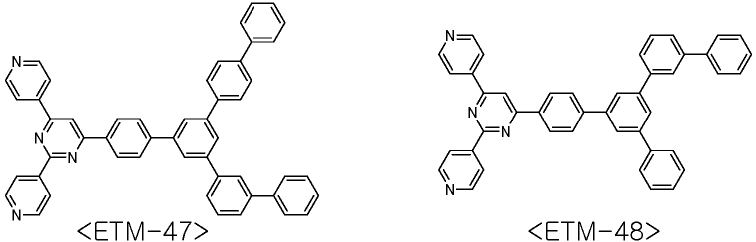

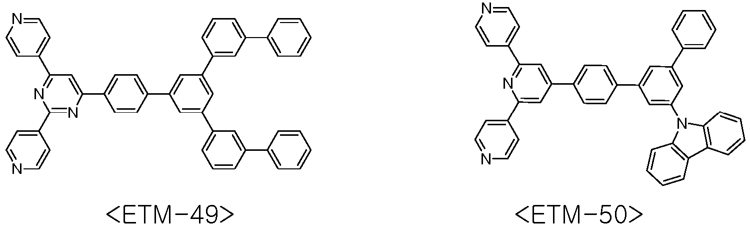

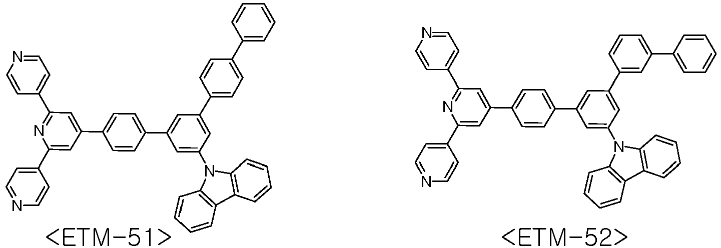

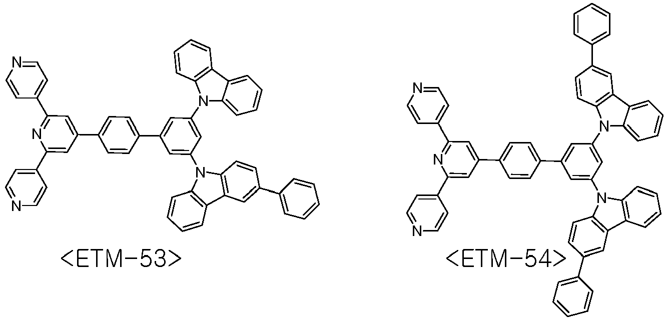

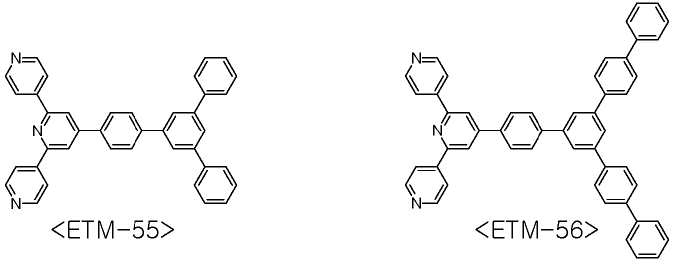

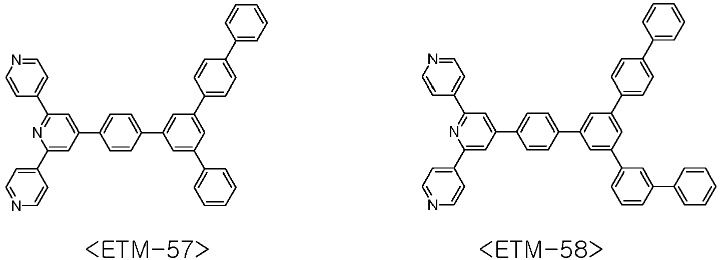

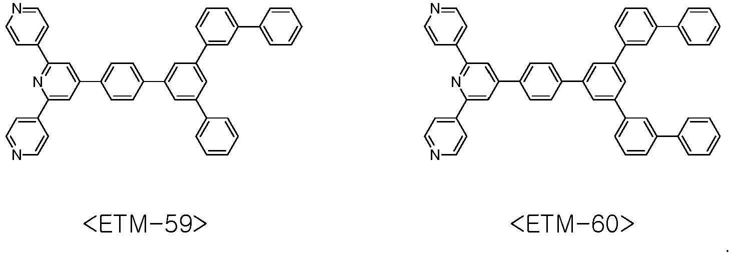

9. Lichtemittierende Vorrichtung nach einem der Ansprüche 2 bis 8, wobei die Verbindung der Formel 2 eine der folgenden Verbindungen ist:

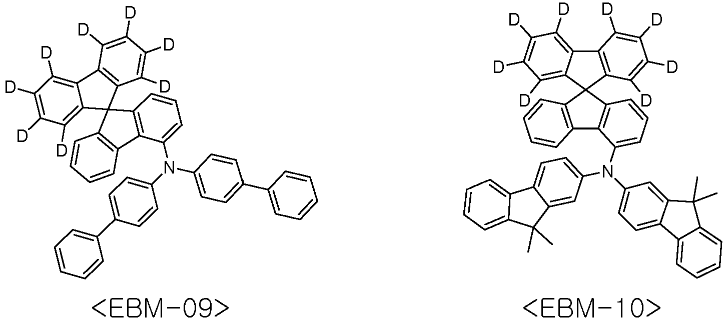

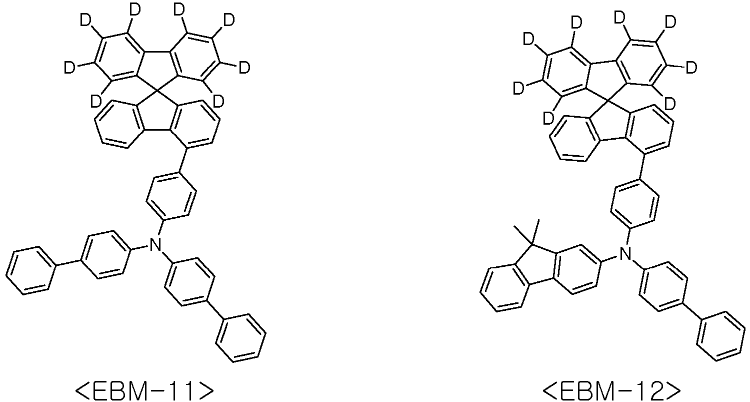

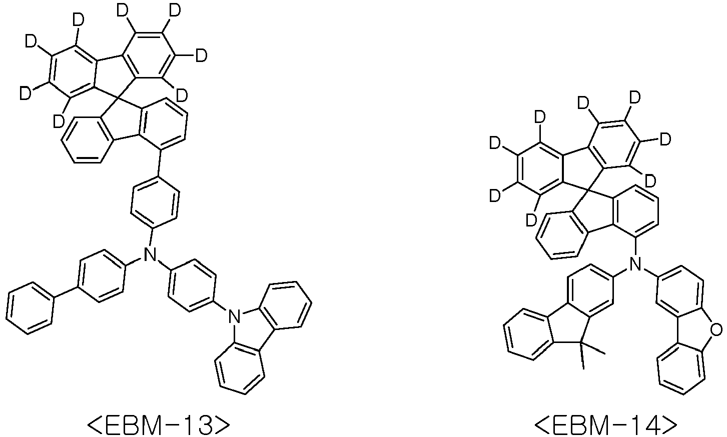

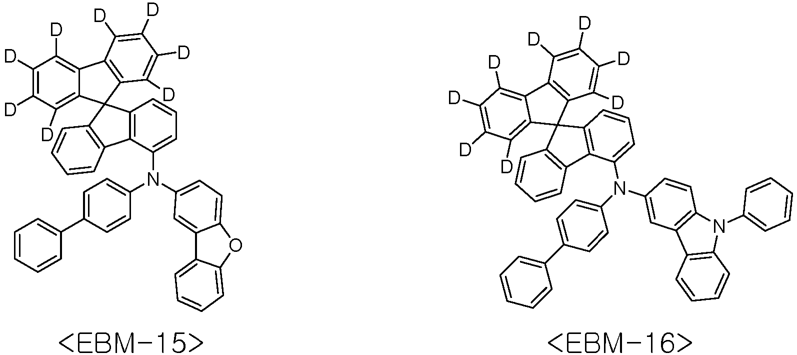

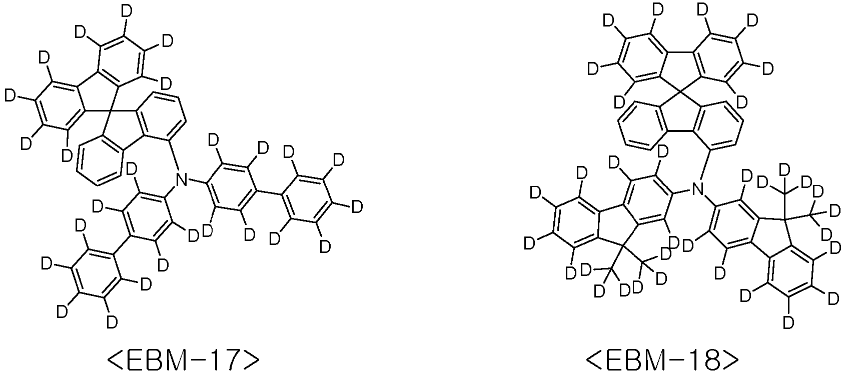

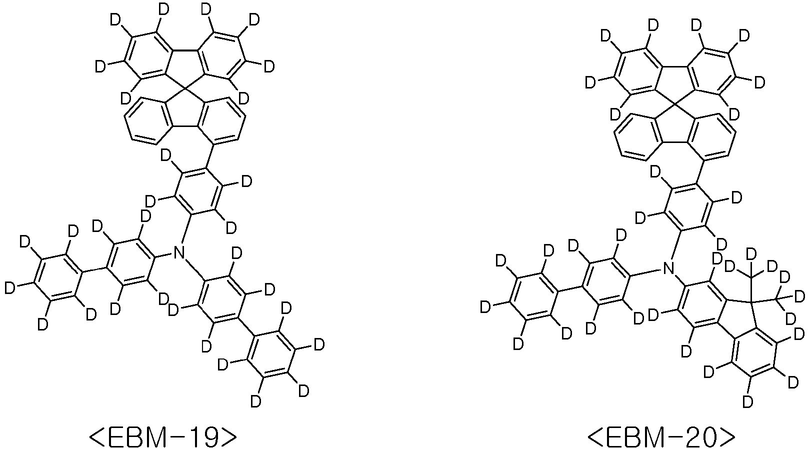

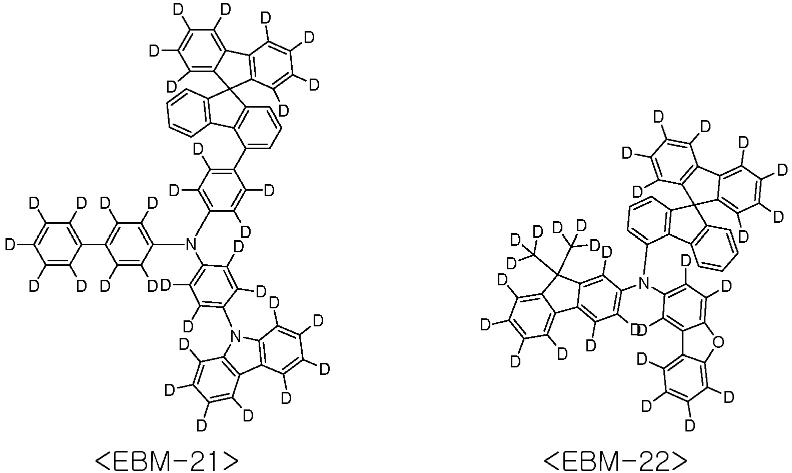

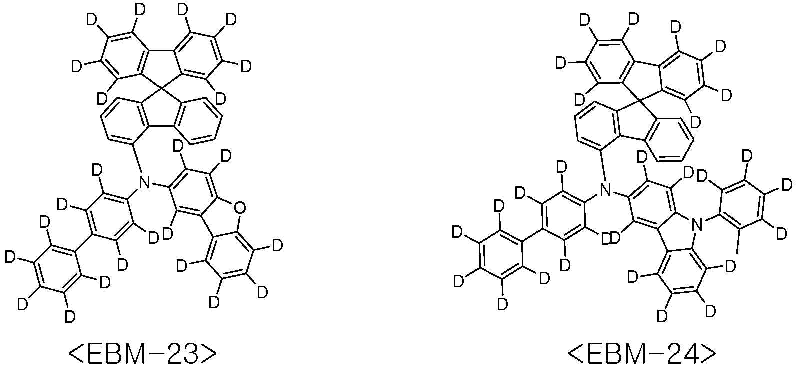

10. Lichtemittierende Vorrichtung nach einem der Ansprüche 1 bis 9, wobei die erste Elektronenblockierschicht mit einer Oberfläche der ersten blaues Licht emittierenden Schicht in Kontakt steht, die erste Elektronentransportschicht mit der anderen Oberfläche der ersten blaues Licht emittierenden Schicht in Kontakt steht und die eine Oberfläche und die andere Oberfläche der ersten blaues Licht emittierenden Schicht einander gegenüberliegen, mit einem Abstand dazwischen, der der Dicke der ersten blaues Licht emittierenden Schicht entspricht.

11. Lichtemittierende Vorrichtung nach einem der Ansprüche 1 bis 10, wobei die mindestens zwei phosphoreszierenden Licht emittierenden Schichten des zweiten Stapels umfassen:
eine rotes Licht emittierende Schicht neben dem ersten Stapel; und
eine grünes Licht emittierende Schicht neben der Kathode.

12. Lichtemittierende Vorrichtung nach Anspruch 11, wobei die mindestens zwei phosphoreszierenden Licht emittierenden Schichten zusätzlich eine gelblich-grünes Licht emittierende Schicht zwischen der rotes Licht emittierenden Schicht und der grünes Licht emittierenden Schicht umfassen.

13. Lichtemittierende Vorrichtung nach einem der Ansprüche 1 bis 12, ferner umfassend mindestens einen Stapel zwischen dem zweiten Stapel und der Kathode,
wobei der mindestens eine Stapel zwischen dem zweiten Stapel und der Kathode umfasst:
eine zweite Elektronenblockierschicht mit dem zweiten Material;
eine zweite blaues Licht emittierende Schicht, die dieselbe Farbe wie die erste blaues Licht emittierende Schicht emittiert; und
eine zweite Elektronentransportschicht mit dem ersten Material.

14. Lichtemittierende Vorrichtung nach Anspruch 13, ferner umfassend eine Elektroneninjektionsschicht zwischen der zweiten Elektronentransportschicht und der Kathode,
wobei die zweite Elektronentransportschicht ferner ein drittes Material umfasst.

15. Lichtemittierende Anzeige, umfassend:
ein Substrat mit einer Vielzahl von Subpixeln;
einen Dünnschichttransistor, der in jedem der Subpixel auf dem Substrat vorgesehen ist; und
eine mit dem Dünnschichttransistor verbundene lichtemittierende Vorrichtung,
wobei die lichtemittierende Vorrichtung einem der Ansprüche 1 bis 14 entspricht.

## Revendications

1. Dispositif électroluminescent comportant :
une anode (110) et une cathode (200) dirigées l'une vers l'autre ;
une première pile (S1) et une seconde pile (S2) disposées entre l'anode et la cathode,
la première pile comportant :
une première couche de blocage d'électrons (EBL1) ;
une première couche d'émission de lumière bleue (BEML1) contenant un composé à base de bore émettant de la lumière ayant une longueur d'onde de 430 nm à 480 nm ; et
une première couche de transport d'électrons (ETL1), et
la seconde pile comportant au moins deux couches d'émission de lumière phosphorescente (R EML, YG EML, G EML) émettant de la lumière ayant une longueur d'onde plus longue qu'une longueur d'onde de la lumière émise par la première couche d'émission de lumière bleue ; et
une couche de génération de charges (CGL1) disposée entre la première pile et la seconde pile,
dans lequel la première couche de transport d'électrons comporte un premier matériau de Formule 1, un deuxième matériau de la première couche de blocage d'électrons comporte un 9,9'-spirobifluorène, et au moins un spirofluorène du 9,9'-spirobifluorène est substitué par un deutérium, 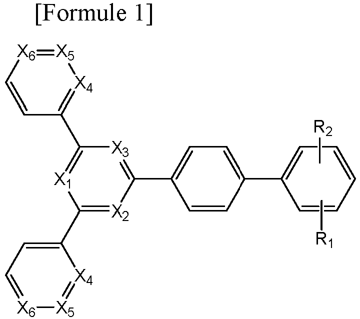
dans laquelle R₁ et R₂ sont chacun choisis indépendamment l'un de l'autre parmi un groupe cycloalkyle, un groupe aryle et un groupe hétéroaryle ;
X₁, X₂ et X₃ sont chacun, indépendamment les uns des autres, N ou CH ; et
au moins un élément parmi X₄, X₅ et X₆ est N, et les éléments restants sont CH.

2. Dispositif électroluminescent selon la revendication 1, dans lequel le deuxième matériau comporte un composé représenté par la Formule 2 ci-dessous : 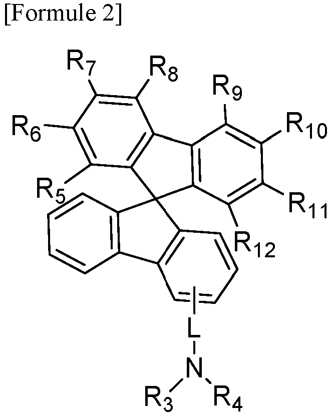
dans laquelle L est une liaison simple ou est choisi parmi un groupe phénylène substitué ou non substitué par un deutérium et un groupe naphtylène substitué ou non substitué par un deutérium ;
R₃ et R₄ sont chacun choisis indépendamment l'un de l'autre parmi un groupe phényle non substitué ou substitué par un deutérium, un groupe biphényle substitué ou non substitué par un deutérium, un groupe diméthylfluorène substitué ou non substitué par un deutérium, et un groupe hétéroaryle substitué par un deutérium ; et
R₅ à R₁₂ représentent chacun le deutérium.

3. Dispositif électroluminescent selon la revendication 1, dans lequel au moins un élément parmi R₁ et R₂ est un groupe carbazole et le groupe carbazole inclut un groupe phényle en tant que substituant.

4. Dispositif électroluminescent selon la revendication 1, dans lequel au moins un élément parmi R₁ et R₂ est un groupe phényle ou un groupe biphényle.

5. Dispositif électroluminescent selon la revendication 2, dans lequel au moins un élément parmi R₃ et R₄ inclut au moins un groupe parmi un groupe biphényle, un groupe diméthylfluorène, un groupe carbazole, un groupe dibenzofurane, un groupe biphényle substitué par un deutérium, un groupe diméthylfluorène substitué par un deutérium, un groupe carbazole substitué par un deutérium, un groupe dibenzofurane substitué par un deutérium, un groupe biphényle perdeutérié, un groupe diméthylfluorène perdeutérié ou un groupe carbazole perdeutérié.

6. Dispositif électroluminescent selon la revendication 5, dans lequel le groupe carbazole inclut un groupe phényle en tant que substituant.

7. Dispositif électroluminescent selon la revendication 2, dans lequel R₃ et R₄ sont entièrement substitués par un deutérium.

8. Dispositif électroluminescent selon la revendication 1, dans lequel le composé de Formule 1 est l'un des composés suivants :

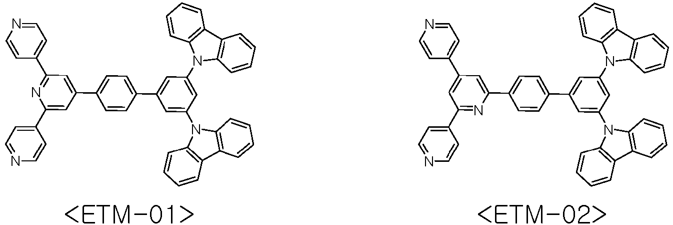

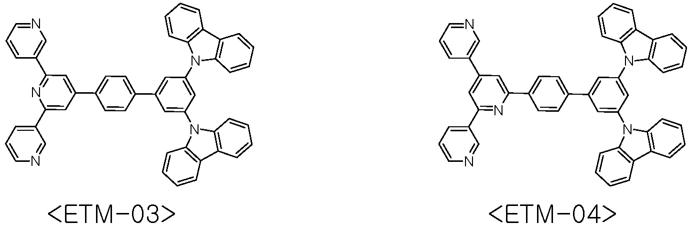

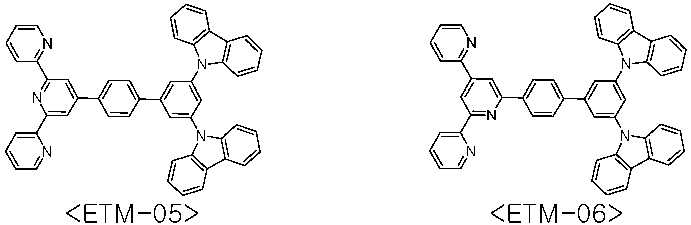

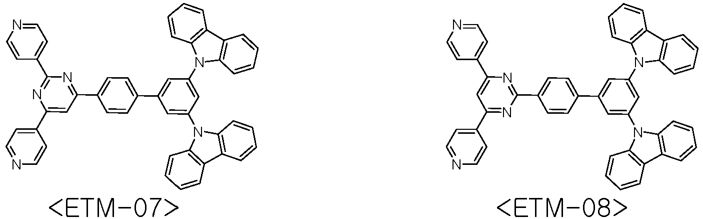

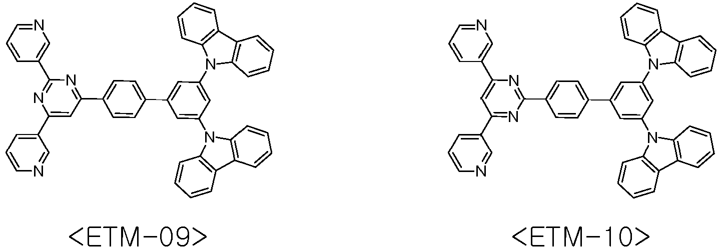

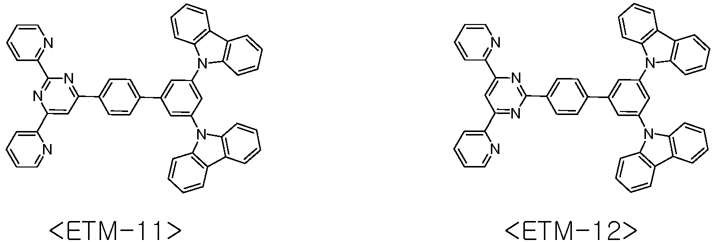

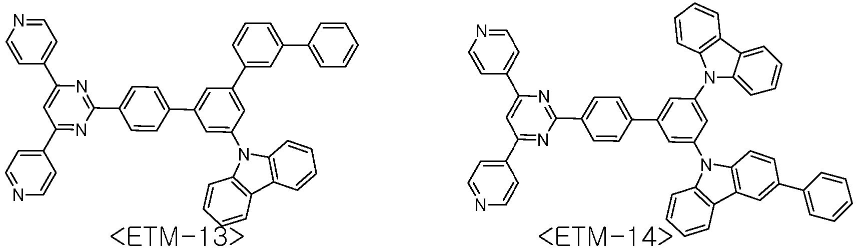

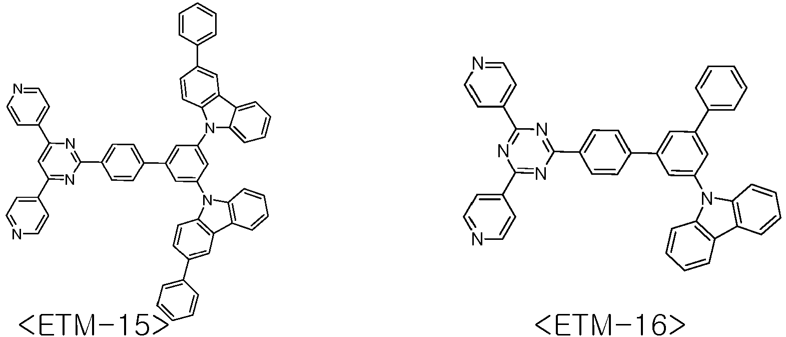

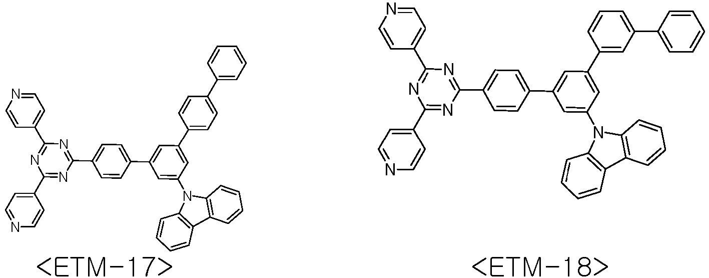

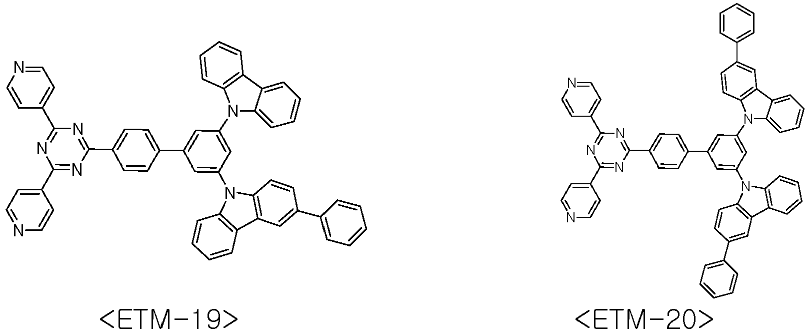

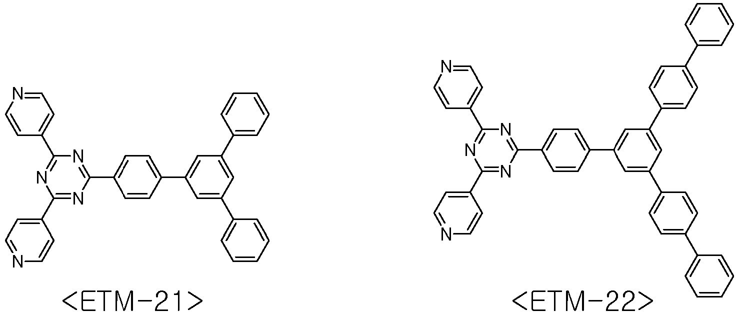

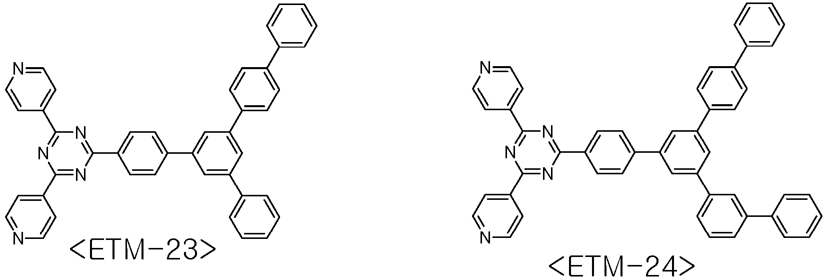

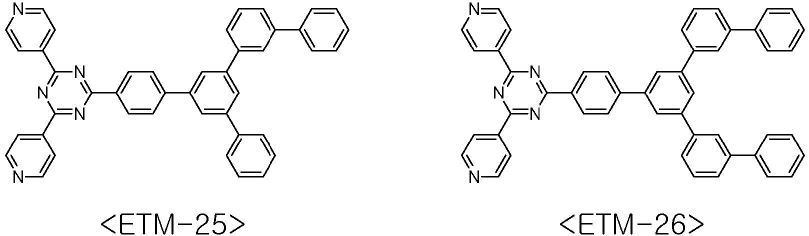

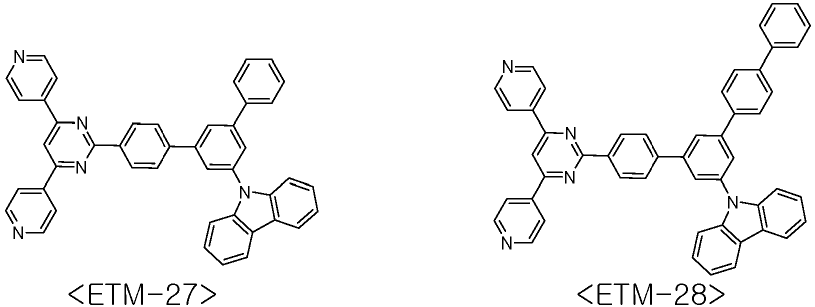

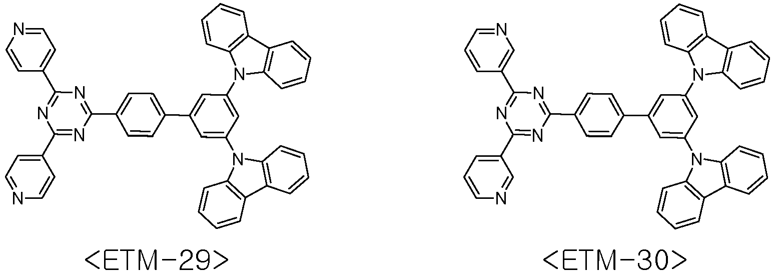

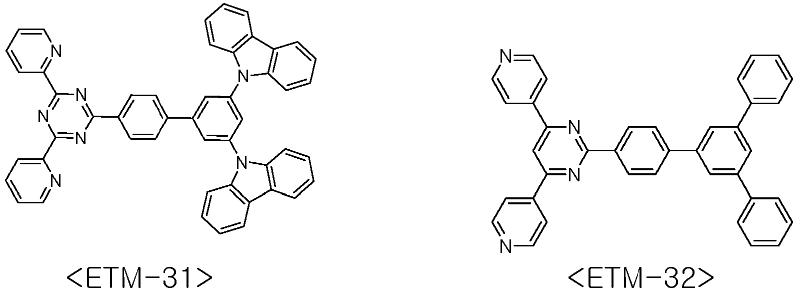

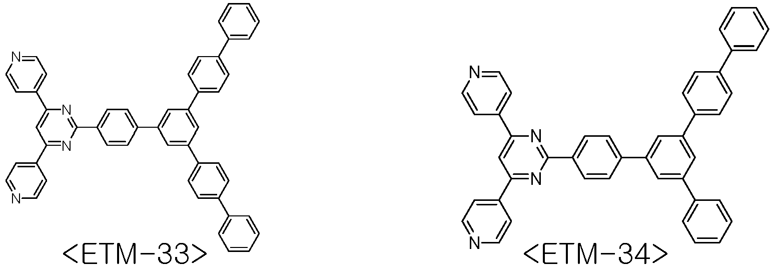

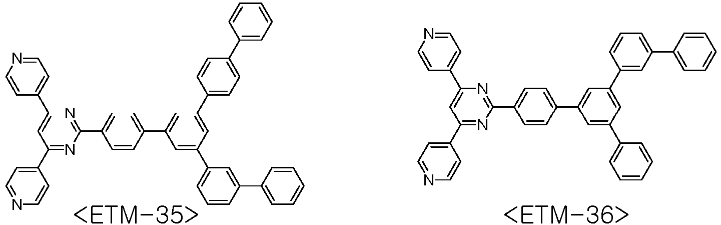

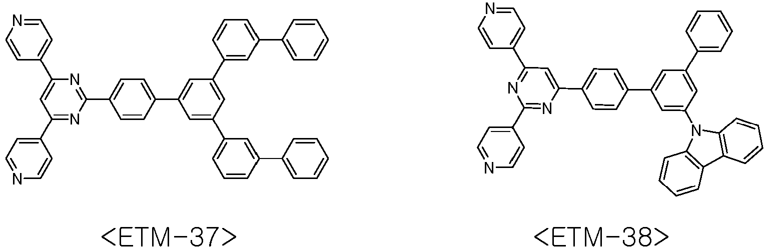

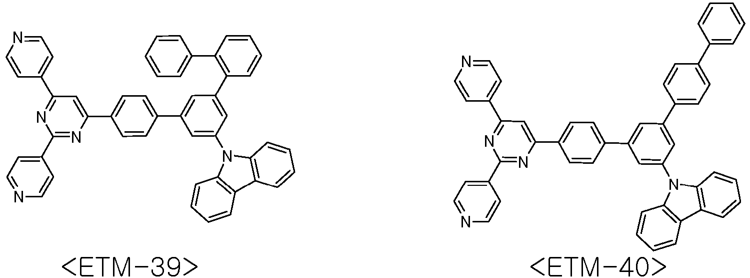

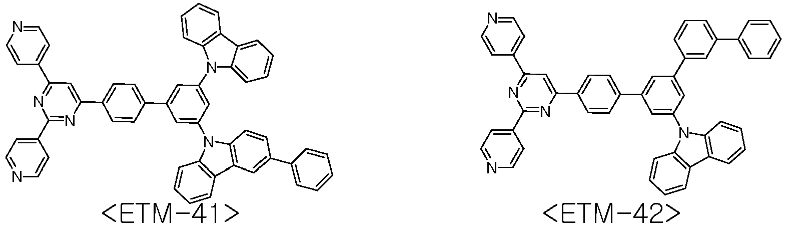

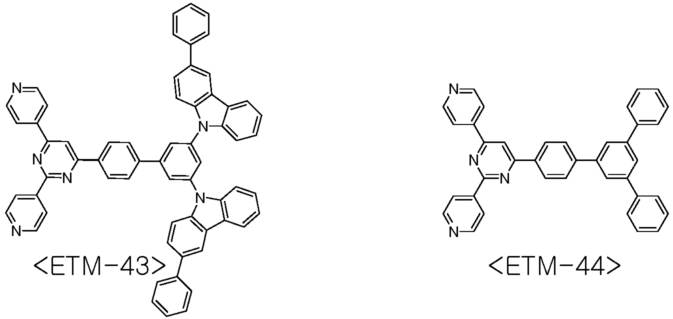

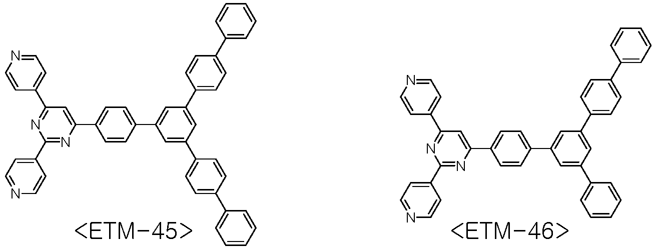

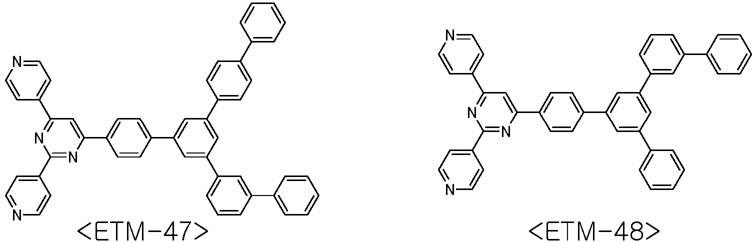

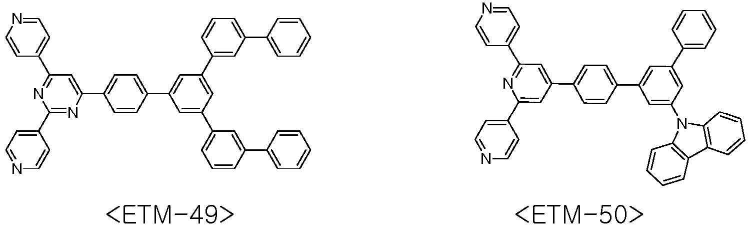

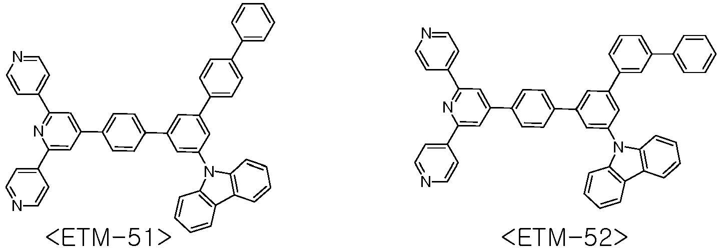

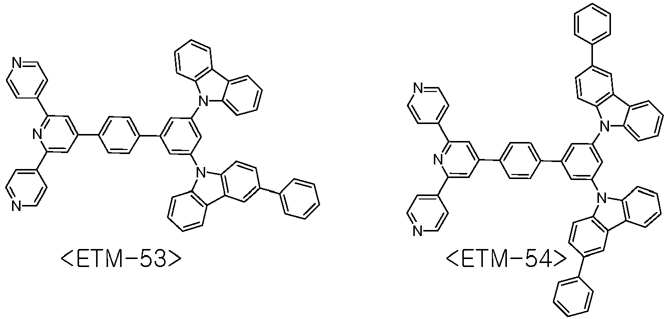

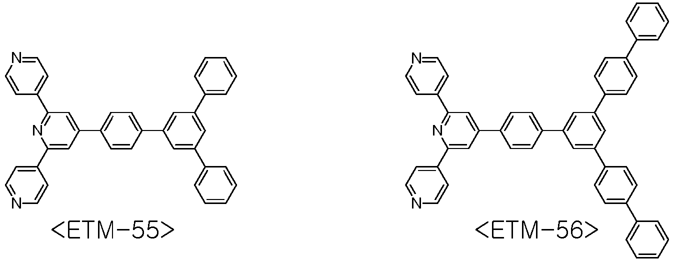

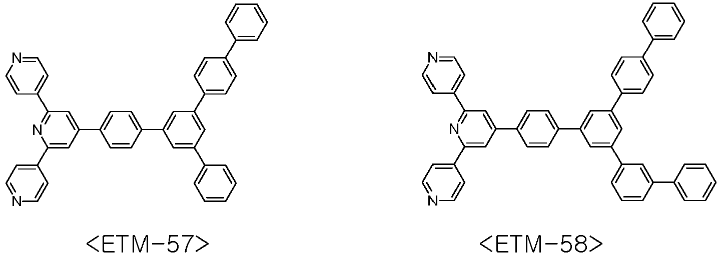

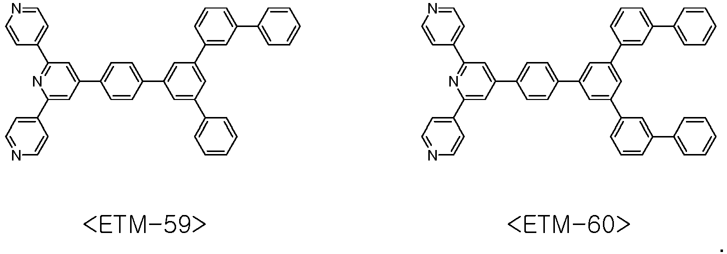

9. Dispositif électroluminescent selon l'une quelconque des revendications 2 à 8, dans lequel le composé de Formule 2 est l'un des composés suivants :

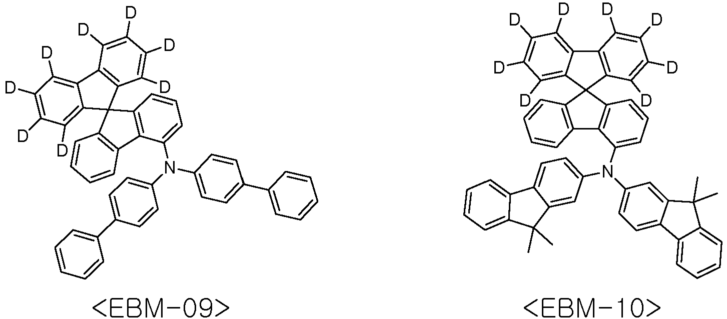

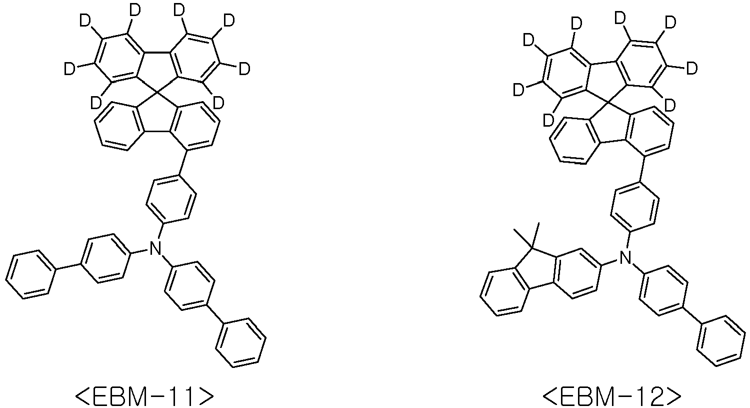

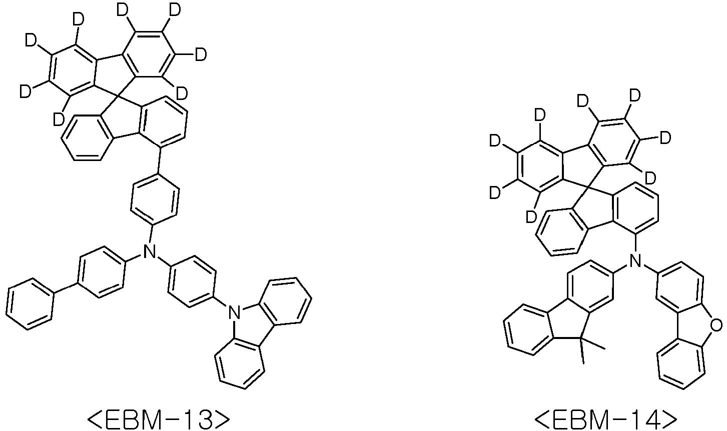

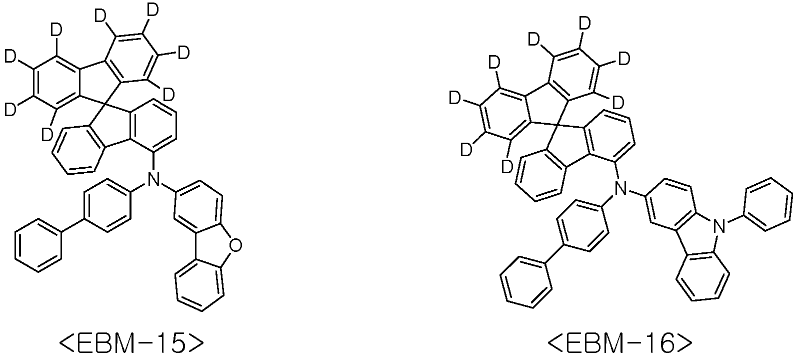

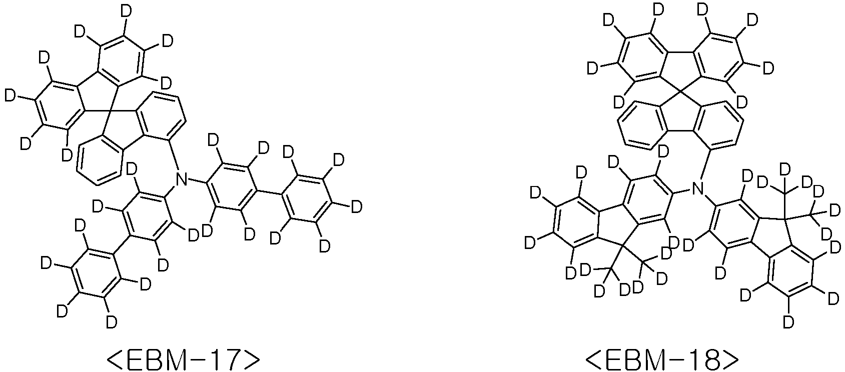

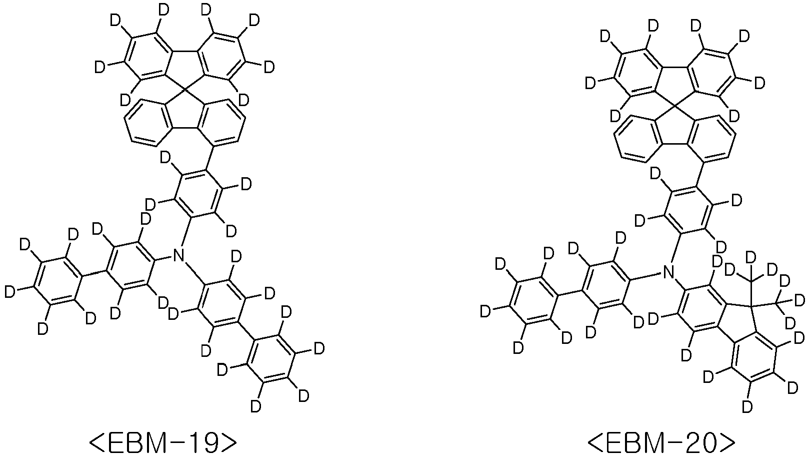

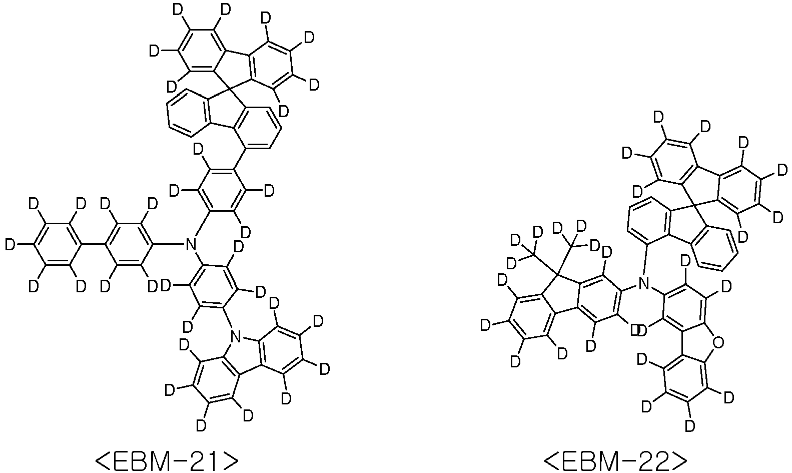

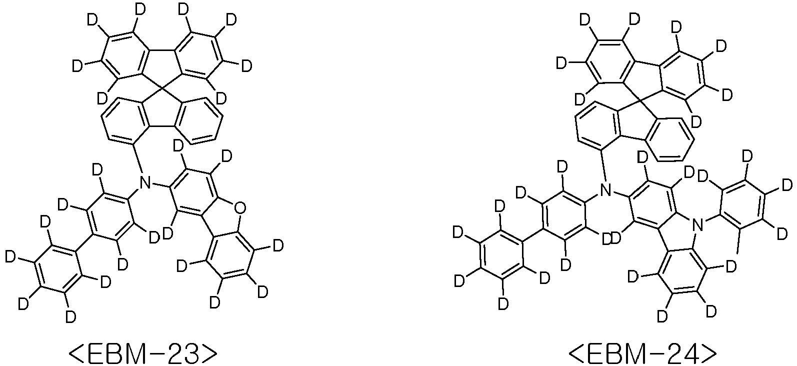

10. Dispositif électroluminescent selon l'une quelconque des revendications 1 à 9, dans lequel la première couche de blocage d'électrons est en contact avec une première surface de la première couche d'émission de lumière bleue, la première couche de transport d'électrons est en contact avec la seconde surface de la première couche d'émission de lumière bleue, et une première surface et la seconde surface de la première couche d'émission de lumière bleue sont dirigées l'une vers l'autre, avec un espace entre elles correspondant à une épaisseur de la première couche d'émission de lumière bleue.

11. Dispositif électroluminescent selon l'une quelconque des revendications 1 à 10, dans lequel les au moins deux couches d'émission de lumière phosphorescente de la seconde pile comportent :
une couche d'émission de lumière rouge adjacente à la première pile ; et
une couche d'émission de lumière verte adjacente à la cathode.

12. Dispositif électroluminescent selon la revendication 11, dans lequel les au moins deux couches d'émission de lumière phosphorescente comportent en outre une couche d'émission de lumière verte-jaunâtre entre la couche d'émission de lumière rouge et la couche d'émission de lumière verte.

13. Dispositif électroluminescent selon l'une quelconque des revendications 1 à 12, comportant en outre au moins une pile entre la seconde pile et la cathode.
dans lequel au moins une pile entre la seconde pile et la cathode comporte :
une seconde couche de blocage d'électrons incluant le deuxième matériau ;
une seconde couche d'émission de lumière bleue émettant la même couleur que la première couche d'émission de lumière bleue ; et
une seconde couche de transport d'électrons incluant le premier matériau.

14. Dispositif électroluminescent selon la revendication 13, comportant en outre une couche d'injection d'électrons entre la seconde couche de transport d'électrons et la cathode,
dans lequel la seconde couche de transport d'électrons comporte en outre un troisième matériau.

15. Affichage électroluminescent comportant :
un substrat incluant une pluralité de sous-pixels ;
un transistor à couches minces disposé dans chacun des sous-pixels sur le substrat ; et
un dispositif électroluminescent connecté au transistor à couches minces,
dans lequel le dispositif électroluminescent est selon l'une quelconque des revendications 1 à 14.
